# EUROPEAN PATENT APPLICATION

(11) **EP 2 107 824 A2**
(43) Date of publication of application: **07.10.2009**
(21) Application number: 09004476.9
(22) Date of filing: 27.03.2009
(51) Int. Cl.: H04R 23/00, H05K 5/02, H05K 7/14

(54) **Lead frame and package of semiconductor device**

(30) Priority: 31.03.2008 JP 2008090475; 13.06.2008 JP 2008155370; 26.09.2008 JP 2008248228
(71) Applicant: Yamaha Corporation, Hamamatsu-shi, Shizuoka-ken (JP)
(72) Inventor: Shirasaka, Kenichi, Shizuoka-ken (JP)
(74) Representative: Emde, Eric

(57) **Abstract**

A lead frame including a shield plate, a main frame, interconnection arms, support arms, and terminals is sealed with a resin mold including a base portion for embedding the shield plate and a peripheral wall for embedding the interconnection arms and support arms, thus forming a package base. The Interconnection arms and support arms are subjected to bending so as to depress the shield plate in position compared with the main frame. At least one semiconductor chip (e.g. a microphone chip) is mounted on the base portion just above the shield plate. A cover having conductivity is attached onto the main frame exposed on the upper end of the peripheral wall, thus completely producing a semiconductor device encapsulated in a package. A sound hole is formed in the cover or the package base so as to allow the internal space of the package to communicate with the external space.

## Description

### BACKGROUND OF THE INVENTION

### Field of the Invention

The present invention relates to lead frames and packages for use in semiconductor devices, wherein semiconductor chips are mounted on package bases including lead frames sealed with mold resins.

The present application claims priority on Japanese Patent Application No. 2008-90475, Japanese Patent Application No. 2008-155370, and Japanese Patent Application No. 2008-248228, the contents of which are incorporated herein by reference.

### Description of the Related Art

Conventionally, semiconductor devices such as silicon microphones and pressure sensors are designed such that semiconductor chips such as microphone chips are encapsulated in hollow packages of a pre-mold type in which lead frames are sealed with mold resins in advance. Various types of conventionally-known semiconductor devices encapsulated in pre-mold type packages have been developed and disclosed in various documents such as Patent Documents 1-6.
Patent Document 1: Japanese Unexamined Patent Application Publication No. 2007-66967
Patent Document 2: Japanese Unexamined Patent Application Publication No. H08-255862
Patent Document 3: Japanese Unexamined Patent Application Publication No. 2000-353759
Patent Document 4: Japanese Unexamined Patent Application Publication No. 2005-5353
Patent Document 5: Japanese Unexamined Patent Application Publication No. 2005-26425
Patent Document 6: U.S. Patent No. 6,781,231

Patent Document 1 teaches a semiconductor device using a pre-mold type package, in which a semiconductor chip is mounted on a shield plate (or a stage) disposed at the center of a lead frame; a mold resin is integrally formed to cover the backside of the shield plate and the surrounding area of the shield plate; and the intermediate portions of interconnection leads extended from the shield plate are exposed on the upper surface of a peripheral wall of the mold resin protruding from the shield plate. The mold resin is closed with a cup-shaped metal cover, the peripheral portion of which is bonded to the peripheral wall of the mold resin so as to form an internal space surrounding the semiconductor chip. The metal cover is electrically connected to the exposed portions of the interconnection leads.

In the above, the distal ends of the interconnection leads are exposed on the backside of the mold resin together with the distal ends of leads disposed externally of the shield plate. The distal ends of the interconnection leads and leads are connected to the circuitry of an external substrate on which the semiconductor device is mounted.

Patent Documents 2 to 5 teach other types of semiconductor devices using pre-mold type packages.

Patent Document 6 teaches a semiconductor device in which a semiconductor chip (e.g. a microphone chip) is mounted on the surface of a flat-shaped circuit substrate, which is assembled with a metal case (or a metal cover).

The semiconductor device of Patent Document 1 is designed such that the shield plate of the lead frame and the metal cover are connected together with the exposed portions of the interconnection leads so as to surround the semiconductor chip with metals, thus improving shield property. This semiconductor device having a simple structure, in which the lead frame is integrally unified with the resin mold, can be manufactured with low cost. However, it needs a complex bending process in which the interconnection leads are partially bent upwardly so as to expose the intermediate portions thereof on the upper surface of the peripheral wall of the mold resin, then, the distal ends of the interconnection leads are bent downwardly and exposed on the backside of the mold resin.

The semiconductor device of Patent Document 6 suffers from a drawback in which a flat-shaped package base thereof likely allows a bonding agent, which is used for die bonding of the semiconductor chip, to overflow toward the internal ends of the leads. For this reason, it is necessary to secure an adequate distance between the chip mounting area and the internal ends of the leads, thus preventing the bonding agent from overflowing toward the internal ends of the leads. This makes it difficult to produce small-size semiconductor devices.

### SUMMARY OF THE INVENTION

It is an object of the present invention to provide a lead frame and a package for use in a semiconductor device achieving a small-size simple structure, thus reducing manufacturing cost.

In a first aspect of the present invention, a flat frame material for use in a lead frame is constituted of a main frame, a plurality of interconnection arms, a shield plate which is placed inside the main frame and is interconnected to the main frame via the plurality of interconnection arms, a plurality of bent portions which are bent externally from the main frame so as to form a plurality of recesses therein, a plurality of support arms which are extended inwardly from the plurality of recesses in connection with the plurality of bent portions, and a plurality of terminals which are connected to distal ends of the support arms in proximity to the shield plate.

The flat frame material is subjected to press working so as to depress the shield plate in position compared to the main frame, wherein the interconnection arms and support arms are subjected to bending, thus producing a three-dimensionally structured lead frame with ease. Compared to the conventionally-known lead frames in which interconnection arms are repeatedly bent, the lead frame of the present invention is designed such that the interconnection arms are bent downwardly from the main frame to the shield plate. This makes it possible to form the main frame having a relatively large size even irrespective of the reduced outline configuration of the lead frame depending upon the size of the main frame. That is, it is possible to increase the mounting area for mounting a semiconductor chip on the shield plate and to increase the internal volume of a semiconductor package while reducing the outline configuration of the lead frame. The press working is performed to depress the shield plate in position while maintaining the position of the main frame in the plane; this makes it possible to use a flat-shaped cover for closing the internal space with the lead frame. The lead frame is sealed with a mold resin and is then subjected to cutting at the bent portions of the main frame, thus isolating the terminals supported by the support arms from the main frame.

In the above, the interconnection arms are subjected to bending at first and second ends thereof in such a way that a first line imaginarily connecting between the first ends of the interconnection arms aligned in proximity to the main frame is parallel to a second line imaginarily connecting between the second ends of the interconnection arms aligned in proximity to the shield plate. It is possible to dispose the interconnection arms in parallel with each other between the main frame and the shield plate which are positioned opposite to each other. In addition, the interconnection arms are positioned linearly symmetrical with respect to the shield plate, so that the first ends of the interconnection arms interconnected to the main frame are shifted in position compared to the second ends of the interconnection arms interconnected to the shield plate. Even when the interconnection arms are linearly aligned on both sides of the shield plate, and the interconnection arms must be slightly extended due to bending, it is possible to easily depress the shield plate in position compared to the main frame by way of bending at the first and second ends of the interconnection arms because the first line is drawn parallel to the second line.

A plurality of flat frame materials is collectively formed inside an external frame so as to form a flat frame assembly, wherein the main frames of the flat frame materials are positioned on one ends of the lead frames and are linearly interconnected in each row so as to form a support frame, so that the bent portions are expanded externally from the main frames and perpendicularly to rows. It is necessary to determine the distance between the main frame and the shield plate based on the pre-estimated bending lengths of the interconnection arms; however, since the main frame is disposed on one side of the lead frame only, it is unnecessary to pre-estimate the bending lengths of the interconnection arms with respect to the other side of the lead frame. This increases the size of the shield plate so as to improve the shield effect. In addition, it is possible to form the flat frame materials having large sizes from the flat frame assembly having a limited size.

In a second aspect of the present invention, a lead frame is formed by performing press working on the flat frame material such that the interconnection arms and the support arms are subjected to bending so as to depress the shield plate coupled with the terminals in position compared to the main frame. The lead frame is sealed with a mold resin; at least one semiconductor chip is mounted on the shield plate; then, the periphery thereof is subjected to dicing, thus producing a semiconductor device. In dicing, the bent portions of the main frame are subjected to cutting so as to separate the support frames independently from the main frame. Specifically, the support arms are bent downwardly so that the downward slopes thereof are embedded in the mold resin and are then subjected to cutting, thus reliably insulating the terminals supported by the support arms from the cover attached onto the mold resin including a base portion for embedding the shield plate and a peripheral wall vertically disposed on the periphery of the base portion. It is possible to secure a large contact area with respect to the main frame, which can be arranged circumferentially on the peripheral wall in contact with the cover. When the shield plate becomes smaller than the main frame, it is possible for the mold resin to reduce the base portion in size compared to the upper end of the peripheral wall on which the main frame is exposed. This reduces the mounting area for mounting a semiconductor chip on an external substrate, thus achieving high-density packaging. In this connection, the interconnection arms can be slightly extended due to bending.

In the above, the interconnection arms are subjected to bending at first and second ends thereof in such a way that a first line imaginarily connecting between the first ends of the interconnection arms aligned in proximity to the main frame is parallel to a second line imaginarily connecting between the second ends of the interconnection arms aligned in proximity to the shield plate. The intermediate portions of the interconnection arms between the first and second ends subjected to bending are slantingly disposed between the main frame and the shield plate. The support arms are subjected to bending as well so as to depress the shield plate coupled with the terminals in position compared to the main frame.

A plurality of lead frames is collectively formed inside an external frame so as to form a lead frame assembly, wherein the main frames are positioned on one ends of the lead frames and are linearly interconnected in each row so as to form a support frame, so that the bent portions are expanded externally from the main frames and perpendicularly to rows, and wherein the interconnection arms and the support arms are subjected to bending so as to depress the shield plate coupled with the terminals in position compared to the main frame. Herein, the bent portions connected to the support arms are subjected to cutting in columns, thus cutting the peripheries of the peripheral walls of the mold resins.

In a third aspect of the present invention, a package base is formed by sealing the lead frame with the mold resin in which the main frame is partially exposed on the upper end of the peripheral wall, in which the interconnection arms and support arms are embedded inside the peripheral wall, and in which the shield plate is embedded in the base portion except for the terminals. When the cover composed of a conductive material is attached onto the package base in connection with the main frame exposed on the upper end of the peripheral wall, the internal space is surrounded by the cover, main frame, interconnection arms, and shield plate and is shielded from an external magnetic field by grounding a prescribed portion of the shield plate. It is possible to secure a large contact area with respect to the main frame, which can be formed circumferentially on the peripheral wall, in contact with the cover.

A plurality of package bases is collectively formed inside an external frame so as to form a package base assembly, which is then covered with a cover assembly including a plurality of covers.

A package is formed by attaching the cover onto the package base so as to enclose the internal space surrounded by the peripheral wall of the mold resin.

A semiconductor device is produced by mounting at least one semiconductor chip on the base portion of the mold resin in the package.

A microphone package is produced by mounting a microphone chip on the base portion of the mold resin of the package base in the package, wherein a sound hole is formed in the cover or the package base so as to allow the internal space to communicate with the external space.

In the above, a window hole is formed to expose a prescribed portion of the shield plate in the base portion of the mold resin, wherein a plurality of small holes is formed to run through the exposed portion of the shield plate, thus collectively forming the sound hole.

As described above, the lead frame having a simple structure is sealed with the mold resin, wherein the interconnection arms are bent downwardly from the main frame to the shield plate. This makes it possible to form the shield plate having a relatively large size by use of the lead frame having a small outline configuration. That is, it is possible to secure a relatively large volume for storing the semiconductor chip within the package having a relatively small size, thus achieving high-density packaging. After the lead frame is sealed with the mold resin, the bent portions of the main frame are subjected to cutting so as to isolate the terminals supported by the support arms independently from the main frame. By attaching the cover having conductivity onto the main frame exposed on the upper end of the peripheral wall, it is possible to reliably shield the internal space from an external magnetic field while reliably insulating the terminals from the cover.

### BRIEF DESCRIPTION OF THE DRAWINGS

These and other objects, aspects, and embodiments of the present invention will be described in more detail with reference to the following drawings.
Fig. 1 is a plan view showing the surface of a lead frame for use in a semiconductor device according to a first embodiment of the present invention.
Fig. 2 is a back view showing the backside of the lead frame.
Fig. 3 is a sectional view taken along line A-A in Fig. 1.
Fig. 4 is a sectional view taken along line B-B in Fig. 1, showing that the lead frame is placed in an injection metal mold.
Fig. 5 is a plan view showing a package base in which the lead frame is sealed with a mold resin by the injection metal mold shown in Fig. 4.
Fig. 6 is a plan view of the package base which is separated from an external frame by cutting connections therebetween.
Fig. 7 is a longitudinal sectional view of a semiconductor device including the package base taken along line C-C in Fig. 6.
Fig. 8 is a perspective view of the semiconductor device which is produced using the lead frame shown in Fig. 1.
Fig. 9 is a plan view showing the surface of a lead frame for use in a semiconductor device according to a second embodiment of the present invention.
Fig. 10 is a fragmentary sectional view taken along line D-D in Fig. 9.
Fig. 11 is a plan view of a package base in which the lead frame is unified with a mold resin.
Fig. 12 is a fragmentary sectional view taken along line E-E in Fig. 11.
Fig. 13A is a plan view showing an example of an interconnection arm adaptable to the lead frame of Fig. 9.
Fig. 13B is a plan view showing another example of an interconnection arm adaptable to the lead frame shown in Fig. 9.
Fig. 14 is a fragmentary sectional view showing a modification for embedding a support arm in a peripheral wall of the package base.
Fig. 15 is a fragmentary sectional view showing another modification for embedding a support arm in the peripheral wall of the package base.
Fig. 16 is a plan view showing the surface of a lead frame for use in a semiconductor device according to a third embodiment of the present invention.
Fig. 17 is a plan view showing the surface of a lead frame for use in a semiconductor device according to a fourth embodiment of the present invention.
Fig. 18 is a back view showing the backside of the lead frame shown in Fig. 17.
Fig. 19 is a sectional view taken along line F-F in Fig. 17, showing that the lead frame is placed in an injection metal mold.
Fig. 20 is a longitudinal sectional view showing the semiconductor device in which a package base including the lead frame of Fig. 17 for mounting a semiconductor device is assembled with a cover.
Fig. 21 is a longitudinal sectional view of a semiconductor device according to a fifth embodiment of the present invention.
Fig. 22 is fragmentary plan view showing a sound hole formed in a package base of the semiconductor device shown in Fig. 21.
Fig. 23 is a sectional view showing that a lead frame for use in the semiconductor device of Fig. 21 is held in an injection metal mold.
Fig. 24 is a sectional view showing another example of a press metal mold for depressing the shield plate of the lead frame in conjunction with Fig. 3.
Fig. 25 is a plan view showing the surface of a lead frame for use in a semiconductor device according to a sixth embodiment of the present invention.
Fig. 26 is a back view showing the backside of the lead frame shown in Fig. 25.
Fig. 27A is a plan view of an upper mold of a press metal mold used for press working of a flat frame material.
Fig. 27B is a cross-sectional view taken along line G-G in Fig. 27A, which shows that the flat frame material is held between the upper and lower molds of the press metal mold.
Fig. 27C is a cross-sectional view taken along line H-H in Fig. 27A, which shows that the flat frame material is held between the upper and lower molds of the press metal mold.
Fig. 28 is a plan view showing the surface of the flat frame material corresponding to the development state of the lead frame before press working.
Fig. 29 is a longitudinal sectional view showing that the lead frame taken along line J-J in Fig. 25 is placed in an injection metal mold.
Fig. 30 is a plan view showing the package base in which the lead frame is unified with the mold resin.
Fig. 31 is a plan view of the package base subjected to cutting along cut lines P shown in Fig. 30.
Fig. 32 is a sectional view taken along line K-K in Fig. 31, showing the semiconductor device in which semiconductor chips are mounted on the package base and enclosed with the cover.
Fig. 33 is a perspective view showing the semiconductor device in which a sound hole of the cover allows the internal space to communicate with the external space.
Fig. 34 is a plan view showing a lead frame for use in a semiconductor device according to a seventh embodiment of the present invention.
Fig. 35 is a plan view showing the surface of a lead frame for use in a semiconductor device according to an eighth embodiment of the present invention.
Fig. 36 is a back view showing the backside of the lead frame shown in Fig. 35.
Fig. 37 is a plan view showing a lead frame for use in a semiconductor device according to a ninth embodiment of the present invention.
Fig. 38 is a sectional view taken along line L-L in Fig. 37.
Fig. 39 is a plan view showing a flat frame material corresponding to a development state of the lead frame before bending.
Fig. 40 is a plan view showing the surface of a flat frame material (or a lead frame assembly) including a plurality of lead frames each of which is used for a semiconductor device according to a tenth embodiment of the present invention.
Fig. 41 is a back view showing the backside of the flat frame material.
Fig. 42 is a plan view showing the surface of a single lead frame for use in the semiconductor device according to the tenth embodiment of the present invention.
Fig. 43 is a back view showing the backside of the lead frame shown in Fig. 42.
Fig. 44 is a fragmentary sectional view taken along line M-M in Fig. 42.
Fig. 45 is a plan view showing a package base in which the lead frame is unified with a mold resin.
Fig. 46A is a cross-sectional view taken along line 46A-46A in Fig. 45.
Fig. 46B is a cross-sectional view taken along line 46B-46B in Fig. 45.
Fig. 46C is a cross-sectional view taken along line 46C-46C in Fig. 45.
Fig. 47A is a cross-sectional view taken along line 47A-47A in Fig. 45.
Fig. 47B is a cross-sectional view taken along line 47B-47B in Fig. 45.
Fig. 47C is a cross-sectional view taken along line 47C-47C in Fig. 45.
Fig. 48 is a plan view showing a cover assembly including a plurality of covers.
Fig. 49 is a sectional view showing a press metal mold for performing press working on the flat frame material, which is thus reshaped into the lead frame.
Fig. 50 is a sectional view showing an injection metal mold for forming the mold resin sealing the lead frame taken along line 47A-47A in Fig. 45.
Fig. 51 is a sectional view of the semiconductor device encapsulated in the package constituted of the cover and the package base taken along line N-N in Fig. 52.
Fig. 52 is a plan view showing the package base on which the semiconductor chips are mounted.
Fig. 53 is a back view showing the backside of the semiconductor device.
Fig. 54 is a side view taken along line Q-Q in Fig. 52, which shows the lateral side of the semiconductor device.
Fig. 55 is a side view taken along line R-R in Fig. 52, which shows the longitudinal side of the semiconductor device.
Fig. 56 is a side view taken along line S-S in Fig. 52, which shows the lateral side of the semiconductor device.

### DESCRIPTION OF THE PREFERRED EMBODIMENTS

The present invention will be described in further detail by way of examples with reference to the accompanying drawings.

### 1. First Embodiment

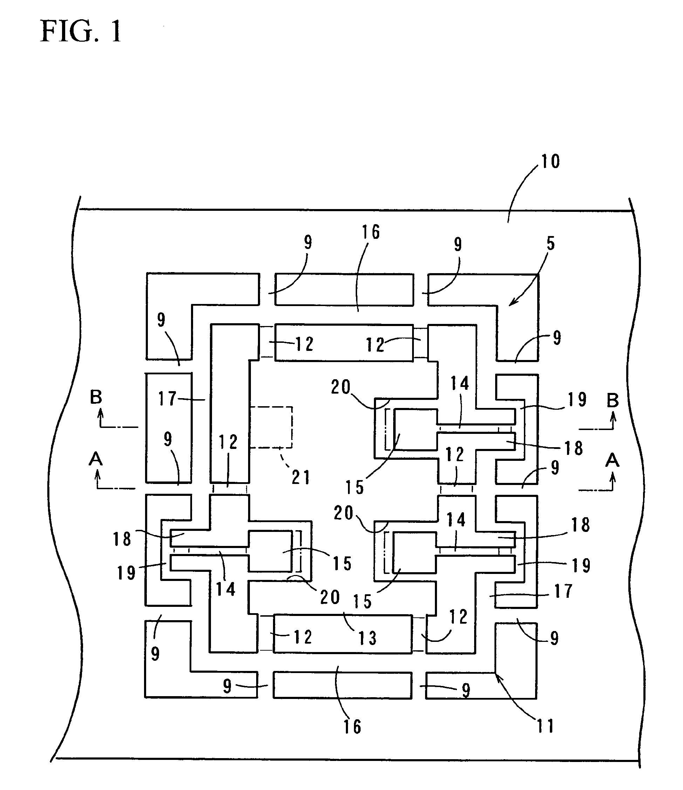

A semiconductor device 1 according to a first embodiment of the present invention will be described with reference to Figs. 1 to 8.

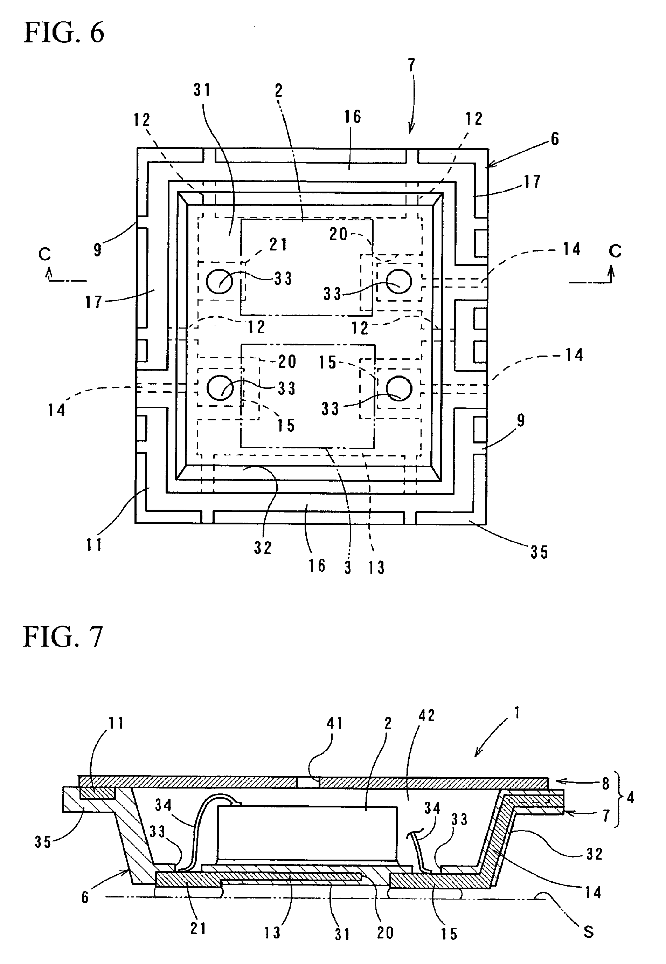

The semiconductor device 1 is a surface-mount type microphone package, which contains two semiconductor chips, i.e. a microphone chip 2 and a control chip (or a circuit chip) 3 as shown in Figs. 6 and 7. A package 4 of the semiconductor device 1 is constituted by a package base 7 and a cover 8. The package base 7 is constituted of a lead frame 5 and a box-shaped mold resin 6 which is integrally formed with the lead frame 5. The cover 8 closes the upper section of the package base 7.

A plurality of lead frames (each corresponding to the lead frame 5) which is aligned in line or in plural lines is collectively formed by way of press working on a sheet-shaped metal plate. In the present specification, the upper/lower direction is referred to as a vertical direction while the left/right direction is referred to as a horizontal direction (or a lateral direction) with respect to the lead frame 5 shown in Fig. 1. Reference numeral 9 designates connections for connecting the lead frame 5 to an external frame 10 which is formed by punching.

The lead frame 5 is constituted of a main frame 11 having a rectangular shape, a shield plate 13 interconnected to the inside of the main frame 11 via a plurality of interconnection arms 12, and a plurality of terminals 15 which are supported and cantilevered by a plurality of support arms 14 in connection with the shield plate 13.

The main frame 11 entirely formed in a rectangular shape is constituted of a pair of lateral frames 16 and a pair of longitudinal frames 17 which interconnect the opposite ends of the lateral frames 16. Two connections 9 are disposed outside of each lateral frame 6, while three connections 9 are disposed outside of each longitudinal frame 17.

In addition, two interconnection arms 12 are connected to the inside of each lateral frame 16, while one interconnection frame 12 is connected to the center of the inside of each longitudinal frame 17, whereby the shield plate 13 is interconnected to the main frame 11 via the interconnection arms 12. Each of the interconnection arms 12 is disposed between the main frame 11 and the shield plate 13 and is straightened in plan view in the opposing direction thereof. The two interconnection arms 12 adapted to the upper-side lateral frame 16 are linearly symmetrical with the two interconnection arms 12 adapted to the lower-side lateral frame 16 with respect to the shield plate 13. The interconnection arm 12 adapted to the left-side longitudinal frame 17 is linearly symmetrical with the interconnection arm 12 adapted to the right-side longitudinal frame 17 with respect to the shield plate 13.

Two terminals 15 are connected to the right-side longitudinal frame 17 at its upper and lower positions with respect to the interconnection arm 12 via the support arms 14, while one terminal 15 is connected to the left-side longitudinal frame 17 at its lower position below the interconnection arm 12 via the support arm 14. The terminal 15 connected to the lower position of the left-side longitudinal frame 17 is placed symmetrical with the terminal connected to the lower position of the right-side longitudinal frame 17. In proximity with the base portion of each support arm 14, a part of the longitudinal frame 17 is bent externally so as to form a bent portion 19 for circumscribing a recess 18 whose opening is disposed horizontally and inwardly. The base portion of the support arm 14 is connected to the inside of the bent portion 19 of the longitudinal frame 17 at a prescribed position for dividing the recess 18 into two areas.

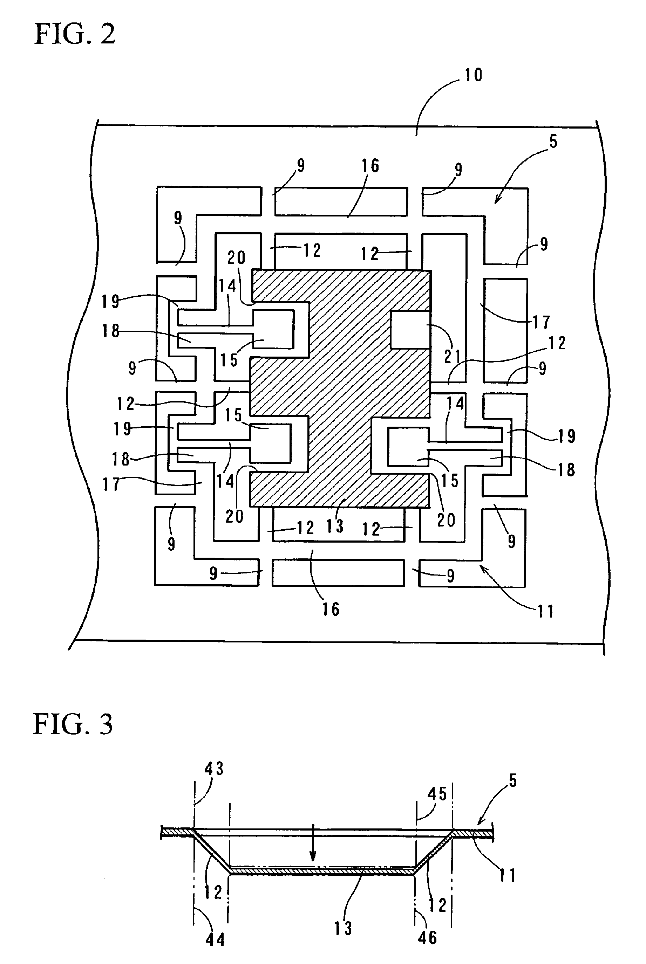

The terminals 15 supported by the support arms 14 are extended inwardly from the main frame 11 and are located inside respective cutouts 20 which are horizontally cut into the peripheral portion of the shield plate 13. As shown in Fig. 1, a total of three terminals 15 serving as a power-supply terminal, an output terminal, and a gain terminal are accommodated for the lead frame 5 such that two terminals 15 are disposed in the right side while one terminal 15 is disposed in the left side. As shown in Fig. 2, a ground terminal 21 is formed at an upper position of the backside of the shield plate 13 which is placed symmetrically with the terminal 15 adapted to the upper position of the right-side longitudinal frame 17. The ground terminal 21 is formed by electing half-etching on the backside of the shield plate 13 (except for the area of the ground terminal 21), so that the ground terminal 21 slightly projects from the half-etched backside of the shield plate 13. Fig. 2 shows the backside of the lead frame 5, in which hatching areas are subjected to half-etching. The surfaces of the terminals 15 and 21 serve as internal terminals exposed inside the package base 7, while the backsides of the terminals 15 and 21 serve as external terminals exposed outside of the package base 7.

The lead frame 5 having the above outline configuration is mechanically reshaped by deforming the interconnection arms 12 and the support arms 14 such that the shield plate 13 is depressed downwardly from the main frame 11 as shown in Fig. 3. Since the interconnection arms 12 are disposed along four sides of a rectangular shape with respect to the main frame 11 and the shield plate 13, they are slightly expanded by way of deformation. In Fig. 1, thin lines indicate fold lines, by which the interconnection arms 12 are bent at their opposite ends connected to the main frame 11 and the shield plate 13, so that the intermediate portions thereof are linearly expanded in the longitudinal direction.

Since the support arms 12 are cantilevered by the longitudinal frames 17 of the main frame 11, they are bent by way of deformation so that the terminals 15 disposed at the distal ends of the support arms 14 are placed in the same plane as the shield plate 13. Figs. 1 and 2 show the deformation-completed state of the lead frame 5 in which the terminals 15 connected to the support arms 14 are moved proximately to the openings of the cutouts 20. In the development state before deformation, the terminals 15 are originally disposed in the backs of the cutouts 20 indicated by dashed lines.

The present specification refers to the three-dimensionally deformed state of the lead frame 5 in which the interconnection arms 12 and the support arms 14 are already deformed. In contrast, it refers to a flat frame material corresponding to the development state in which the interconnection arms 12 and the support arms 14 are not deformed in the main frame 11, which is thus straightened in the same plane and in which the terminals 15 are at the positions indicated by dashed lines in Fig. 1.

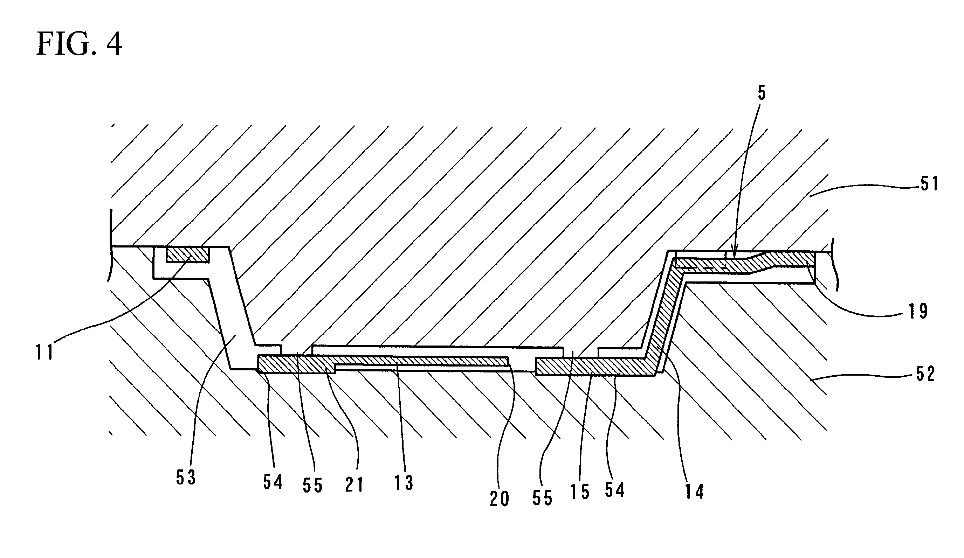

With respect to the connection between the main frame 11 and the support arms 14, the bent portions 19 of the longitudinal frames 17 are integrally placed in the same plane as the main frame 11, while the base portions of the support arms 14 disposed at the backs of the recesses 18 are bent but their extended portions within the recesses 18 are slightly depressed downwardly, compared to the surface of the main frame 11 (see Figs. 4 to 7).

The lead frame 5 mechanically processed above is unified with the mold resin 6 so as to form the package base 7. As shown in Figs. 6 and 7, the box-shaped mold resin 6 is constituted of a base portion 31 having a rectangular shape which is elongated so as to linearly mount the microphone chip 2 and the control chip 3 thereon and a prism-shaped peripheral wall 32 vertically disposed on the periphery of the base portion 31.

The shield plate 13 and the terminals 15 are embedded in the base portion 31 of the mold resin 6 while the backsides of the terminals 15 and 21 (serving as the external terminals) are exposed on the backside of the base portion 31. Specifically, the backsides of the terminals 15 and 21 slightly project from the backside of the base portion 31. The base portion 31 covers the shield plate 13 and the surfaces of the terminals, wherein four openings 33 are formed on the surface of the base portion 31 so as to partially expose the surfaces of the terminals 15 and 21.

The microphone chip 2 and the control chip 3 are fixed onto the base portion 31 via die bonding and are electrically connected to the surfaces of the terminals 15 and 21 exposed in the openings 33 of the base portion 31 of the mold resin 6 via bonding wires 34. The microphone chip 2 is constituted of a diaphragm electrode and a fixed electrode which are positioned opposite to each other, thus detecting variations of electrostatic capacitance based on vibration of the diaphragm electrode occurring due to pressure variations such as sound-pressure variations. The control chip 3 includes a power-supply circuit for supplying electric power to the microphone chip 2 and an amplifier for amplifying an output signal of the microphone chip 2.

As shown in Fig. 7, the prism-shaped peripheral wall 32 is vertically disposed on the peripheral of the base portion 31 for embedding the shield plate 13 of the lead frame 5 such that the surrounding area thereof is gradually widened from the lower section to the upper section thereof. An external flange 35 is unified with the upper end of the peripheral wall 32. The interconnection arms 11 and the support arms 14 are embedded inside the peripheral wall 32, wherein the surface of the main frame 11 is partially exposed on the external flange 35 on the upper end of the peripheral wall 32. The proximate portions proximate to the bent portions 19 of the main frame 11 are cut out so that the support arms 14 connected to the bent portions 19 are slightly lowered in position, compared to the main frame 11, and are embedded in the external flange 35, while the cut portions of the support arms 14 are exposed externally of the external flange 35.

The cover 8 attached onto the package base 7 is composed of a conductive metal material such as copper and is formed in a rectangular shape substantially matching the outline shape of the external flange 35 on the upper end of the peripheral wall 32. A sound hole 41 is formed to run through the cover 8 at a prescribed position, thus allowing an internal space 42, which is formed between the package base 7 and the cover 8, to communicate with the external space. The cover 8 is bonded to the external flange 35 on the upper end of the peripheral wall 32 via a conductive bonding material, thus enclosing the internal space 42 surrounded by the peripheral wall 32 while allowing the internal space 42 to communicate with the external space via the sound hole 41. In addition, an electric connection is established between the cover 8 and the main frame 11 which is partially exposed on the external flange 35. That is, the package 4 is designed to sequentially and electrically connect the cover 8 to the main frame 11 of the lead frame 5, the interconnection arms 12, and the shield plate 13, wherein the cover 8 and the lead frame 5 are arranged to encompass the internal space 42 therein. Herein, the three terminals 15 disposed in the cutouts 20 of the shield plate 13 are disposed independently of the shield plate 13.

Next, a manufacturing method of the semiconductor device 1 will be described in detail.

First, half-etching is performed using masks covering prescribed areas of a metal plate so as to reduce the thickness of the lead frame 5, hatching areas (see Fig. 2) of which are thus reduced to approximately a half of the original thickness. Then, press working is performed so as to punch out the outline of a flat frame material which is connected to the external frame 10 via the connections 9. Subsequently, the flat frame material is subjected to drawing so as to deform the interconnection arms intervened between the main frame 11 and the shield plate 13, thus depressing the shield plate 13 in position, compared to the main frame 11. Fig. 3 shows a press metal plate for use in drawing, in which the main frame 11 is held between press molds 43 and 44 as shown by dashed lines while the shield plate 13 is held between an upper punch 45 and a lower punch 46. Depressing the shield plate 13 downwardly allows the interconnection arms 12 to be deformed and expanded. That is, the interconnection arms 12 are subjected to bending deformation and linearly expanding deformation in the length direction thereof.

At the same time, the support arms 14 are subj ected to bending deformation so as to position the terminals 15 in the cutouts 20 and to place them in the same plane as the shield plate 13. Due to bending of the support arms 14, the terminals 15 which are originally positioned in the backs of the cutouts 20 (indicated by dashed lines in Fig. 1) in the development state of the lead frame 5 are moved close to the openings of the cutouts (indicated by solid lines in Fig. 1) in the deformation-completed state of the lead frame 5. That is, the terminals 15 are supported by the support arms 14 while being slid in position due to deformation of the support arms 14.

Next, the lead frame 5 completed in pressing is placed in an injection metal mold, in which the mold resin 6 is formed to embed the lead frame 5 therein. Fig. 4 shows that the lead frame 5 completed in pressing is placed in the injection metal mold. Recesses 54 are formed to partially concave the interior surface on a lower mold 52 in association with a cavity 53 and are engaged with the terminals 15 and 21, which are thus stopped in movement during injection molding. Since the backside of the shield plate 13 is subjected to half-etching except for the ground terminal 21, the terminals 15 and 21 slightly project from the half-etched backside of the shield plate 13, so that the depths of the recesses 54 are slightly smaller than the heights of the terminals 15 and 21 projecting from the half-etched backside of the shield plate 13. When the backsides of the terminals 15 and 21 are brought into contact with the backs of the recesses 54, the half-etched backside of the shield plate 13 slightly floats above the interior surface of the lower mold 52. The back areas of the recesses 54 are slightly larger than the areas of the terminals 15 and 21 in order to permit their tolerances. The surfaces of the terminals 15 and 21 are brought into contact with projections 55 of an upper mold 51, which are used to form the openings 33 of the mold resin 6.

The surface of the main frame 11 and the surfaces of the bent portions 19 of the main frame 11 are brought into contact with the interior surface of the upper mold 51 in association with the cavity 53. Due to clamping of the upper mold 51, the interior surface of which is placed in contact with the surface of the main frame 11 and the surfaces of the bent portions 19, and the lower mold 52, the interior surface of which is placed in contact with the backsides of the terminals 15 and 21, the interconnection arms 12 and the support arms 14 are slightly deflected in the cavity 53. Due to a pressing force exerted by the upper mold 51 and the lower mold 52, the surface of the main frame 11 is placed in close contact with the interior surface of the upper mold 51.

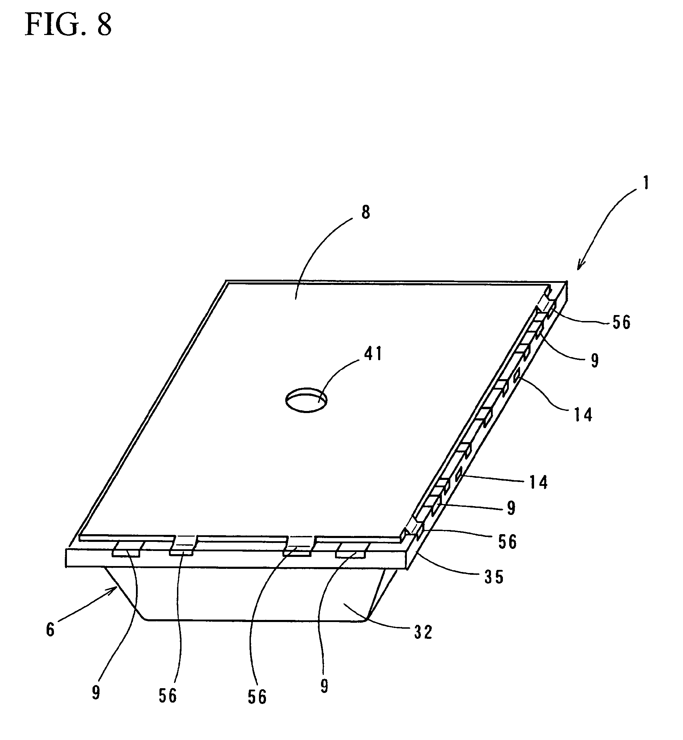

Thereafter, the lead frame 5 is unified with the mold resin 6 so as to form the package base 7. The semiconductor chips 2 and 3 are fixed onto the base portion 31 of the package base 7 via die bonding and are electrically connected to the terminals 15 and 21 which are exposed in the openings 33 of the base portion 31 via wire bonding. A conductive bonding agent is applied to the upper end of the peripheral wall 32, subsequently, the cover 8 which is produced independently is attached onto the package base 7. In this stage, a plurality of package bases (each corresponding to the package base 7) is interconnected together such that adjacent lead frames (each corresponding to the lead frame 5) are interconnected together via the connections 9. Similarly, a plurality of covers (each corresponding to the cover 8) is interconnected together with prescribed pitches (corresponding to pitches between package bases) therebetween via connections 56 (see Fig. 8). That is, numerous covers are collectively attached onto numerous package bases.

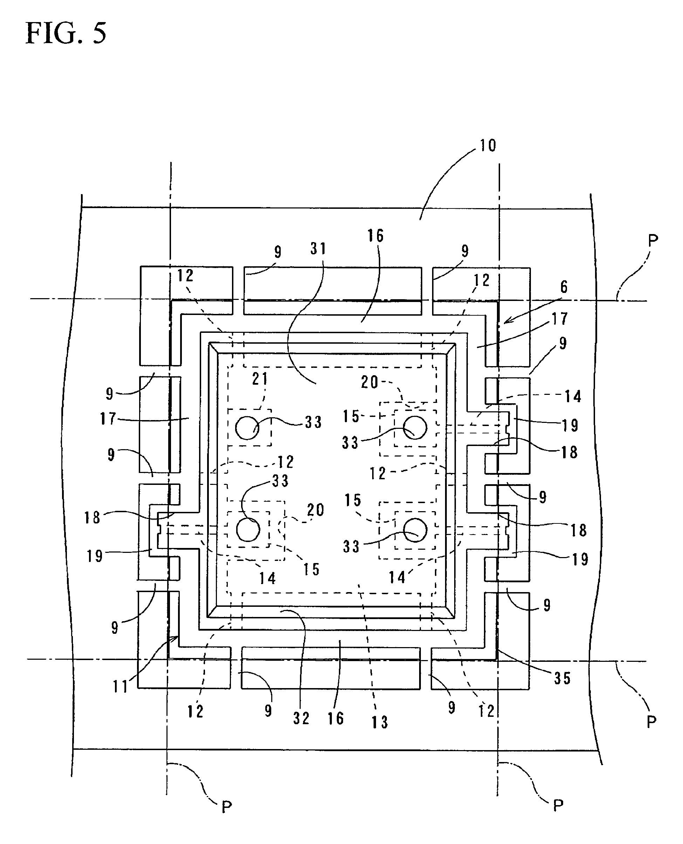

After bonding between the package base 7 and the cover 8, the connections 9 of the lead frame 5, which project externally of the mold resin 6, the connections 56 of the cover 8, and the bent portions 19 of the main frame 11 are collectively subjected to cutting, thus individually separating the package 4. Fig. 5 shows the package base 7 before being assembled with the cover 8, wherein straight dashed lines indicate cut lines P. Before cutting, the bent portions 19 project externally from the main frame 11, while the support arms 14 are bent and deformed inside the recesses 18 defined by the bent portions 19, so that the mold resin 6 partially enters into the recesses 18. Therefore, the package base 7 is subjected to cutting together with the mold resin 6.

Thus, it is possible to produce the semiconductor device 1 of the surface-mount type as shown in Fig. 7, wherein the terminals 15 and 21 slightly projecting from the backside of the package 4 are soldered onto the surface of an external substrate S (indicated by a dashed line). In this state in which the semiconductor device 1 is fixed onto the surface of the external substrate S, the shield plate 13 is positioned below the semiconductor chips 2 and 3; the shield plate 13 is connected to the cover 8 via the interconnection arms 12 and the main frame 11; and the cover 8 is positioned above the semiconductor chips 2 and 3. That is, the semiconductor chips 2 and 3 are surrounded by the shield plate 13 and the cover 8, wherein the ground terminal 21 of the shield terminal 13 is grounded so as to shield the semiconductor chips 2 and 3 from an external magnetic field. The lateral frames 16 and the longitudinal frames 17 (forming the main frame 11) are entirely exposed and circumferentially disposed on the external flange 35 on the upper end of the peripheral wall 32 together with the corners thereof except for the bent portions 19 which are cut out; hence, it is possible to secure an adequately large contact area with the cover 8, thus reliably establishing electric connection therebetween.

When the semiconductor device 1 is fixed onto the external substrate S, only the terminals 15 and 21 slightly projecting from the backside of the package base 7 are brought into contact with the surface of the external substrate S (see dashed lines in Fig. 7). Thus, it is possible to avoid the occurrence of defectiveness due to foreign matter entering between the base portion 31 and the external substrate S.

Since the base portion 31 is smaller than the outline of the external flange 35 on the upper end of the peripheral wall 32, it is possible to reduce the mounting area of the semiconductor device 1 on the external substrate S; hence, it is possible to reduce interference between the semiconductor device 1 and the circuitry of the external substrate S, thus achieving high-density packaging.

### 2. Second Embodiment

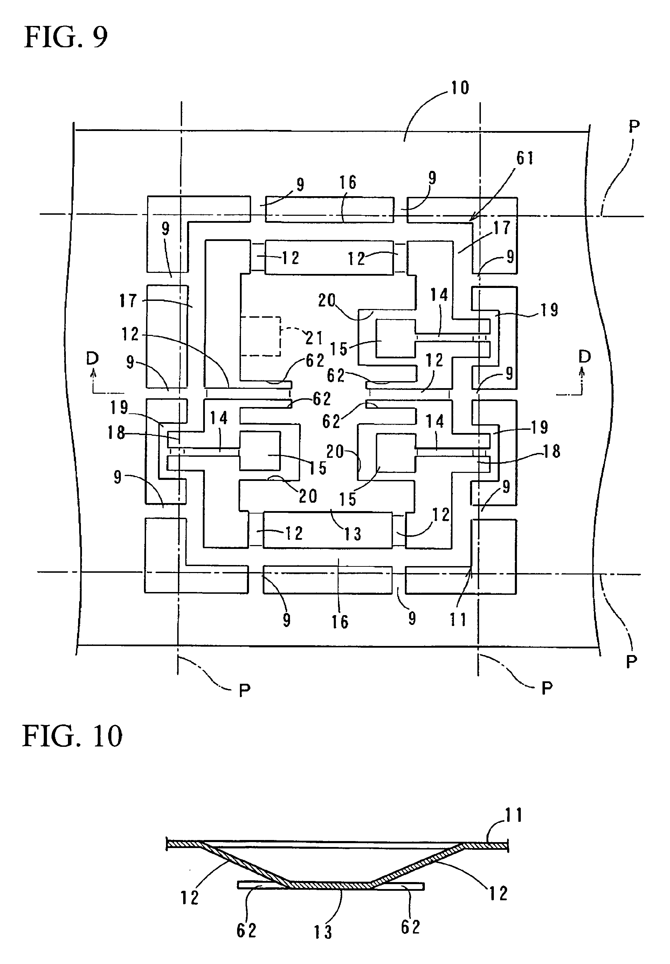

A semiconductor device according to a second embodiment of the present invention will be described with reference to Figs. 9 to 12, wherein parts identical to those of the semiconductor device 1 of the first embodiment are designated by the same reference numerals, thus avoiding duplicate descriptions thereof.

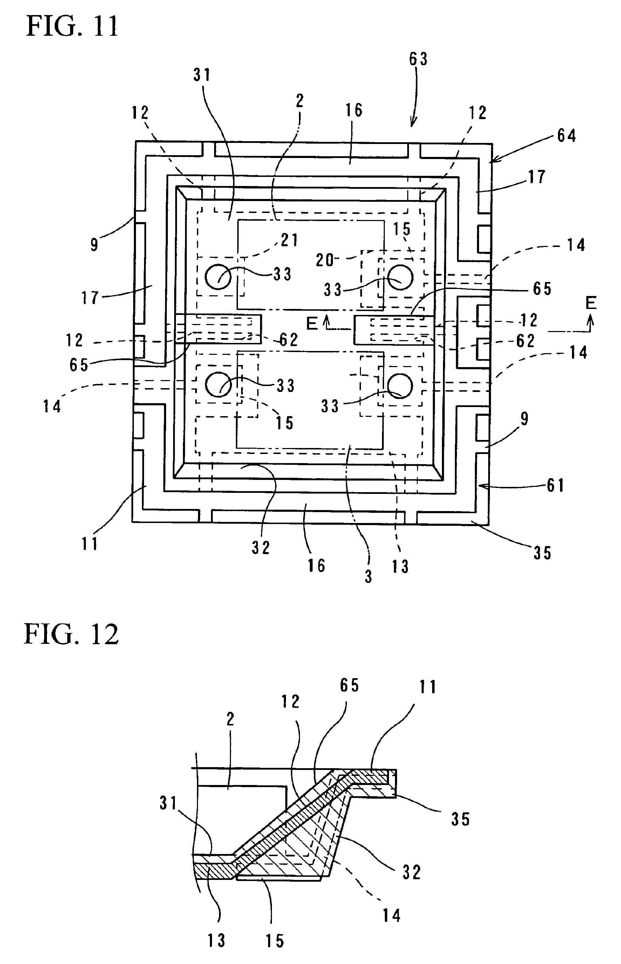

Compared with the lead frame 5 of the first embodiment shown in Fig. 1, a lead frame 61 of the semiconductor device of the second embodiment is **characterized in that** slits 62 are additionally formed to partially cut into the shield plate 13 so as to further extend the interconnection arms 12 derived from the center positions of the longitudinal frames 17. That is, the distal ends of the interconnection arms 12 are disposed at the recessed positions on the longitudinal sides of the shield plate 13. When the shield plate 13 is subjected to pressing and is depressed in position compared to the main frame 11, the interconnection arms 12 are each bent upwardly between the opposite slits 62 thereby so that they are slantingly arranged between the shield plate 13 and the main frame 11 as shown in Fig. 10. A package base 63 is formed by unifying the lead frame 61 with a mold resin 64 and is constituted of the base portion 31 and the peripheral wall 32 similar to the package base 7 of the first embodiment. The package base 63 of the second embodiment is **characterized in that,** as shown in Figs. 11 and 12, triangular ribs 65 project inwardly from the peripheral wall 32 so as to form slopes slanted between the base portion 31 to the upper end of the peripheral wall 32. The slanted interconnection arms 12 are embedded in the mold resin 64 by the triangular ribs 65. The triangular ribs 65 are disposed between the areas (encompassed by dashed lines in Fig. 11) of the semiconductor chips 2 and 3 so as not to interfere with the semiconductor chips 2 and 3.

Compared with the lead frame 5 of the first embodiment, the lead frame 61 of the second embodiment is **characterized in that** the interconnection arms 12 are increased in length, which in turn reduces expansion of the interconnection arms 12 during pressing, thus improving processing ability of the lead frame 61.

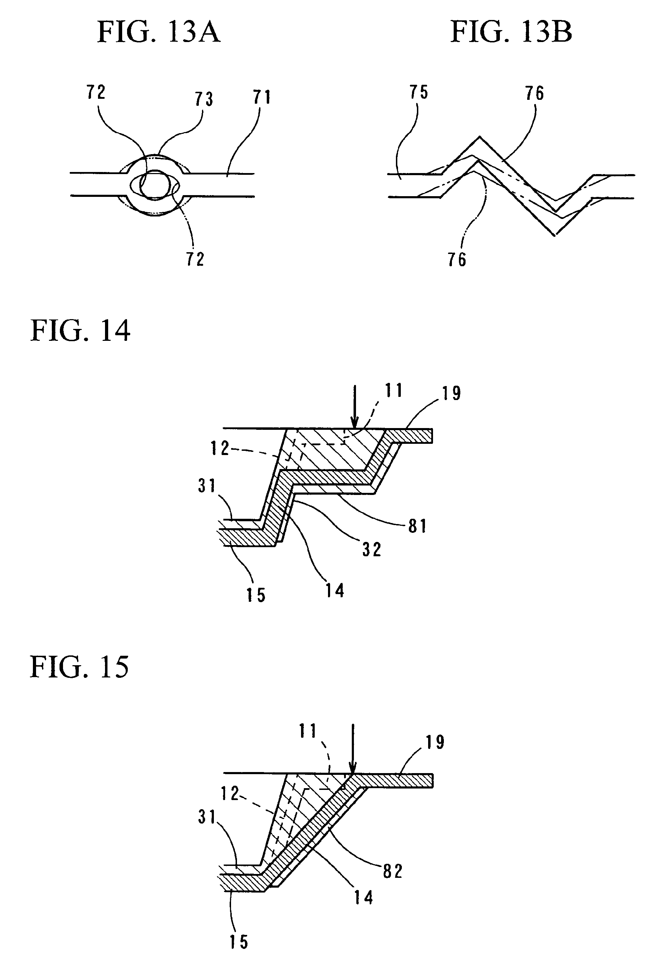

It is possible to reshape the intermediate portions of the interconnection arms 12 as shown in Figs. 13A and 13B. Fig. 13A shows an interconnection arm 71 whose mid-portion is slightly widened so as to form a wide portion 72 having a circular hole 73 at its. The diameter of the circular hole 73 is larger than the width of the interconnection arm 71. When the interconnection arm 71 is stretched due to drawing, the wide portion 73 is deformed into a shape indicated by dashed lines so that the circular hole 72 is expanded into an elliptical shape. The deformation of the wide portion 73 may greatly contribute to bending rather than stretching, so that bending deformation partially absorbs tensile stress, thus making it easy for the interconnection arm 71 to be deformed. Fig. 13B shows an interconnection arm 75 whose intermediate portion is bent so as to form a meandering portion 76 in plan view. The interconnection arm 75 can be easily deformed during drawing as indicated by dashed lines such that the meandering portion 76 is bent and stretched.

In the lead frame 5 of the first embodiment, the support arms 14 are slightly lowered in position compared to the surface of the main frame 11 within the thickness of the flange 35. It is possible to replace the flange 35 with a thick flange 81 which is externally expanded from the mid-position of the peripheral wall 32 in its height direction as shown in Fig. 14. Correspondingly, the support arm 14 is bent at the mid-position of the peripheral wall 32 and is thus embedded in the thick flange 81. In the modification of Fig. 14, the thick flange 81 is subjected to cutting together with the support arm 14 at an arrow-designating position, thus forming the package base. Alternatively, it is possible to modify the structure as shown in Fig. 15 in which the support arm 14 is slanted with an angle which is smaller than that of the interconnection arm 12 and is slantingly disposed in a peripheral wall 82 between the terminal 15 to the bent portion 19 of the main frame 11. In this modification, the peripheral wall 82 gradually increases in thickness from the lower section to the upper section thereof, wherein the support arm 14 is subjected to cutting together with its surrounding resin at an arrow-designating position on the upper end of the peripheral wall 82.

### 3. Third Embodiment

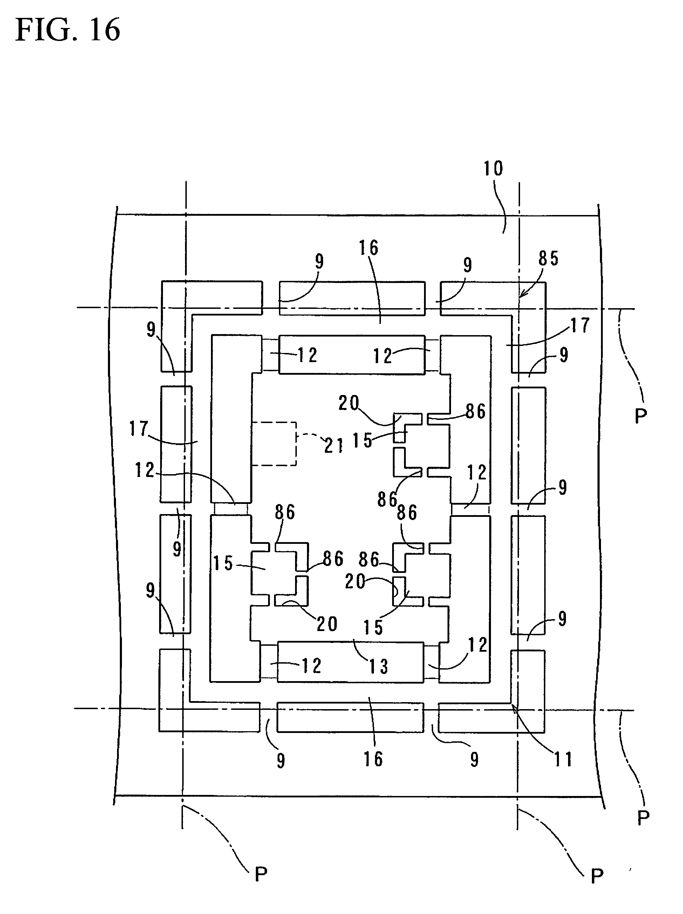

A semiconductor device according to a third embodiment of the present invention will be described with reference to Fig. 16, wherein it is characterized by modifying the structure for supporting the terminals 15 in a lead frame 85, compared to the lead frames 5 and 61 of the first and second embodiments. In the first and second embodiments, the terminals 15 are disposed independently of the shield plate 13 and are cantilevered and supported by the support arms 14 derived from the main frame 11. The lead frame 85 is designed without using the support arms 14 such that the terminals 15 positioned inside of the cutouts 20 of the shield plate 13 are interconnected to the shield plate 13 via a plurality of bridges 86. After completion of resin molding, the bridges 86 are subjected to laser cutting so as to separate the terminals 15 from the shield plate 13. In the first and second embodiments in which the support arms 14 are bent and deformed so as to move the terminals 15 inside the recesses 20 of the shield plate 13 due to pressing, it is necessary to estimate the movements of the terminals 15 due to pressing in determining the positional relationship between the shield plate 13 and the terminals 15. The lead frame 85 of Fig. 16 is designed not to vary the positional relationship between the shield plate 13 and the terminals 15 before and after pressing; this makes it easy for a manufacturer to design and manufacture the lead frame 85.

### 4. Fourth Embodiment

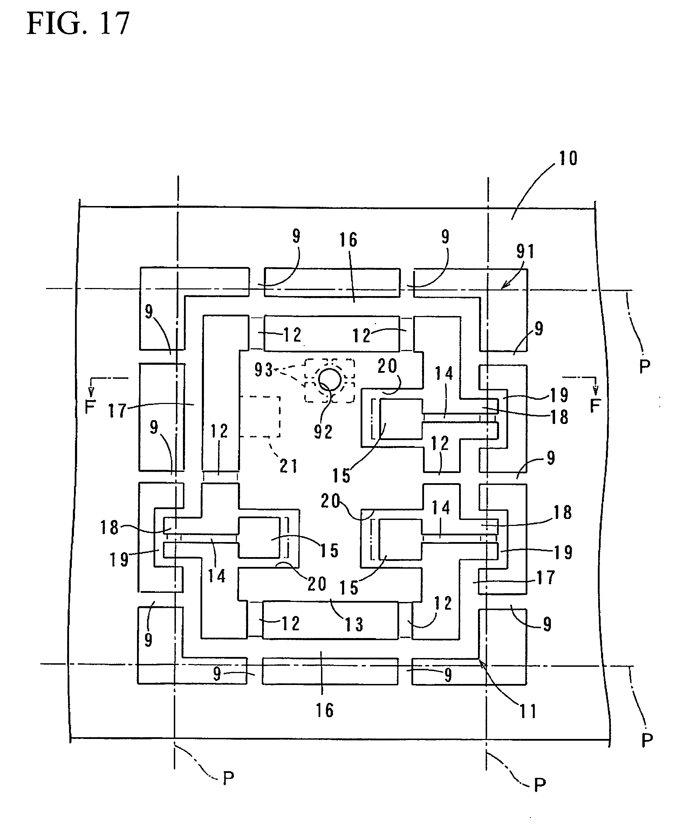

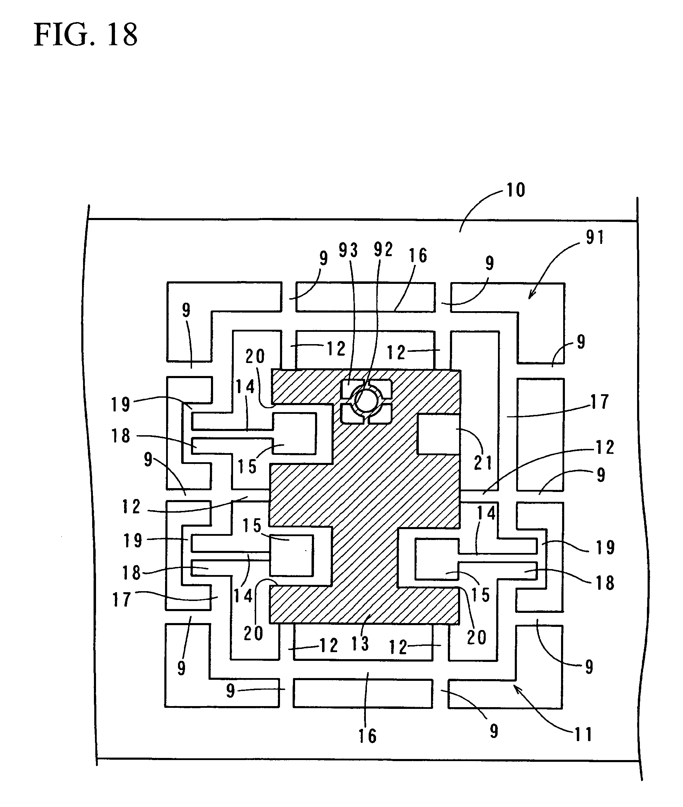

A semiconductor device 105 according to a fourth embodiment of the present invention will be described with reference to Figs. 17 to 20. In contrast to the semiconductor 1 of the first embodiment in which the sound hole 41 is formed in the cover 8, the semiconductor device 105 of the fourth embodiment is designed to form a sound hole 100 in a package base 102. As shown in Figs. 17 and 18, a lead frame 91 for use in the semiconductor device 100 is designed such that a lower hole 92 serving as a sound hole is formed to run through the shield plate 13 at a prescribed position. Similar to the lead frame 5 of the first embodiment, the lead frame 91 of the fourth embodiment includes the main frame 11, the interconnection arms 12, and the terminals 15 and 21. In addition, the backside of the shield plate 13 is subjected to half-etching (see hatching areas in Fig. 18) so that the shield plate 13 is reduced in thickness except for the ground terminal 21. As shown in Fig. 18, the surrounding area of the lower hole 92 is subjected to half-etching except for a plurality of projections 93 (i.e. four projections 93 which circumferentially surround the backside of the lower hole 92 in a radial direction with equal angular spacing therebetween). That is, the thickness of the projections 93, which are vertically disposed on the backside of the shield plate 13 in proximity to the lower hole 92, is identical to the thickness of the ground terminal 21 of the shield plate 13.

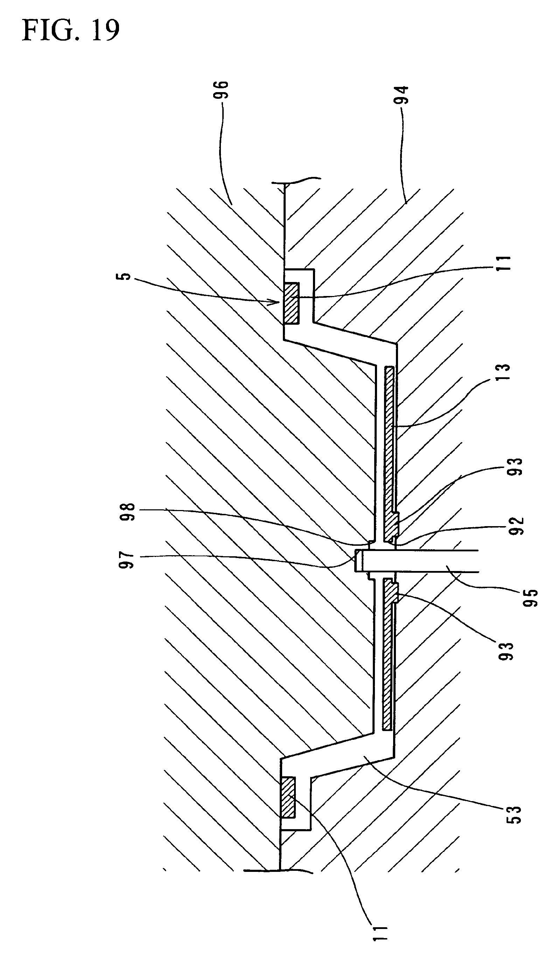

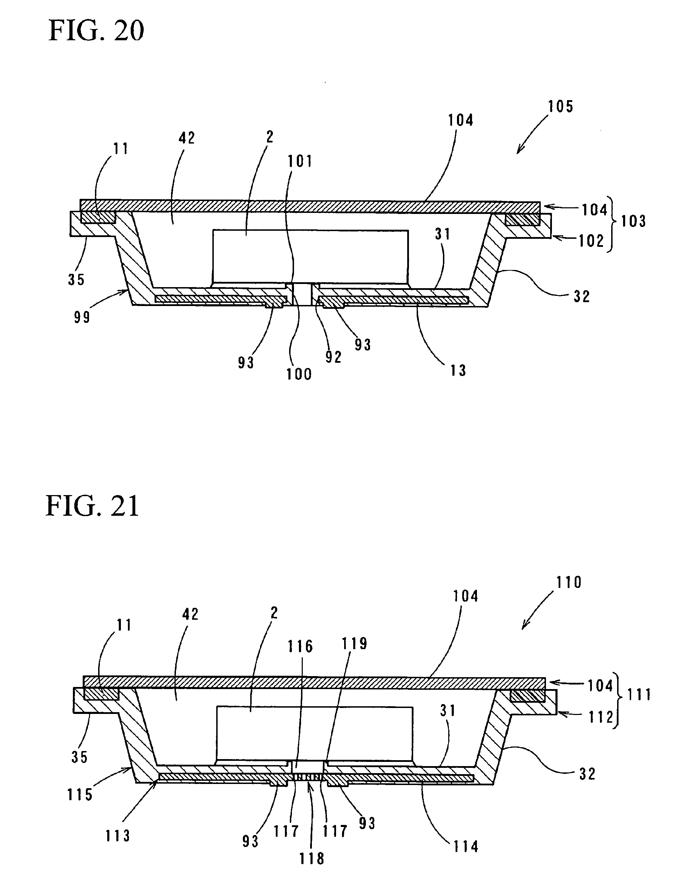

The lead frame 91 is subjected to pressing and is then placed in an injection metal mold shown in Fig. 19. In the injection metal mold of Fig. 19, a pin 95 whose diameter is slightly smaller than the diameter of the lower hole 92 of the lead frame 91 is disposed to vertically project from a lower mold 94 at a prescribed position, while a hole 97 for inserting the distal end of the pin 95 and a counterbore 98 whose diameter is slightly larger than the diameter of the hole 97 are concentrically formed in an upper mold 96. Due to clamping of the lower mold 94 and the upper mold 96, the pin 95 is inserted into the hole 97 so as to form a cylindrical space by the counterbore 98 around the pin 95. When a melted resin is injected into the injection metal mold holding the lead frame 91, the lead frame 91 is sealed with a mold resin 99, which is constituted of the base portion 31 and the peripheral wall 32, thus forming the package base 102. As shown in Fig. 20, the sound hole 100 is formed in the base portion 31 of the mold resin 99 by the pin 95, while a cylindrical wall 101 is formed to surround the sound hole 100 on the surface of the base portion 31 of the resin mold 99. The cylindrical wall 101 dams up a bonding agent, which is used to bond the semiconductor chips 2 and 3 onto the surface of the base portion 31 via die bonding, so as to prevent it from overflowing into the sound hole 100. A cover 104 having no hole is assembled with the package base 104 so as to form a package 103. In the semiconductor device 105 similar to the semiconductor device 1, the cover 104 composed of a conductive metal material is electrically connected to the main frame 11 of the lead frame 91 so as to shield the internal space 42 circumscribed by the package base 102 and the cover 104.

### 5. Fifth Embodiment

A semiconductor device according to a fifth embodiment of the present invention will be described with reference to Figs. 21 to 23, wherein it is designed based on the semiconductor device 105 of the fourth embodiment in which the sound hole 100 is formed in the package base 102. The semiconductor device 110 is encapsulated in a package 111 which is formed by assembling a package base 112 with the cover 104, wherein the package base 112 is formed by sealing a lead frame 113 having a shield plate 114 with a mold resin 115. A circular area of the mold resin 115 is extracted to form a window hole 116, thus exposing a circular area of the shield plate 114. A plurality of small holes 117 runs through the exposed area of the shield plate 114, thus forming a sound hole 118. A cylindrical wall 119 is formed to surround the sound hole 118 on the shield plate 114 of the lead frame 113.

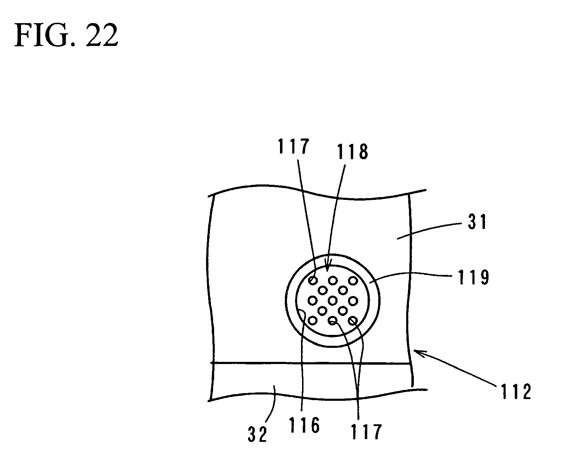

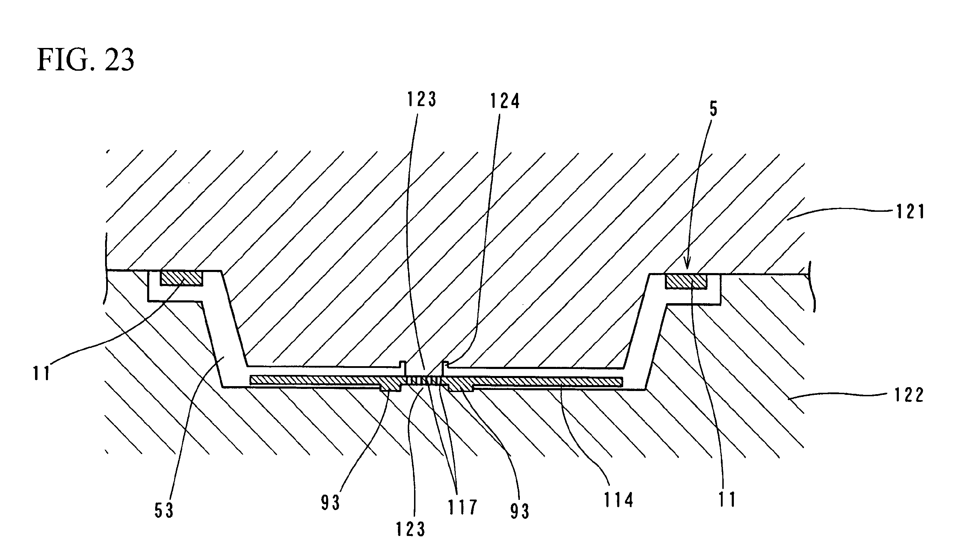

In manufacturing of the package base 112, the small holes 117 collectively forming the sound hole 118 are formed by way of half-etching on the lead frame 113. The fifth embodiment resembles the other embodiments such that the lead frame 113 is subjected to half-etching using a mask having holes corresponding to the small holes 117 on the prescribed area used for the formation of the sound hole 118, thus forming the small holes 117 running through the shield plate 114 of the lead frame 117. In injection molding of the mold resin 115 for sealing the lead frame 113 as shown in Fig. 23, the prescribed area of the shield plate 114 (used for the formation of the sound hole 118) is held between circular projections 123 which project from upper and lower molds 121 and 122, thus temporarily closing the small holes 117. In addition, a circular channel 124 is formed in proximity to the circular projection 123 of the upper mold 121. This makes it possible for the shield plate 114 to be partially exposed in the circular area thereof and to thereby form the sound hole 118 consisting of the small holes 117 running through the exposed area of the shield plate 114 as shown in Figs. 21 and 22. When the cylindrical wall 119 is capable of adequately damming a bonding agent applied to the semiconductor chip 2, it can be formed in an arc-shape in plan view so as to surround approximately half the area formed between the sound hole 118 and the mounting area used for mounting the semiconductor chip 2.

The above structure of the sound hole 118 is efficient in manufacturing because it can be formed by way of etching, which is an essential step of manufacturing. Since the sound hole 118 consists of small holes 117 each having a small opening, it is possible to reliably prevent foreign matter such as dust from entering into the internal space 42 circumscribed between the package base 112 and the cover 104, thus suppressing the occurrence of noise.

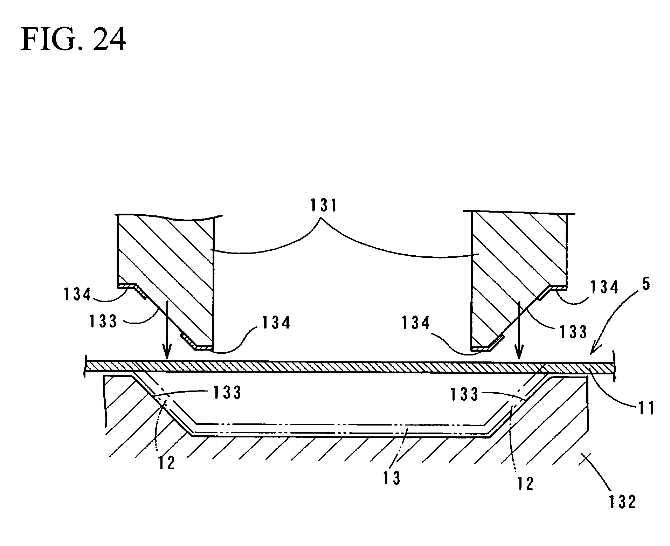

Fig. 24 shows another example of a press metal mold used for depressing the shield plate of the lead frame. The press metal mold used in the first embodiment (circumscribed by dashed lines in Fig. 3) is an upper/lower-mold separation type in which the main frame 11 is held between the press molds 43 and 44 so that the shield plate 13 is depressed by the "mobile" punches 45 and 46, thus deforming the interconnection arms 12. In contrast, the press metal mold of Fig. 24 is constituted of an upper mold 131 and a lower mold 132 both having slopes 133, wherein the interconnection arms 12 are held between the upper mold 131 and the lower mold 132 and are deformed by way of slopes 133. In order to allow the interconnection arms 12 to be smoothly expanded along the interior surfaces of the molds 131 and 132, small projections 134 are formed in the upper mold 131 at prescribed positions matching bent portions on opposite ends of the interconnection arms 12, whereby small gaps are formed between the interconnection arms 12 and the intermediate positions of the slopes 133. At the same time, the support arms 14 interconnected to the terminals 15 are subjected to bending as well.

It is necessary for the press metal mold of the first embodiment shown in Fig. 3 to independently drive the punches 45 and 46 of the press molds 43 and 44. In contrast, the press metal mold of Fig. 24 is designed with a simple structure for simultaneously driving the upper mold 131 and the lower mold 132.

In manufacturing of the lead frame, it is possible to simultaneously perform drawing on the interconnection arms and support arms. Alternatively, the support arms are subjected to bending, then, the interconnection arms are subjected to drawing. In order to minimize error between bending and drawing, it is possible to additionally introduce a mold pressing step for adjusting the processed shape of the lead frame after bending and drawing.

The first to fifth embodiments may suffer from a minor probability of drawback dependent upon materials, thickness, and processing dimensions of lead frames such that interconnection arms will be destroyed during expansion and bending deformation. Sixth to ninth embodiments are designed to solve such a drawback by processing interconnection arms via bending only without causing expansion.

### 6. Sixth Embodiment

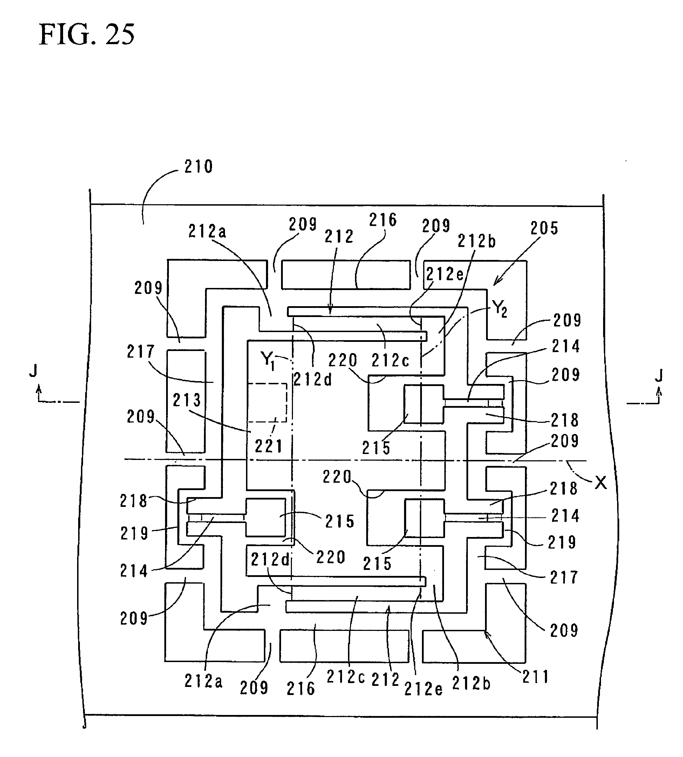

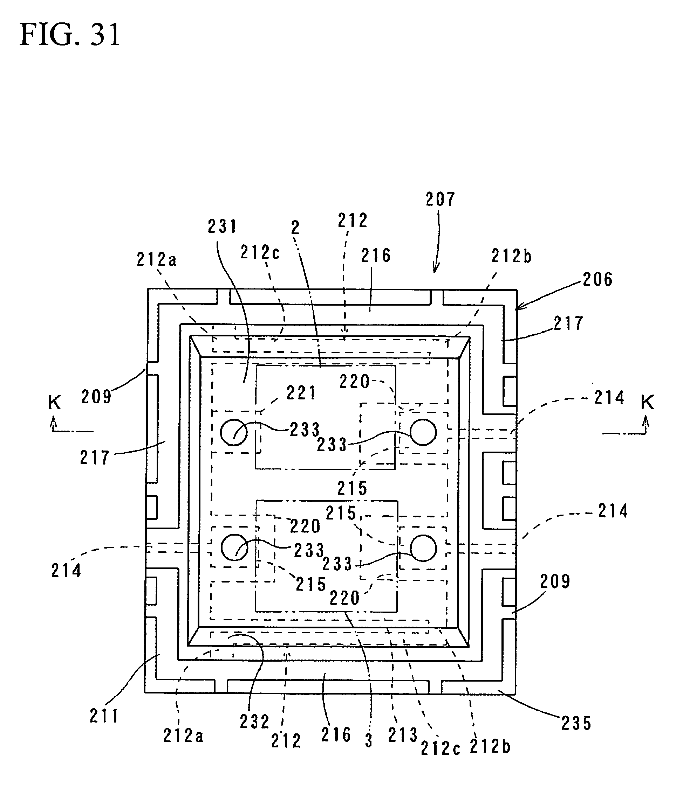

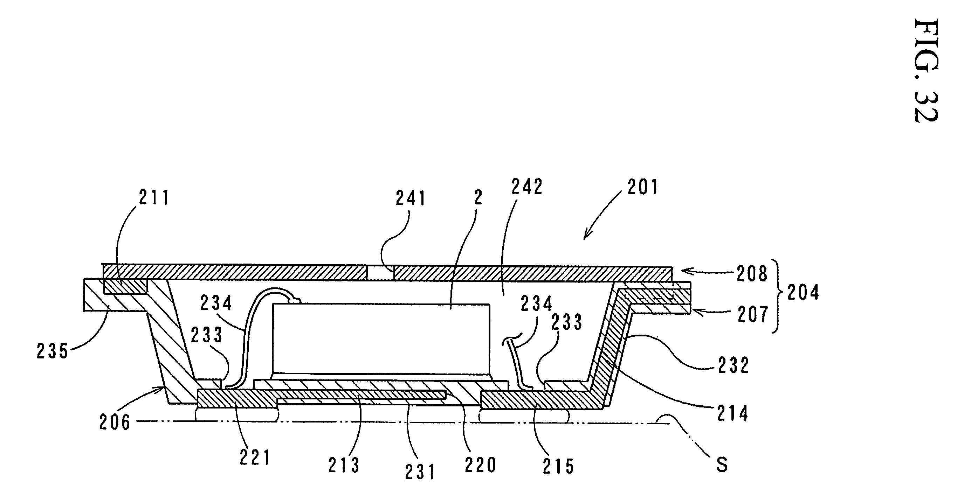

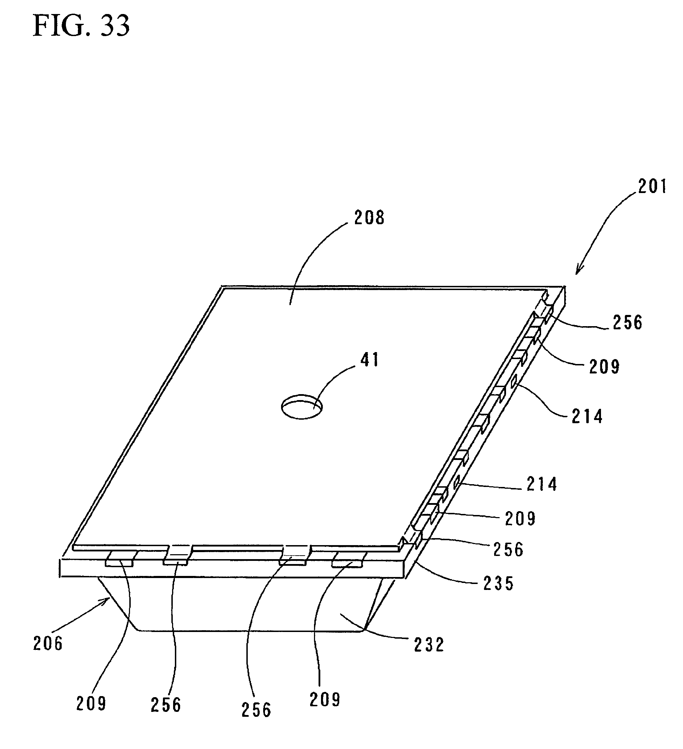

A semiconductor device 201 according to a sixth embodiment of the present invention will be described with reference to Figs. 25-26, 27A-27C, and 28-33. As shown in Figs. 31 and 32, the semiconductor device 201 is a surface-mount type microphone package containing the microphone chip 2 and the control chip 3. A lead frame 205 is unified with a box-shaped mold resin 206 so as to form a package base 207. The package base 207 is closed by a cover 208 so as to form a package 204.

A plurality of lead frames (each corresponding to the lead frame 205 shown in Fig. 25) is aligned in a single line or in plural lines on a sheet-shaped metal plate, which is subjected to press working so as to form individual lead frames collectively. In Fig. 25, reference numeral 209 designates connections which are formed by punching the lead frame 205 and are connected to an external frame 210.

The lead frame 205 is constituted of a rectangular-shaped main frame 211, a plurality of interconnection arms 212, a shield plate 213 which is placed inwardly of the main frame 211 and is connected to the main frame 211 via the interconnection arms 212, and a plurality of terminals 215 cantilevered by a plurality of support arms 214.

The main frame 211 is entirely formed in a rectangular shape in which a pair of lateral frames 216 is combined with a pair of longitudinal frames 217 at their opposite ends. Two connections 209 are disposed externally of each lateral frame 216, and three connections 209 are disposed externally of each longitudinal frame 217.

Two interconnection arms 212 are disposed between the shield plate 213 and the lateral frames 216 such that one interconnection arm 212 is disposed between each lateral side of the shield plate 213 and each lateral frame 216. The interconnection arms 212 are constituted of interconnection portions 212a and 212b, which interconnect between the lateral sides of the shield plate 213 and the lateral frames 216, and intermediate portions 212c horizontally extended between the interconnection portions 212a and 212b. The interconnection portions 212a and 212b are disposed perpendicularly between the shield plate 213 and the lateral frame 216 which are positioned opposite to each other but are shifted in position in the lateral direction. In plan view, the intermediate portion 212c is elongated in the lateral direction and in parallel with the shield plate 213 and the lateral frame 216 which are positioned opposite to each other. That is, the interconnection 212 consisting of the interconnection portions 212a and 212b, and the intermediate portion 212c is formed in a crank-shape.

The shield plate 213 is positioned between the interconnection arms 212 coupled with the lateral frames 216, wherein the interconnection arms 212 are positioned linearly symmetrical to each other with respect to a center line X passing through the center of the shield plate 213 shown in Fig. 25. That is, the crank-shape of the upper interconnection arm 212 is reverse to the crank-shape of the lower interconnection arm 212. In Fig. 25, both the interconnection portions 212a connected to the lateral frames 216 are positioned in the left-side while both the interconnection portions 212b connected to the lateral sides of the shield plate 213 are positioned in the right-side.

A pair of terminals 215 is connected to a pair of upper and lower positions of the right-side longitudinal frame 217 via a pair of support arms 214 with respect to the center line X of the shield plate 213. A terminal 215 is connected to a lower position of the left-side longitudinal frame 217 below the center line X and is positioned opposite to the terminal 215 disposed at a lower position of the right-side longitudinal frame 217 with respect to the shield plate 213. The prescribed parts of the longitudinal frames 217 are bent externally in proximate to the base portions of the support arms 214 so as to form bent portions 219 for circumscribing recesses 218 whose openings are directed inwardly. The support arm 214 is disposed to divide the inside area of the recess 218 surrounded by the bent portion 219 into two sections.

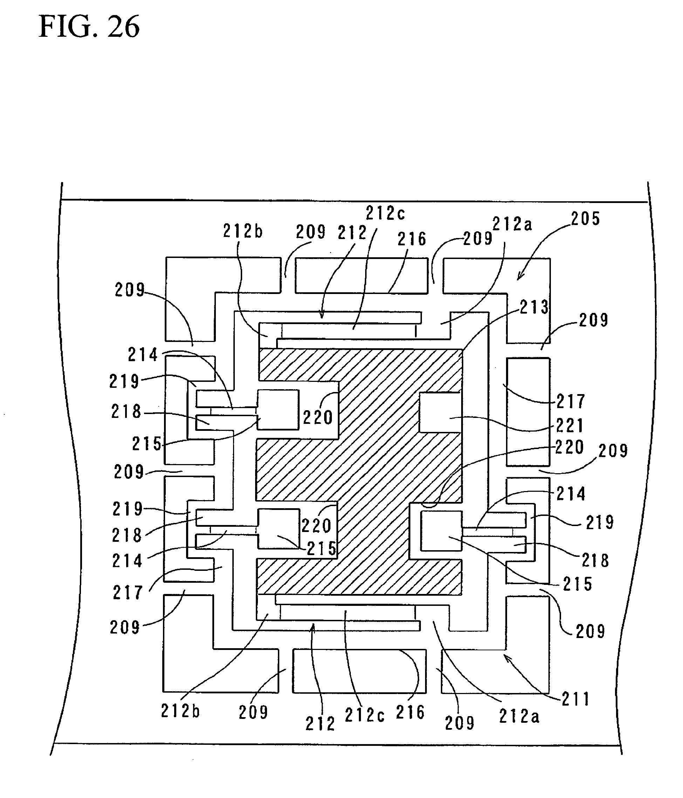

The terminals 215 are positioned inside the main frame 211 via the support arms 214 and are disposed inside cutouts 220 which are cut into the periphery of the shield plate 213. As shown in Fig. 25, three terminals used for power-supply, output, and gain are accommodated to the shield plate 213 such that two terminals 215 are disposed on the right-side of the shield plate 213 while one terminal is disposed on the left-side of the shield plate 213. A ground terminal 221 is formed on the backside of the shield plate 213 at an upper-left position of Fig. 25 (or an upper-right position of Fig. 26) which is opposite to the terminal 215 disposed in proximity to the upper position of the right-side longitudinal frame 217. The surfaces of the terminals 215 and 221 serve as internal terminals exposed inside the package base 207, while the backsides of the terminals 215 and 221 serve as external terminals exposed on the backside of the package base 207.

The backside of the shield plate 213 (and the backsides of the support arms 214 as necessary) is subjected to half-etching except for the terminals 215 and 221, which thus remain and slightly project from the backside of the shield plate 213. Fig. 26 shows the backside of the lead frame 205, in which hatching areas designate half-etched areas.

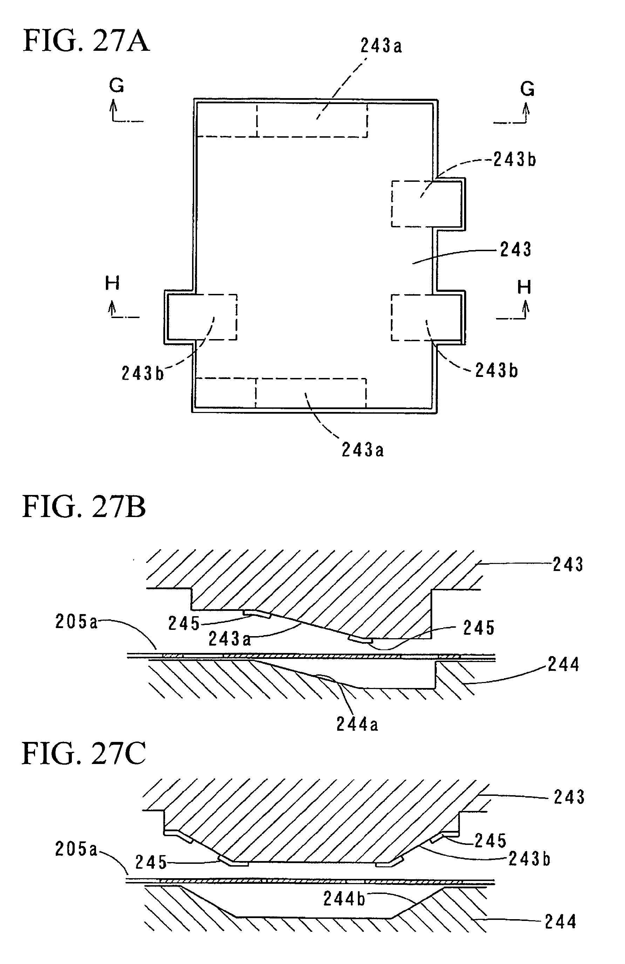

The lead frame 205 having the above outline configuration is subjected to processing for deforming the interconnection arms 212 and the support arms 214, so that the shield plate 213 is depressed in position, compared to the main frame 211. In Fig. 25, thin lines indicate fold lines by which the opposite ends of the intermediate portions 212c of the interconnection arms 212 are bent so as to form bent portions 212d and 212e, by which the intermediate portions 212c are slantingly deformed (see Figs. 27B and 27C). Fig. 25 shows a dashed line Y₁ imaginarily connecting between the bent portions 212d of the interconnection arms 212 in connection with the lateral frames 216 and a dashed line Y₂ imaginarily connecting between the bent portions 212e of the interconnection arms 212 in connection with the lateral sides of the shield plate 213. The dashed lines Y₁ and Y₂ are perpendicular to the center line X and parallel to each other with respect to the shield plate 213.

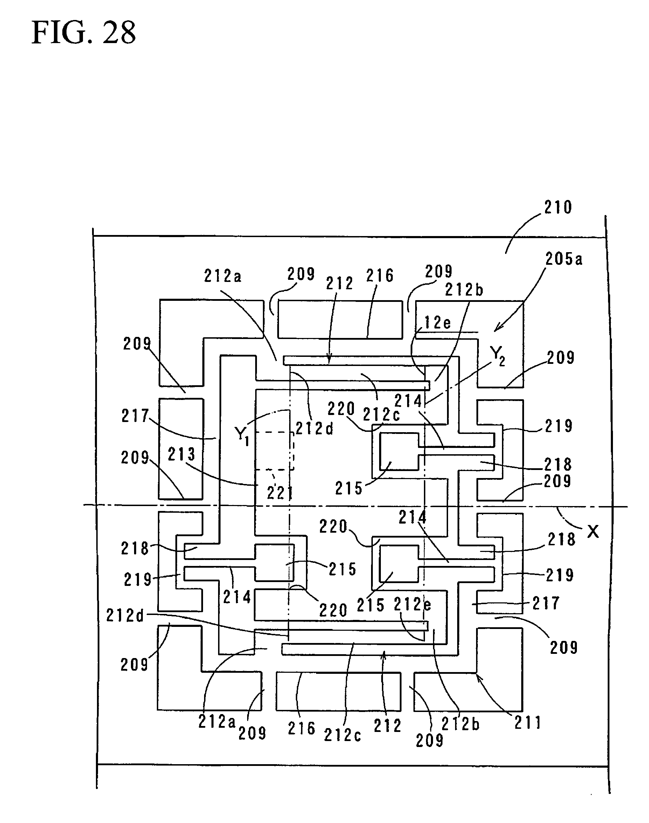

The support arms 214 are cantilevered by the longitudinal frames 217 of the main frame 211 and are thus deformable by bending, wherein the terminals 215 supported by the distal ends of the support arms 214 are placed in the same plane as the shield plate 213. Figs. 25 and 26 show the deformation-completed state of the lead frame 205 while Fig. 28 shows the development state of the lead frame 205 before deformation. Comparison between Fig. 25 and Fig. 28 clearly shows that the shield plate 213 is originally biased rightward in the inside area of the main frame 211 as shown in Fig. 28 before bending of the interconnection arms 212 and is moved to approximately the center position due to bending of the interconnection arms 212 as shown in Fig. 25. In the deformation-completed state shown in Fig. 25 and 26, the terminals 215 joining the distal ends of the support arms 214 are positioned close to the openings of the cutouts 220. In the development state shown in Fig. 28, the movement of the shield plate 213 due to deformation is estimated in advance so as to position the right-side terminals 215 in the backs of the cutouts 220. The left-side terminal 215 is not changed in relative positioning before and after deformation since it moves in the same moving direction as the cutout 220 of the shield plate 213 due to deformation. That is, the left-side terminal 215 is positioned close to the opening of the cutout 220 of the shield plate 213 in the development state shown in Fig. 28.

Similar to the first embodiment, the sixth embodiment refers to the lead frame 205 of the three-dimensionally-deformed state, in which the interconnection arms 212 and the support arms 214 are deformed, while referring to a flat frame material corresponding to the development state of the lead frame 205, in which interconnection arms 212 and the support arms 214 are not deformed and placed in the same plane as the main frame 211. In the flat frame material shown in Fig. 28, bent portions which will be formed by bending the interconnection arms 212 are designated by reference numerals 212d and 212e.

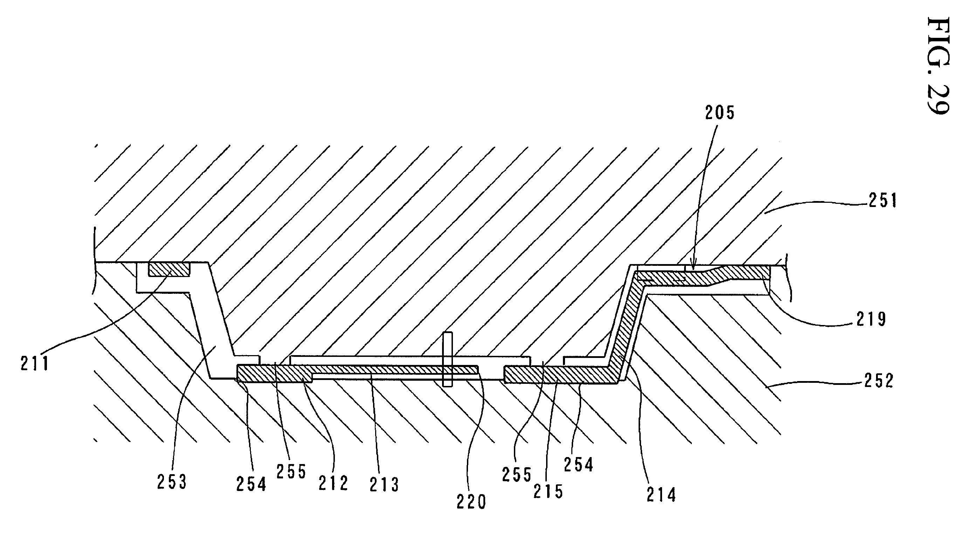

The bent portions 219 used for connecting the support arms 214 to the main frame 211 are placed in the same plane as the main frame 211. The base portions of the support arms 214, which are extended inside the recesses 218 in connection with the longitudinal frames 217, are bent and thus slightly depressed in position, compared to the main frame 211 (see Figs. 29 to 32).

The above lead frame 205 is unified with the mold resin 206 so as to form the package base 207. As shown in Figs. 31 and 32, the box-shaped mold resin 206 is constituted of a base portion 231 having a rectangular shape, which is elongated in the longitudinal direction so as to securely mount the microphone chip 2 and the control chip 3 thereon, and a prism-shaped peripheral wall 232 which is vertically disposed on the periphery of the base portion 231.

The shield plate 213 and the terminals 215 of the lead frame 205 are embedded in the base portion 231 of the mold resin 206 except that the backsides of the terminals 215 and 221 are exposed on the backside of the base portion 231. The backsides of the terminals 215 and 221 slightly project externally from the backside of the base portion 231 of the mold resin 206. The base portion 231 entirely covers the surface of the shield plate 213 and the surfaces of the terminals 215 therein. In addition, four openings 233 for partially exposing the surfaces of the terminals 215 and 221 are formed in the base portion 231 and are positioned in correspondence with the terminals 215 and 221.

The microphone chip 2 and the control chip 3 are fixed onto the surface of the base portion 231 via die bonding and are electrically connected to the surfaces of the terminals 215 and 221, which are exposed in the openings 233 of the base portion 231 of the mold resin 206, via bonding wires 234.

In Fig. 32, the peripheral wall 232 entirely formed in a prism-shape is vertically disposed on the periphery of the base portion 231 embedding the shield plate 213 of the lead frame 205 such that the surrounding area thereof is gradually increased in the vertical direction, wherein an external flange 235 is integrally formed with the upper end of the peripheral wall 232. The interconnection arms 212 and the support arms 214 are embedded inside the peripheral wall 232, while the surface of the main frame 211 is partially exposed on the surface of the external flange 235. In the latter processing, the bent portions 219 and their proximate areas are cut out from the main frame 211 but the support arms 214 connected to the bent portions 219 are embedded inside the external flange 235 slightly below the main frame 211, so that the cut ends of the support arms 214 are exposed externally of the external flange 235.

The cover 208 composed of a conductive metal material such as copper is attached onto the package base 207, wherein it is formed in a rectangular shape approximately matching the outline shape of the external flange 235 on the upper end of the peripheral wall 232. A sound hole 241 is formed at a prescribed position of the cover 208 so as to allow an internal space 242, circumscribed between the package base 207 and the cover 208, to communicate with the external space. When the cover 208 is bonded to the surface of the external flange 235 via a conductive bonding agent, the cover 208 closes the internal space 242 surrounded by the peripheral wall 232 while allowing the internal space 242 with the external space via the sound hole 241. In this state, the cover 208 is electrically connected to the main frame 211 exposed on the surface of the external flange 235. That is, the package 204 is designed to electrically connect the cover 208 to the main frame 211, the interconnection arms 212, and the shield plate 213 of the lead frame 205 while enclosing the internal space 242 being surrounded by the lead frame 205 and the cover 208. In addition, the three terminals 215 disposed inside the cutouts 220 of the shield plate 213 are placed independently of the shield plate 213.

Next, a manufacturing method of the semiconductor device 201 will be described below.

First, a metal plate used for the formation of the lead frame 205 is subjected to half-etching using a mask covering prescribed areas, thus reducing the thickness of hatching areas shown in Fig. 26 to approximately half the original thickness. Then, the metal plate is subjected to press working (or punching) so as to extract the external shape of the lead frame 205, thus forming a flat frame material 205a connected with the external frame 210 via the connections 209 as shown in Fig. 28. Thereafter, the interconnection arms 212, which are originally placed in the same plane as and between the main frame 211 and the shield plate 213, are subjected to bending so as to depress the shield plate 231 in position, compared to the main frame 211.

The press working is performed using a press metal mold constituted of an upper mold 243 and a lower mold 244 as show in Figs. 27B and 27C. Slopes 243a and 243b are formed in the upper mold 243 in connection with the interconnection arms 212 and the support arms 214 so as to bend the support arms 214 and to thereby depress the shield plate 213 in position. Slopes 244a and 244b are formed in the lower mold 244 in correspondence with the slopes 243a and 243b of the upper mold 243. The flat frame material 205a is held between the upper mold 243 and the lower mold 244 between the slopes 243a and 243b and the slopes 244a and 244b. In order to smoothly deform the interconnection arms 212 and 214 by the interior surfaces of the upper mold 243 and the lower mold 244, small projections 245 are formed at the bent portions of the slopes 243a and 243b of the upper mold 243, thus forming small gaps between the small projections 245 and the prescribed areas of the flat frame material 205a disposed in contact with the slopes 243a and 243b of the upper mold 243. In the flat frame material 205a shown in Fig. 28, the interconnection arms 212 are placed linearly symmetrical to the center line X and positioned between the lateral frames 216 and the lateral sides of the shield plate 213, wherein the connection portions 212a connected with the lateral frames 216 of the main frame 211 are positioned in the left-side while the connection portions 212b connected with the lateral sides of the shield plate 213 are positioned in the right-side. In the press working, the interconnection arms 212 are deformed while being pivotally moved like pendulums about the bent portions 212d in connection with the lateral frames 216 of the main frame 211. This moves the shield plate 213, which is originally positioned rightward in the flat frame materials 205a shown in Fig. 28, to the center position of the inside area of the main frame 211 in the lead frame 205 shown in Fig. 25.

At the same time, the support arms 214 are bent together with the interconnection arms 212 so that the terminals 215 are placed in the same plane as the shield plate 213 inside the cutouts 220 of the shield plate 213. Due to the bending deformation of the support arms 214, the two terminals 215, which are positioned in the right-side of the shield plate 213 and are originally positioned in the backs of the cutouts 220 of the shield plate shown in Fig. 28, are moved close to the openings of the cutouts 220 of the shield plate 213 shown in Fig. 25, while the remaining terminal 215, which is positioned inside the cutout 220 on the left-side of the shield plate 213, is moved together with the shield plate 213.

The projections 245 of the upper mold 243 make it possible for the shield plate 213 and the terminals 215 to smoothly move and slide along with the interior surfaces of the press metal mold during the press working.

Next, the lead frame 205 completed in press working is placed in an injection metal mold so as to form the mold resin 206 for embedding the lead frame 205 via injection molding. Fig. 29 shows that the lead frame 205 completed in press working is placed in the injection metal mold, wherein a melted resin is injected into a cavity 253 formed between an upper mold 251 and a lower mold 252. In order to prevent the terminals 215 and 221 from unexpectedly moving during injection molding, a recess 254 engaged with the terminals 215 and 221 is formed on the interior surface of the lower mold 252 in proximity to the cavity 253. Since the terminals 215 and 221 slightly project from the backside of the shield plate 213 by way of half-etching, the depth of the recess 254 is slightly smaller than the heights of the terminals 215 and 221, so that when the backsides of the terminals 215 and 221 are brought into contact with the bottom of the recess 254, the shield plate 213 and the support arms 214 are slightly floated above the interior surface of the lower mold 252 except for the recess 254. The horizontal dimensions of the recess 254 are determined such that the recessed area thereof is slightly larger than the sum of the backsides of the terminals 215 and 221 so as to permit tolerances of dimensions of the terminals 215 and 221. Projections 255 of the upper mold 251 are brought into contact with the surfaces of the terminals 215 and 221 so as to form the openings 233 of the mold resin 206.

The upper mold 251 and the lower mold 252 are clamped in the condition in which the surface of the main frame 211 is brought into contact with the interior surface of the upper mold 251 together with the surfaces of the bent portions 219 while the backsides of the terminals 215 and 221 are brought into contact with the bottom of the recess 254 of the lower mold 252. During clamping, the interconnection arms 212 and the support arms 214 are slightly deflected in the cavity 253 while the surface of the main frame 211 comes in close contact with the interior surface of the upper mold 251 due to a pressing force occurring on the interior surfaces of the upper mold 251 and the lower mold 252.

As described above, the lead frame 205 is unified with the mold resin 206 so as to form the package base 207. Then, the semiconductor chips 2 and 3 are fixed onto the surface of the base portion 231 of the package base 207 via die bonding and are electrically connected to the terminals 215 and 221 exposed in the openings 233 of the base portion 231 via wire bonding. In addition, a conductive bonding agent is applied to the upper end of the peripheral wall 232, so that the cover 208, which is produced independently of the package base 207, is bonded to the peripheral wall 232 of the package base 207. In this state, a plurality of package bases (each corresponding to the package base 207) is interconnected together such that a plurality of lead frames (each corresponding to the lead frame 205) is interconnected to adjoin each other via the connections 209, while a plurality of covers (each corresponding to the cover 208) is interconnected to adjoin each other via connections 256 with the same pitches as the pitches between adjacent lead frames; hence, numerous covers are collectively attached to numerous package bases.

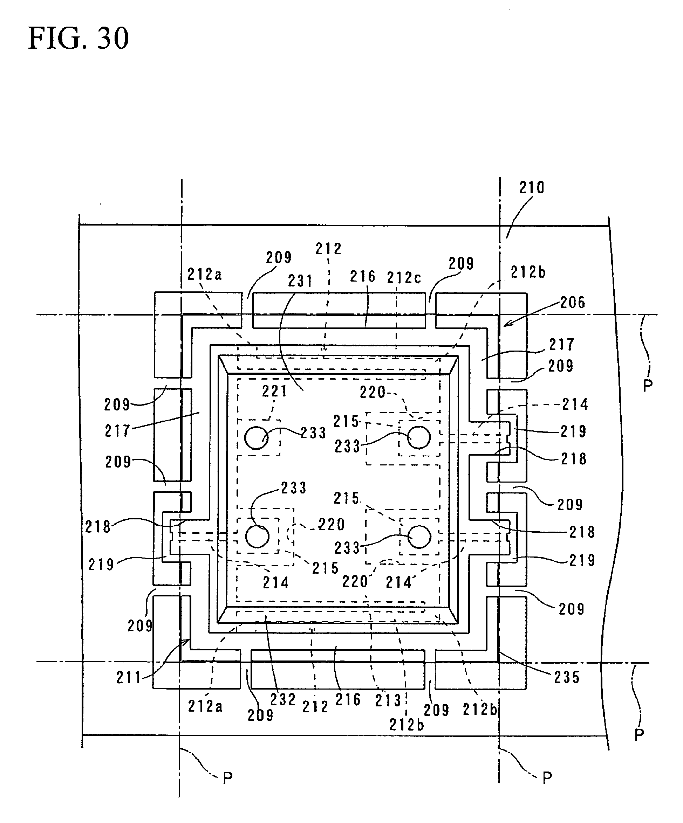

After bonding, the connections 209 of the lead frame 205, which are exposed externally of the mold resin 206, the connections 256 of the cover 208, and the bent portions 219 of the main frame 211 are collectively subjected to cutting along cut lines P shown in Fig. 30, thus separating the individual package 204. Before separation, the support arms 214 are bent inside the recesses 218 circumscribed by the bent portions 219 externally expanded from the main frame 211, while the mold resin 206 is partially introduced into the recesses 218. For this reason, the package 204 is subjected to cutting together with the mold resin 206.

As shown in Fig. 32, the semiconductor 201 is a surface-mount type semiconductor device, in which the terminals 215 and 221 are exposed to slightly project from the backside of the package base 207. The semiconductor device 201 is mounted on the surface of an external substrate S such that the terminals 215 and 221 are soldered to the circuitry of the external substrate S (see dashed lines in Fig. 32). In this state, the shield plate 213 embedded in the base portion 231 is positioned below the semiconductor chips 2 and 3; the shield plate 213 is connected to the cover 208 via the main frame 211 and the interconnection arms 212; and the cover 208 closes the upper space of the semiconductor chips 2 and 3, whereby the semiconductor chips 2 and 3 are surrounded by the shield plate 213 and the cover 208. When the ground terminal 221 of the shield plate 213 is grounded via the external substrate S, it is possible to shield the semiconductor chips 2 and 3 from an external magnetic field. With respect to the main frame 211, the lateral frames 216 and the longitudinal frames 217 as well as their corners are exposed on the surface of the external frame 235 except for the bent portions 219 which are already cut out. Since the main frame 211 is arranged for substantially the entire circumference of the external flange 235, it is possible to secure a large contact area between the main frame 211 and the cover 208; hence, it is possible to secure electrical connection therebetween.

When the semiconductor device 201 is mounted on the external substrate S, only the terminals 215 and 221 which slightly project from the backside of the package base 207 are brought into contact with the surface of the external substrate S; hence, it is possible to prevent foreign matter from entering between the base portion 231 and the external substrate S, thus avoiding the occurrence of defects.

Since the outline area of the base portion 231 is smaller than the outline area of the external flange 235 on the upper end of the peripheral wall 232, it is possible to reduce the mounting area for mounting the semiconductor device 201 on the external substrate S and to reduce interference with the circuitry of the external substrate S, thus achieving a high packaging density.

The support arms 214 can be reshaped in a manner similar to the support arms 14 shown in Fig. 14, in which the intermediate portions thereof are horizontally bent at the mid-position of the peripheral wall 232, or in Fig. 15 in which they are inclined with small inclination angles between the terminals 215 and the bent portions 219.

### 7. Seventh Embodiment

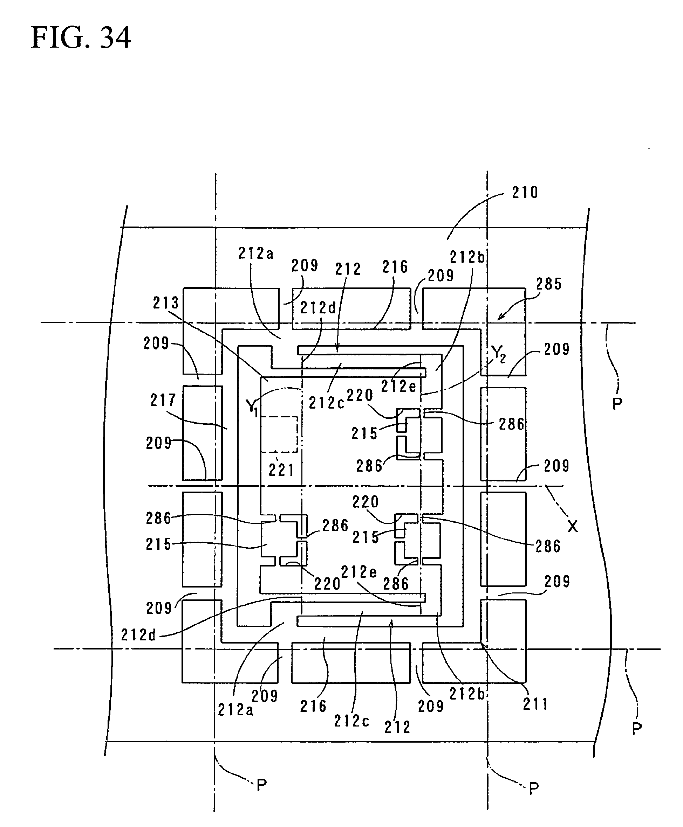

A lead frame 285 for use in a semiconductor device according to a seventh embodiment of the present invention will be described with reference to Fig. 34,
wherein it is designed to partially modify the lead frame 205 of the sixth embodiment with respect to the support structure of the terminals 215. In contrast to the lead frame 205 in which the terminals 215 disposed independently of the shield plate 213 are cantilevered by the support arms 214 extended inwardly from the main frame 211, the lead frame 285 is designed without using support arms such that the terminals 215 disposed in the cutouts 220 of the shield plate 213 are each interconnected to the shield plate 213 via a plurality of bridges 286. After completion of resin molding, the bridges 286 are cut out via laser cutting so that the terminals 215 are isolated from the shield plate 213. The lead frame 205 of the sixth embodiment, in which the interconnection arms 212 and the support arms 214 are bent via press working so that the terminals 215 inevitably move inside the recesses 218 of the shield plate 213, should be designed to estimate the movements of the terminals 215 in advance, thus determining the positional relationship between the shield plate 213 and the terminals 215 disposed inside the recesses 218. It is possible to design the lead frame 285 of the seventh embodiment shown in Fig. 34 with ease because the positional relationship between the shield plate 213 and the terminals 215 is not changed before and after press working.

### 8. Eighth Embodiment

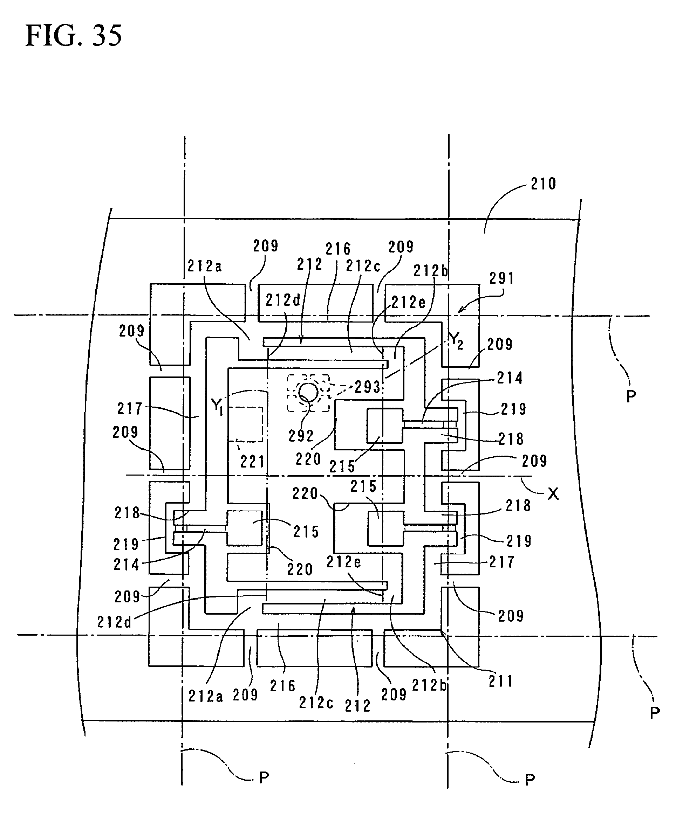

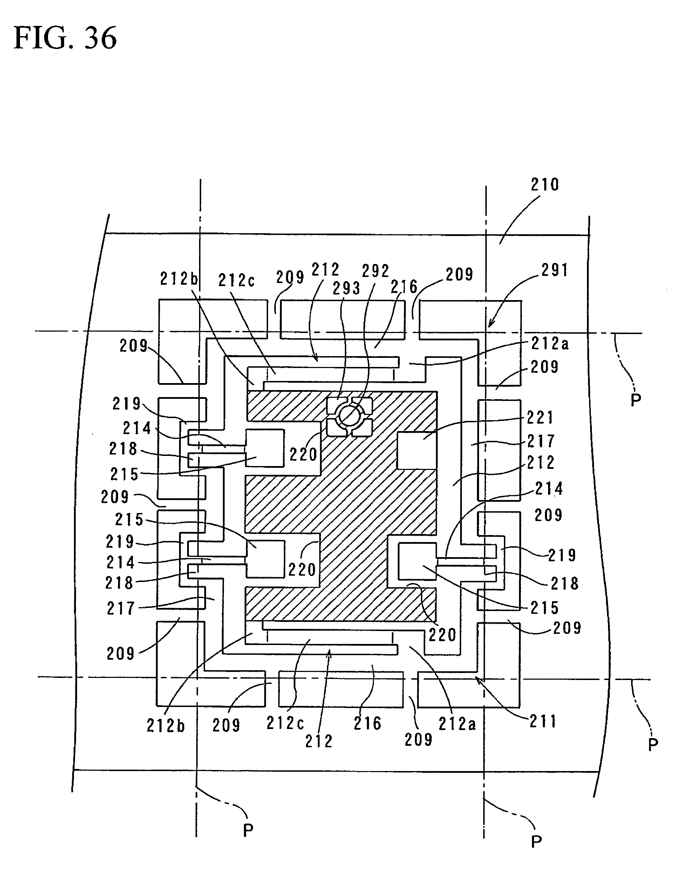

A lead frame 291 for use in a semiconductor device according to an eighth embodiment of the present invention will be described with reference to Figs. 35 and 36. In contrast to the semiconductor device 201 of the sixth embodiment in which the cover 208 has the sound hole 241, the semiconductor device of the eighth embodiment is **characterized in that** a sound hole is formed in a package base. As shown in Figs. 35 and 36, a lower hole 292 serving as a sound hole is formed at a prescribed position of the shield plate 213 of the lead frame 291. Except that, the lead frame 291 of the eight embodiment is in a manner similar to the lead frame 205 of the sixth embodiment with respect to the main frame 211, the interconnection arms 212, and the terminals 215 and 221, wherein the backside of the shield plate 213 is subjected to half-etching and is reduced in thickness except for the backsides of the terminals 215 and 221 (see Fig. 36 in which hatching areas indicate half-etched areas). Herein, the surrounding area of the lower hole 292 is subjected to half-etching except for a plurality of projections 293 which are disposed around the lower hole 292 in a radial direction; hence, the projections 293 still have the same thickness as the terminal 221.

After completion of press working, the lead frame 291 is placed in an injection metal mold which is similar to the injection metal mold used in the fourth embodiment shown in Fig. 19, wherein it is unified with a mold resin which is similar to the mold resin shown in Fig. 20 so that the sound hole is formed in the base portion, on which a cylindrical wall is formed to surround the sound hole. The package base is combined with a cover having no hole. It is possible to modify the sound hole in a manner similar to the fifth embodiment shown in Fig. 21, in which the sound hole is constituted of a plurality of small holes exposed in a window hole.

### 9. Ninth Embodiment

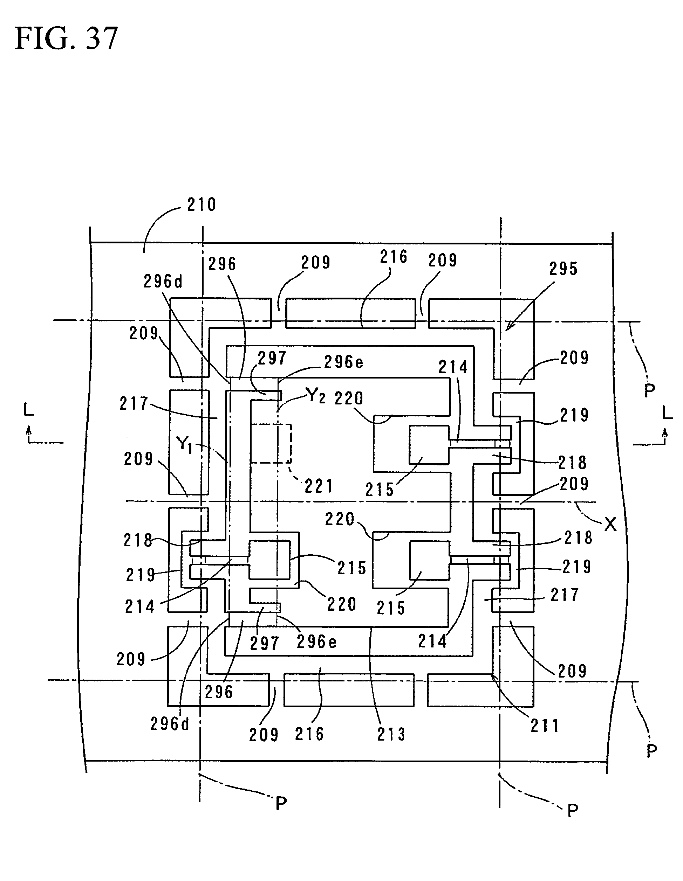

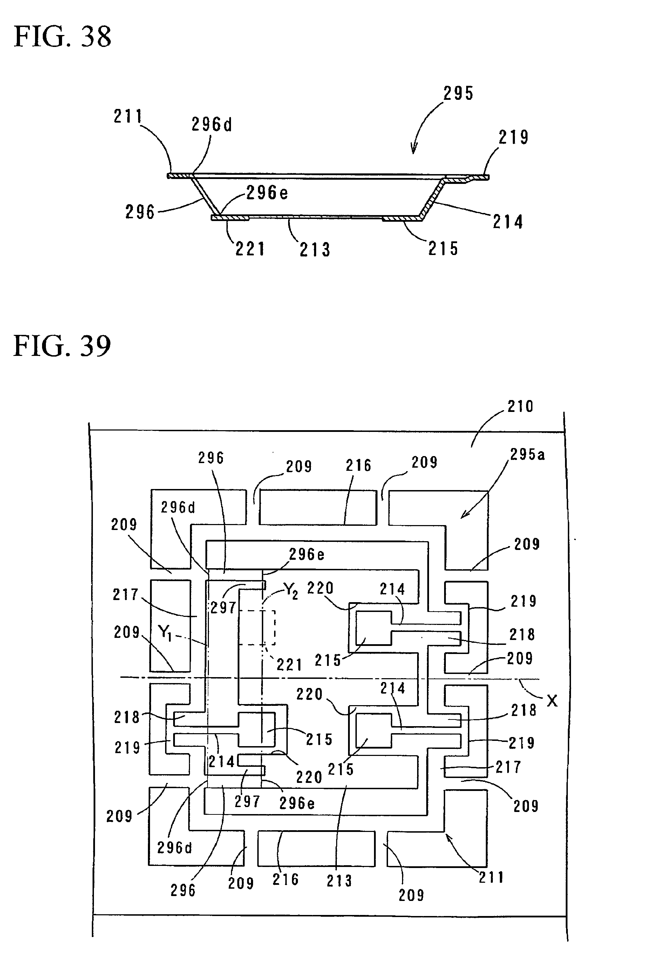

A lead frame 295 for use in a semiconductor device according to a ninth embodiment of the present invention will be described with reference to Figs. 37 to 39. The lead frame 295 is **characterized in that** as shown in Fig. 37, two interconnection arms 296 are disposed in parallel between the left-side longitudinal frame 217 and the longitudinal side of the shield plate 213, thus interconnecting between the main frame 211 and the shield plate 213. As shown in Fig. 38, opposite ends of the interconnection arms 296 are bent at bent portions 296d and 296e so that the intermediate portions of the interconnection arms 296 are both inclined in the same direction and with the same inclination angle. Specifically, the interconnection arms 296 are aligned linearly between the left-side longitudinal frame 217 and the longitudinal side of the shield plate 213, which are positioned opposite to each other. The bent portions 296d of the interconnection arms 296 interconnected with the left-side longitudinal frame 217 are bent along a line Y₁ while the bent portions 296e of the interconnection arms 296 interconnected to the longitudinal side of the shield plate 213 are bent along a line Y₂, wherein the lines Y₁ and Y₂ are perpendicular to the center line X of the shield plate 213 and parallel to each other.

Fig. 39 shows a flat frame material 295a corresponding to the development state of the lead frame 296. The bent portions 296d of the interconnection arms 296 are bent while being pivotally moved about the line Y₁ so that the shield plate 213 is depressed in position, compared to the main frame 211. Slits 297 are formed in the interconnection arms 296 in proximity to the shield plate 213. The interconnection arms 296 are slightly elongated in lengths by the slits 297, thus allowing the interconnection arms 296 to partially cut into the shield plate 213.

The lead frame 205 of the sixth embodiment is designed such that both of the longitudinal sides of the shield plate 213 are supported by the interconnection arms 212 which are aligned in a linear symmetrical manner with the shield plate 213. It is possible to modify the sixth embodiment in a manner similar to the ninth embodiment in which the interconnection arms 296 are disposed on one side of the shield plate 213 so as to cantilever the shield plate 213. In this case, the bent portions 296d of the interconnection arms 296 interconnected to the left-side longitudinal side of the main frame 211 are linearly aligned in parallel and symmetrical to the bent portions 296e of the interconnection arms 296 interconnected to the longitudinal side of the shield plate 213.

### 10. Tenth Embodiment

In the above embodiments, it is necessary to bend the interconnection arms interconnected between the main frame and the shield plate, wherein the main frame is disposed on the upper end of the peripheral wall while the shield plate is disposed in the base portion; hence, it is necessary to slightly increase the distance between the main frame and the shield plate in consideration of relatively long lengths of the interconnection arms in the development state. If the main frame is formed to surround the shield plate, it is necessary to prepare the flat frame material having a large area in plan view; but this causes large loss in space so as to deteriorate the yield in manufacturing, thus pushing up the manufacturing cost. The tenth embodiment is designed such that the main frame is disposed on one side of the package base, only along which the interconnection arms are disposed, thus reducing the space for the development state of the flat frame material.

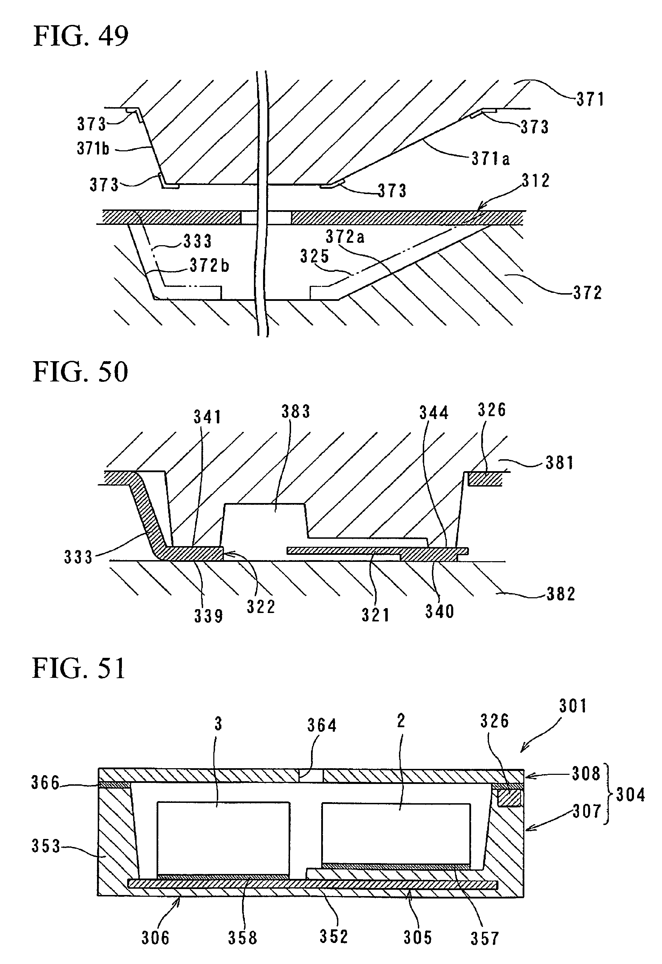

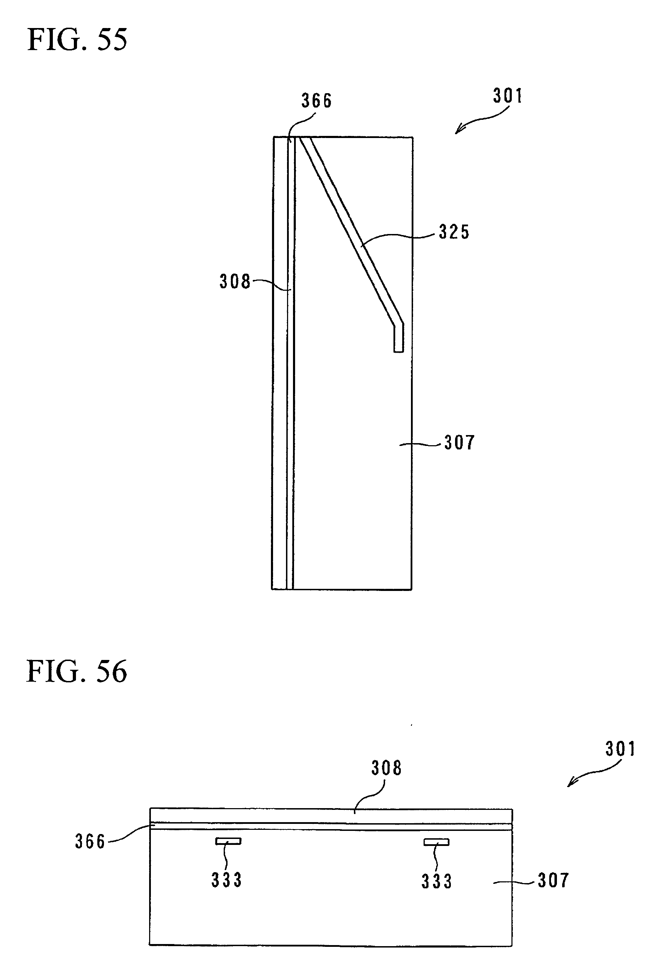

As shown in Figs. 51 to 56, a semiconductor device 301 according to the tenth embodiment of the present invention is a surface-mount type microphone package, which contains the microphone chip 2 and the control chip 3. A package 304 of the semiconductor device 301 is constituted of a package base 307, in which a lead frame 305 is unified with a box-shaped mold resin 306, and a cover 308 for enclosing the upper section of the package base 307.

A plurality of lead frames (each corresponding to the lead frame 305) is formed by processing a sheet-shaped metal plate composed of a conductive metal material such as copper and is then subjected to the aforementioned processing, thus assembling a plurality of semiconductor devices (each corresponding to the semiconductor device 301 shown in Fig. 51) individually.

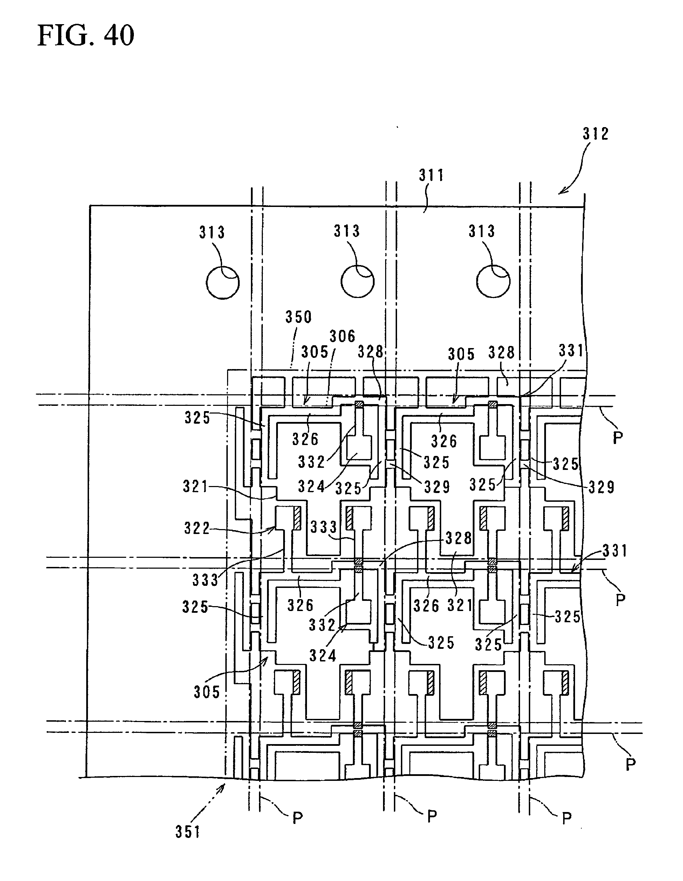

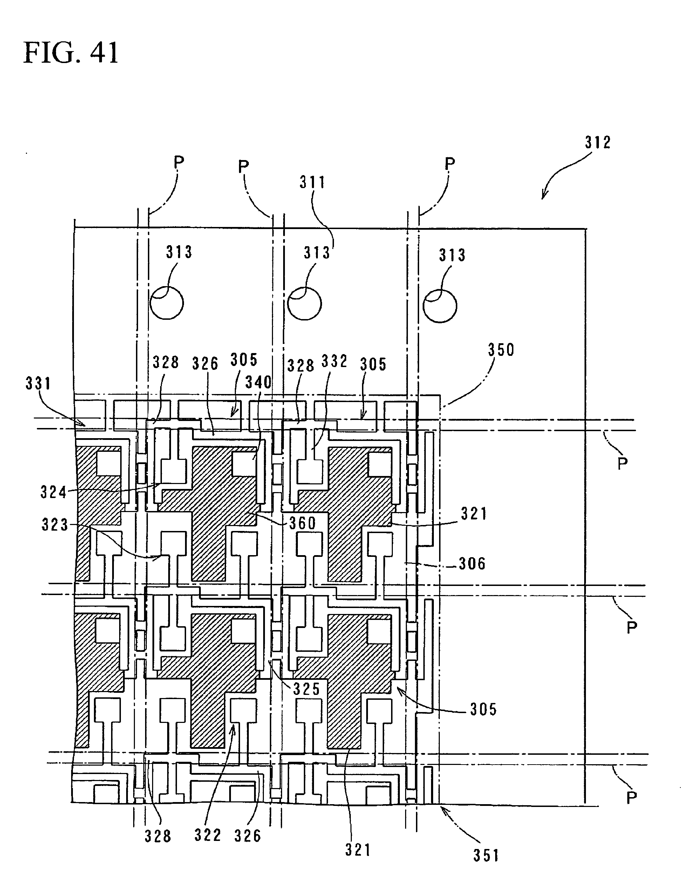

Fig. 40 shows the development state of a flat frame material 312 in which a plurality of lead frames 305 is aligned with prescribed pitches therebetween within an external frame 311. Fig. 41 shows the backside of the flat frame material 312. In Figs. 40 and 41, the same parts are designated by the same reference numerals with respect to the lead frames 305 subjected to bending and the like in the flat frame material 312. In this connection, the reference numeral 312 designates the flat frame material or a lead frame assembly in which a plurality of lead frames is consecutively assembled together. In this specification, the vertical direction is referred to as the longitudinal direction while the horizontal direction is referred to as the lateral direction with respect to each lead frame 305 shown in Fig. 40. Reference numeral 313 designates guide holes for inserting metallic guide pins when attaching the covers 308 to the package bases 307 including the lead frames 305. The guide pins 313 are linearly aligned with prescribed pitches therebetween on each of the opposite ends of the external frame 311 in the vertical direction, wherein Figs. 40 and 41 show only the linear alignment of the guide pins 313 in the upper end of the external frame 311.

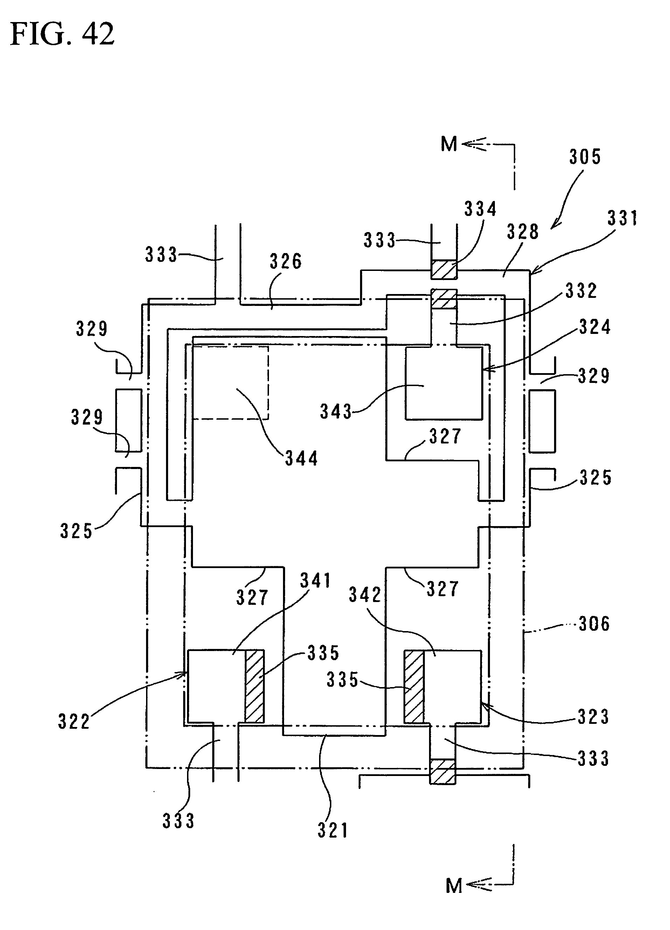

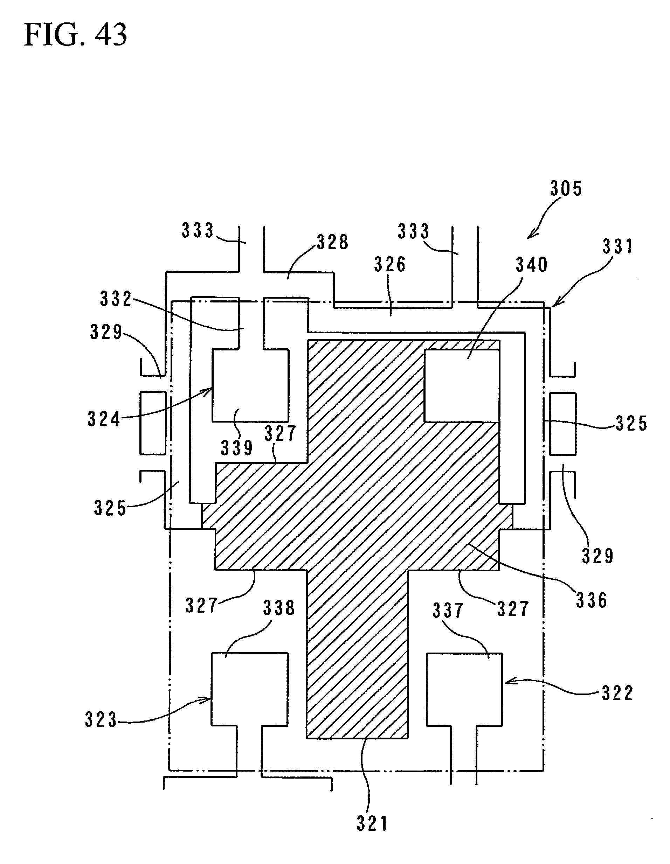

Figs. 42 and 43 show a single unit of the lead frame 305 entirely having an elongated rectangular shape including a flat-shaped shield plate 321 which is disposed below the microphone chip 2 and the control chip 3, three terminals 322 to 324 which are arranged in the periphery of the shield plate 321 with prescribed distances therebetween so as to serve as power-supply, output, and gain terminals, and a main frame 326 which is unified with the shield plate 321 via interconnection arms 325 and is positioned in parallel with the upper end of the shield plate 321 in the vertical direction.

In Fig. 42, two rectangular-shaped cutouts 327 are formed at the lower-left and lower-right corners of the shield plate 321 so at to allocate the terminals 322 and 323 therein, while one rectangular-shaped cutout 327 is formed at the upper-right corner of the shield plate 321 so as to allocate the terminal 324 therein.

The size of the terminals 322 to 324 is smaller than the size of the cutouts 327, so that the terminals 322 to 324 are positioned inside of the cutouts 327 while being slightly distanced from the shield plate 321.

The main frame 326 is slightly distanced from the upper end of the shield plate 321. The main frame 326 is extended within the lateral length of the upper end of the shield plate 321 except for the cutout 327, wherein a bent portion 328 is expanded externally from the main frame 326 relative to the cutout 327. The interconnection arms 325 are elongated in parallel with the longitudinal sides of the shield plate 321 and are integrally connected to the left end of the main frame 326 and the right end of the bent portion 328, so that the distal ends of the interconnection arms 325 are connected to approximately the centers of the longitudinal sides of the shield plate 321. The lead frame 305 shown in Fig.42 is connected with its adjacent lead frames (not shown) via short bridges 329, which are connected to the intermediate position of the left-side interconnection arm 325 (interconnected to the main frame 326) and the intermediate position of the right-side interconnection arm 325 (interconnected to the bent portion 328) respectively.

That is, the left-side interconnection arm 325 (interconnected to the main frame 326) and the right-side interconnection arm 325 (interconnected to the bent portion 328) are mutually interconnected together between adjacent lead frames 305 as shown in Fig. 40, in which a plurality of lead frames 305 is linearly aligned with respect to the main frames 326, the bent portions 328, and the interconnection arms 325 in connection with the external frame 311. The main frames 326, the bent portions 328, and the interconnection arms 325 are linearly interconnected together along the upper ends of the lead frames 305 so as to integrally form a support frame 331 for supporting the lead frames 305 in connection with the external frame 311. Specifically, one end of the support frame 331 is connected to the shield plate 321 of the lead frame 305 via the interconnection arms 325 and is also connected to the terminal 324 via a support arm 332, while the other end of the support frame 331 is connected to the terminals 322 and 323 of the vertically adjacent lead frame 305 via support arms 333.

In the above, the terminal 322 of the lead frame 305 is connected to the main frame 326 of the vertically adjacent lead frame 305 via the support arm 333, while the terminal 323 of the lead frame 305 is connected to the bent portion 328 of the vertically adjacent lead frame 305 via the support arm 333. That is, the main frame 326 of the lead frame 305 included in the support frame 331 is connected to the terminal 322 of the vertically adjacent lead frame 305, while the bent portion 328 of the lead frame 305 included in the support frame 331 is connected to the terminal 324 of the lead frame 305 and the terminal 323 of the vertically adjacent lead frame 305.

Hatching areas shown in Figs. 40 and 42 indicate locally half-etched areas on the surface of the lead frame 305, wherein the original thickness of the metal plate is reduced to approximately half by way of half-etching. Specifically, half-etching is performed on the connection portion of the support arm 332 connected to the bent portion 328, and the connection portion of the support arm 333 connected to the bent portion 328 in proximity to one end of the support frame 331, thus forming recessed portions 334. In addition, half-etching is performed on the interior sides of the terminals 322 and 324 disposed in the cutouts 327 of the shield plate 321 in proximity to the other end of the support frame 331, thus forming recessed portions 335.

The backside of the flat frame material (or the lead frame assembly) 312 is partially subjected to half-etching (see hatching areas shown in Figs. 41 and 43), wherein a large area of the backside of the shield plate 321 is half-etched except for four rectangular-shaped corners, thus forming a recessed portion 336 whose thickness is reduced to approximately half the original thickness of the metal plate. The three corners out of the non-etched four corners on the backside of the shield plate 321 adequately correspond to the rectangular-shaped backsides of the terminals 322 to 324. The backsides of the terminals 322 to 324 and the backside of another corner of the shield plate 321 serve as external connection surfaces 337 to 340, which are thus positioned at the four corners on the backside of the lead frame 305. The four corners of the surface of the shield plate 321 including the surfaces of the three terminals 322 to 324 (except for surfaces of the recessed portions 335 of the terminals 322 and 323 disposed inside the cutouts 327 of the shield plate 321) serve as internal connection surfaces 341 to 344 which are electrically connected to the microphone chip 2 and the control chip 3.

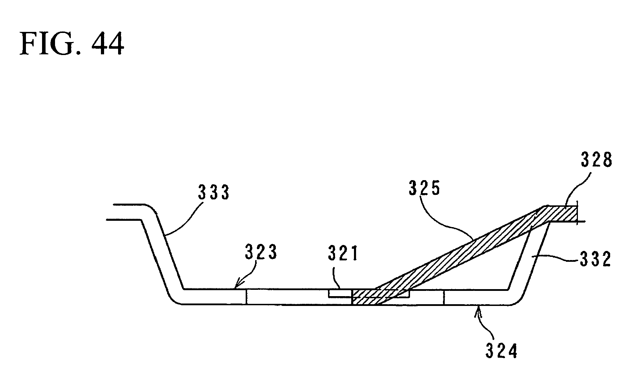

The lead frame assembly 312 is subjected to bending deformation such that as shown in Fig. 44, the interconnection arm 325, and the support arms 332 and 333 are bent and deformed at the opposite ends thereof, so that the support frame 331 is positioned in the same plane as the external frame 311 while the interconnection arm 325, and the support arms 332 and 333 are inclined downwardly, wherein the shield plate 321 and the terminals 322 to 324 are placed in the same plane but are depressed in position, compared to the support frame 331.

The lead frame assembly 312 including a plurality of lead frames 305 which are processed as described above is unified with a mold resin assembly 350 including a plurality of mold resins 306 (circumscribed by dashed lines in Figs. 40 and 41), thus forming a package base assembly 351 including a plurality of package bases 307.

A plurality of semiconductor chips 2 and 3 is collectively mounted on the mold resin assembly 350 and is then enclosed by a cover assembly 361 (including a plurality of covers 308) so as to form a semiconductor package assembly (including a plurality of packages 304), which is then divided into individual pieces, thus producing the semiconductor device 301 containing the microphone chip 2 and the control chip 3 which are encapsulated by the package base 307 (in which the lead frame 305 is unified with the mold resin 306) and the cover 308. The package base assembly 351 is produced by unifying the lead frame assembly 312 and the mold resin assembly 350 so as to interconnect together a plurality of package bases 307.

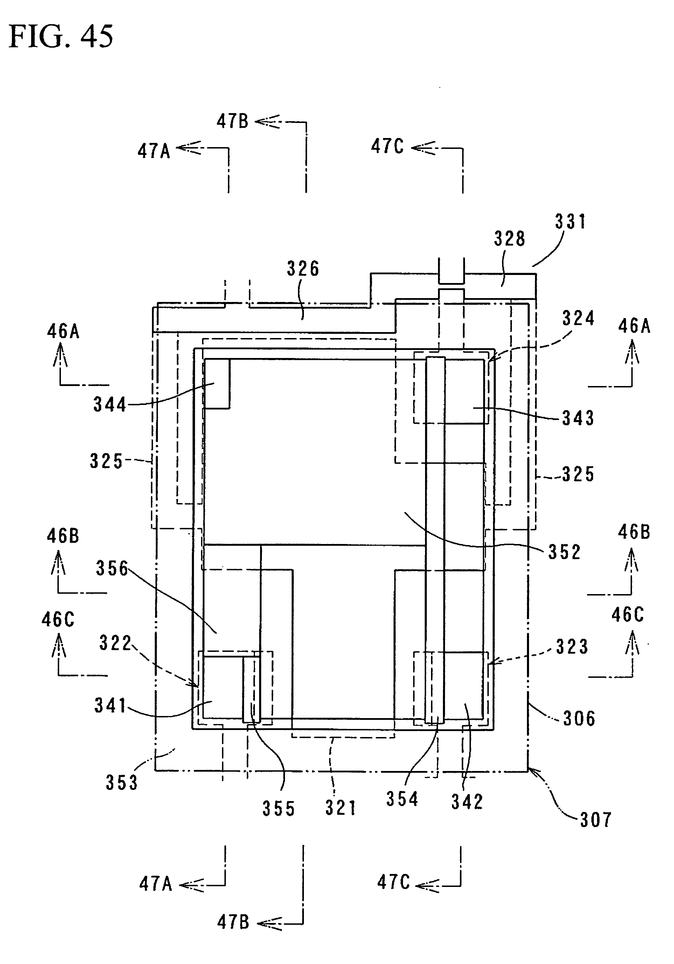

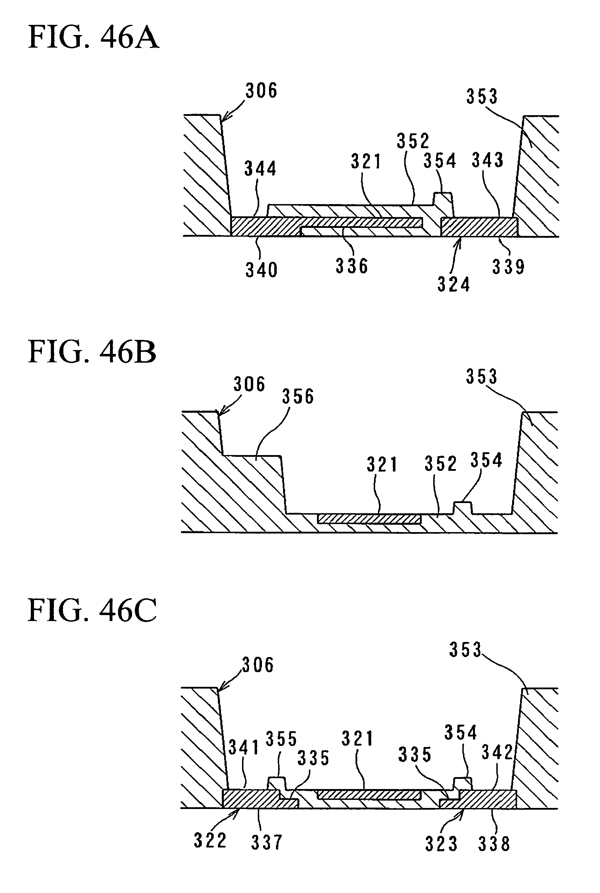

The detailed structure of the package base 307 will be described with reference to Figs. 45, 46A-46C, and 47A-47C. The mold resin 306 of the package base 307 is constituted of a base portion 352 having a rectangular shape, which is elongated in length so as to linearly align the microphone chip 2 and the control chip 3 thereon, and a peripheral wall 353 vertically disposed on the periphery of the base portion 352.

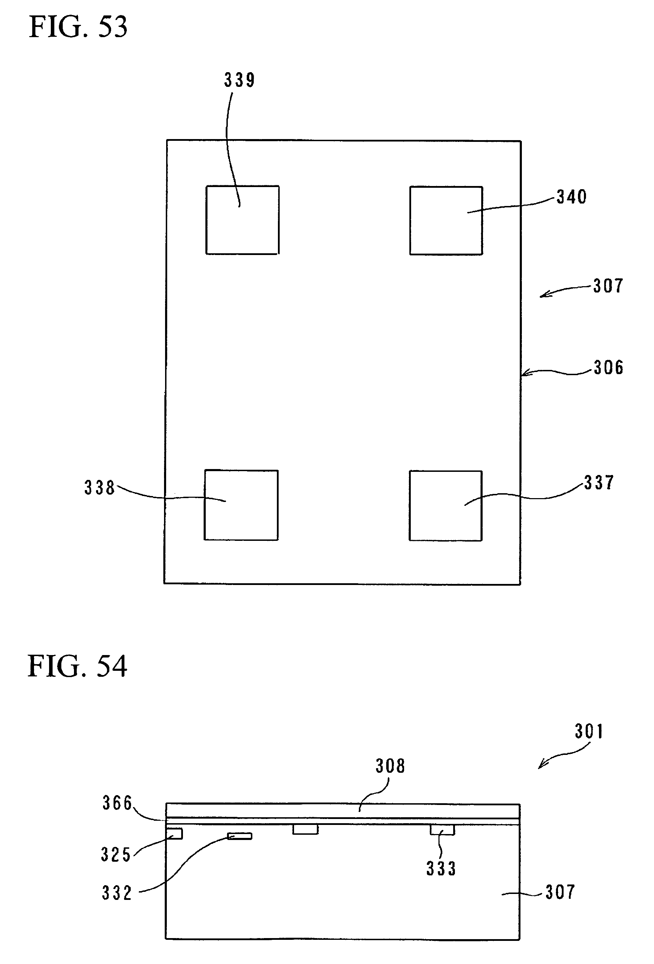

The external connection surfaces 337 to 340 of the shield plate 321 including the backsides of the terminals 322 to 324 of the lead frame 305 (see Fig. 53) are exposed on the backside of the base portion 352, while the other areas of the shield plate 321 and the terminals 322 to 324 are embedded in the base portion 352. A partition wall 354 having a small height is formed in a rib-shape elongated in the longitudinal direction so as to partition the surface of the base portion 352 into a right-side region and a left-side region. In the right-side region of the partition wall 354, the internal connection surfaces 342 and 343 (corresponding to the surfaces of the terminals 323 and 324) are exposed on the surface of the base portion 352 together with a part of the shield plate 321. The upper portion of the left-side region of the partition wall 354 is embedded in the base portion 352 except for the internal connection surface 344 of the shield plate 321, while the lower portion of the left-side region including a part of the shield plate 321 and the internal connection surface 341 (corresponding to the surface of the terminal 322) is exposed on the surface of the base portion 352. A partition wall 355 having a small height is disposed in proximity to the internal connection surface 341 so as to separate the internal connection surface 341 from the exposed portion of the shield plate 321. The heights of the partition walls 354 and 355 are lower than the heights of the semiconductor chips 2 and 3 but are higher than an applied thickness of die bonding materials, wherein they are determined to prevent die bonding materials applied to the bottoms of the semiconductor chips 2 and 3 from flowing over the partition walls 354 and 355. A rack 356 whose height is higher than the height of the partition wall 355 is connected with the partition wall 355 and is unified with the peripheral wall 353 on the left-side of the exposed portion of the shield plate 321.

The microphone chip 2 is mounted on the upper portion of the base portion 352 in which the upper portion of the shield plate 321 is embedded, while the control chip 3 is mounted on the lower portion of the base portion 352 on which the lower portion of the shield plate 321 is partially exposed. In other words, the mounting area of the microphone chip 2 is entirely sealed with the mold resin 306, while a part of the shield plate 321 is exposed in the mounting area of the control chip 3, so that the control chip 3 is fixed onto the exposed portion of the shield plate 321. The rack 356, which is formed in proximity to the mounting area of the control chip 3, is raised in height, compared to the base portion 352, so as to reduce the volume of the internal space surrounded by peripheral wall 353.

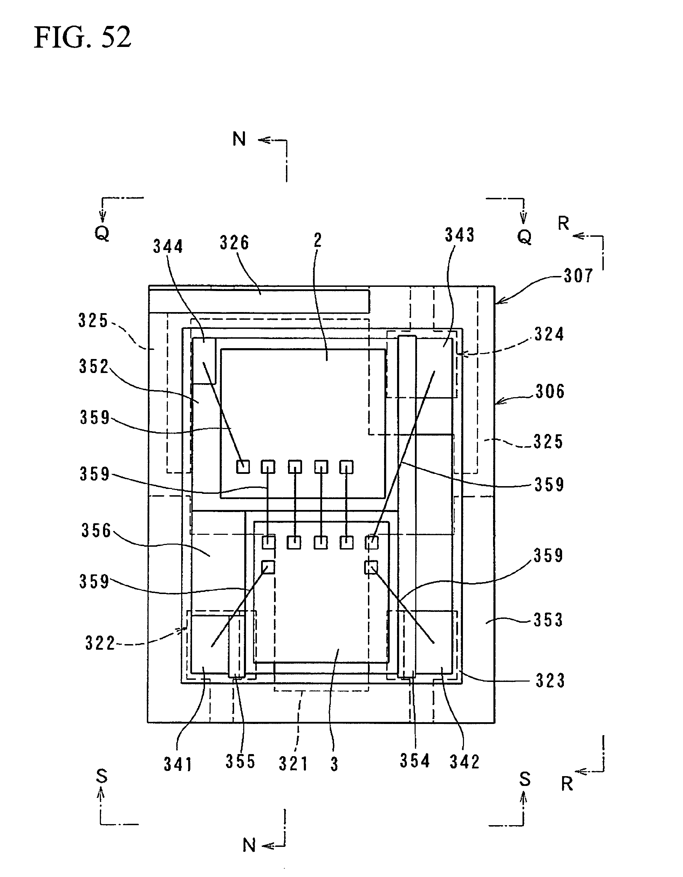

As shown in Figs. 51 and 52, the microphone chip 2 and the control chip 3 are fixed onto the surface of the base portion 352 via die bonding materials 357 and 358 and are then electrically connected to the internal connection surfaces 341 to 344 (corresponding to the surfaces of the terminals 322 to 324 and a part of the surface of the shield plate 321), which are exposed at four corners on the surface of the base portion 352. The die bonding material 357 applied to the microphone chip 2 is composed of an insulating resin, while the die bonding material 358 applied to the control chip 3 is composed of a conductive resin.

The peripheral wall 353 entirely having a prism-shape is disposed vertically on the periphery of the base portion 352 for embedding the shield plate 321 of the lead frame 305. The interconnection arms 325, which are inclined and bent at opposite ends, and the support arms 332 and 333 for supporting the terminals 322 to 324 are embedded in the peripheral wall 353, while the surface of the main frame 326 is partially exposed on the upper end of the peripheral wall 353.

In the mold resin assembly 350, the surfaces of the bent portions 328 of the main frames 326 are exposed externally of the peripheral wall 353; however, they are cut out via dicing.

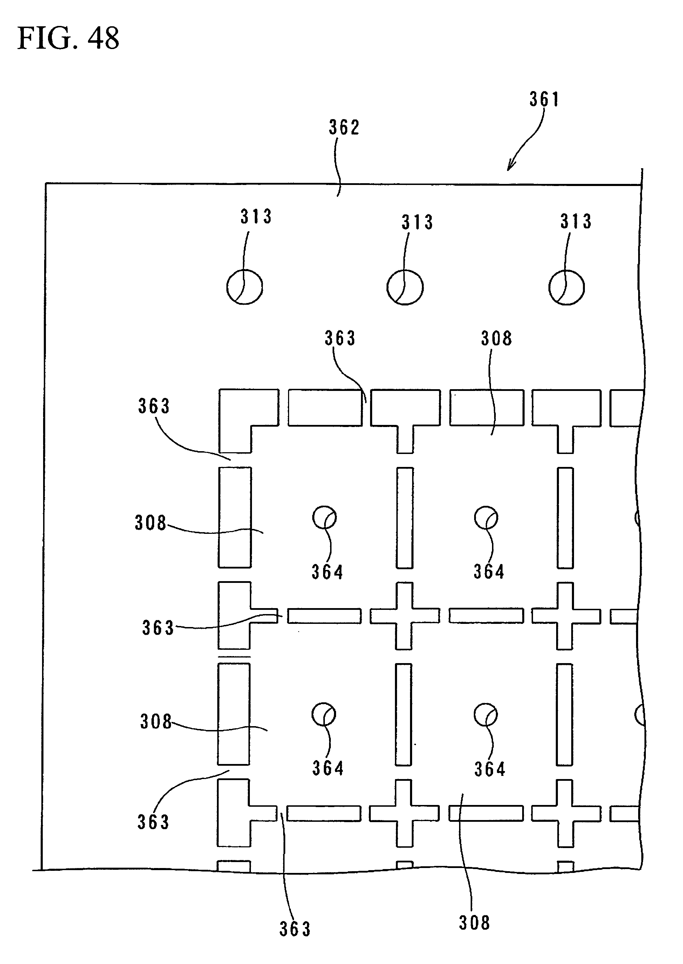

A plurality of covers (each corresponding to the cover 308 attached onto the package base 307) is collectively formed by way of the processing of a sheet-shaped metal plate composed of a conductive metal material such as copper, then, the covers 308 are collectively combined with the package bases 307; thereafter, they are divided into individual pieces. Fig. 48 shows a cover assembly 361 including a plurality of covers 308 which are aligned with prescribed pitches therebetween. In the cover assembly 361, a plurality of covers 308 is aligned to adjoin together with an external frame 362 via connections 363, wherein the covers 308 are aligned in rows and columns with prescribed pitches corresponding to the pitches for aligning the lead frames 305 in the lead frame assembly 312. Similar to the lead frame assembly 312 shown in Fig. 40, a plurality of guide holes 313 for inserting guide pins is linearly aligned on each of the opposite ends of the external frame 262 with prescribed pitches corresponding to the pitches of the guide holes 313 aligned on each of the opposite ends of the external frame 311 of the lead frame assembly 312.

The cover 308 composed of a rectangular flat plate is attached onto the upper end of the peripheral wall 353 of the package base 307, wherein a sound hole 364 is formed at approximately the center of the cover 308. When the cover 308 is combined with the package base 307, the periphery of the cover 308 is placed in contact with the upper end of the peripheral wall 353, wherein the cover 308 is positioned opposite to the base portion 352 of the package base 307, thus forming an internal space 365 surrounded by the base portion 352, the peripheral wall 353, and the cover 308. The sound hole 364 of the cover 308 allows the internal space 365 (used for containing the semiconductor chips 2 and 3) to communicate with the external space.

The periphery of the cover 308 is bonded to the upper end of the peripheral wall 353 of the package base 307 via a conductive bonding agent 366, by which the main frame 326 exposed on the upper end of the peripheral wall 353 is electrically connected to the cover 308. In the package 304 in which the package base 307 is combined with the cover 308, the microphone chip 2 and the control chip 3 contained in the internal space 365 are surrounded by the cover 308 and the shield plate 321 of the lead frame 305, which are electrically connected together.

Next, a manufacturing method of the semiconductor device 301 will be described below.

First, a sheet-shaped metal plate (used for forming the lead frame assembly 312) is subjected to half-etching using masks covering prescribed areas, thus reducing the thickness to approximately half the original thickness with respect to the hatching areas on the surface of the lead frame assembly 312 shown in Fig. 40 and the hatching areas on the backside of the lead frame assembly 312 shown in Fig. 41. The outline shape is refined via hatching so as to collectively form a plurality of lead frames 305 of the development state inside the external frame 311. As shown in Figs. 40 and 41, the support frame 331 consecutively connects the main frames 326, the bent portions 328, and the interconnection arms 325 in a row inside the external frame 311, thus supporting one ends of the lead frames 305 of the development state. In addition, the guide holes 313 are formed in the external frame 311 via etching as well.

With respect to a single unit of the lead frame 305, the interconnection arms 325, and the support arms 332 and 333 for supporting the terminals 322 to 324 are subjected to pressing working and to bending deformation, thus depressing the shield plate 321 and the terminals 322 to 324 in position, compared to the support frame 331. The press working is performed using a press metal mold shown in Fig. 49, in which the right-side illustration shows bending of the interconnection arm 325 while the left-side illustration shows bending of the support arm 333. An upper mold 371 has slopes 371a and 371b, while a lower mold 372 has slopes 372a and 372b. The interconnection arm 325 is bent at the opposite ends thereof while being tightly held between the slope 371a of the upper mold 371 and the slope 372a of the lower mold 372, while the support arm 333 is bent at the opposite ends thereof while being tightly held between the slope 371b of the upper mold 371 and the slope 372b of the lower mold 372. In order to smoothly deform the interconnection arm 325 and the support arm 333 along the interior surfaces of the upper mold 371 and the lower mold 372, small projections 373 are formed at bent portions of the upper mold 371 so as to form small gaps between the slopes 371a and 371b (lying between the small projections 373), and the interconnection arm 325 and the support arm 333.

The press working exerted on the interconnection arms 325 and the support arms 333 is a bending process so that the distal ends thereof slide and move towards the base portions thereof in the transition from the development state to the bending-completed state. For this reason, the press metal mold supports and allows the shield plate 312 (connected to the distal ends of the interconnection arms 325) and the terminals 322 to 324 (connected to the distal ends of the support arms 332 and 333) to slide along the interior surfaces.

Figs. 42 and 43 show the lead frame 305 whose outline configuration is refined via etching and which is partially bent via press working. A plurality of lead frames 305 (each of which is processed as shown in Figs. 42 and 43) is aligned in rows and columns with prescribed pitches therebetween.

Next, the lead frame assembly 312 including a plurality of lead frames 305 is placed in an injection metal mold, in which the mold resin 306 is formed to embed the lead frame 305 therein via injection molding.

Fig. 50 shows that a single unit of the lead frame 305 completed in press working is placed in the injection metal mold, in which a melted resin is injected into a cavity 383 formed between an upper mold 381 and a lower mold 382. Thus, it is possible to produce the mold resin assembly 350 embedding the lead frame assembly 312 including a plurality of lead frames 305 (see Figs. 40 and 41). In the injection metal mold, the external frame 311 of the lead frame assembly 312 is tightly held between the upper mold 381 and the lower mold 382 without gaps therebetween so as to form the "large" cavity 383 which collectively encloses the lead frames 305.

In clamping of the injection metal mold holding the lead frame 305, the external connection surfaces 337 to 340 (corresponding to the backsides of the terminals 322 to 324 and a part of the backside of the shield plate 321) are brought into contact with the interior surface of the lower mold 382, while the internal connection surfaces 341 to 344, the exposed portion of the shield plate 321, and the surfaces of the main frame 326 and the bent portions 328 included in the support frame 331 are brought into contact with the interior surface of the upper mold 383. Since the internal connection surfaces 341 to 344 and the internal connection surfaces 337 to 340 are brought into contact with the interior surfaces of the upper mold 381 and the lower mold 382 respectively, the shield plate 321 and the terminals 322 to 324 are stably held between the upper mold 381 and the lower mold 382, wherein the interconnection arms 325 and the support arms 333 are slightly deflected so as to allow the upper mold 381 and the lower mold 382 to press the external connection surfaces 337 to 340 and the surfaces of the main frame 326 and the bent portions 328 in contact with the interior surfaces thereof.

In the injection metal mold, the lead frame assembly 312 is unified with the mold resin assembly 350 including a plurality of mold resins 306 whose peripheral walls 353 are consecutively interconnected together and which are collectively unified with a plurality of lead frames 305. Thereafter, the microphone chip 2 and the control chip 3 are bonded onto the surface of the base portion 352 of the mold resin 306 via the die bonding agents 357 and 358 and are electrically connected to the internal connection surfaces 341 to 344 exposed on the four corners of the surface of the base portion 352 via the bonding wires 359.

A sheet-shaped metal plate is subjected to etching so as to refine the outline configuration thereof, thus producing the cover assembly 361 shown in Fig. 48, in which a plurality of covers 308 is mutually connected via the connections 363 inside the external frame 362. A plurality of guide holes 313 is formed in the external frame 362 by way of etching as well. The guide holes 313 of the cover assembly 361 are aligned with the prescribed pitches corresponding to the pitches between the guide holes 313 formed in the external frame 311 of the lead frame assembly 312.

As described above, the cover assembly 361 is produced independently of the package base assembly 351 in which the lead frame assembly 312 is unified with the mold resin assembly 350. Then, the cover assembly 361 is attached onto the package base assembly 351 in such a way that the peripheries of the covers 308 are bonded onto the upper ends of the peripheral walls 353 of the mold resins 306 via the conductive bonding agents 366. At this time, a plurality of pins is sequentially inserted into the guide holes 313 of the external frames 311 and 362, thus establishing the prescribed positioning between the lead frame assembly 312 and the cover assembly 361. In this state, a plurality of lead frames 305 is interconnected to linearly adjoin in rows via the support frames 331 and is collectively unified with a plurality of resin molds 306; hence, a plurality of package bases 307 are interconnected together in rows and columns. In addition, a plurality of covers 308 is interconnected together via the connections 363 and aligned with the prescribed pitches corresponding to the pitches between the lead frames 305.

The lead frame assembly 312, the mold resin assembly 350, and the cover assembly 361 are unified together and then subjected to dicing, thus producing individual pieces (each corresponding to the semiconductor device 301).

Dicing is performed along cut lines P having prescribed cutting widths shown in Figs. 40 and 41. With respect to the cut lines P extended along columns of the lead frames 305, dicing is performed to cut out the external portions of the main frames 326 within the support frames 331 aligned in rows with the cutting widths ranging from the interconnections between the main frames 326 and the bent portions 328 to the external ends of the bent portions 328. Thus, it is possible to cut out the base portions of the support arms 333 belonging to the lead frames 305 aligned in columns via the main frame 326; it is possible to separate the bent portions 328 from the main frame 326; and it is possible to cut out the support arms 332 integrally connected with the bent portions 328, thus isolating the terminals 324 (supported by the support arms 332) from the main frames 326.

The mold resins 306 are partially filled into the recessed portions 334 which are formed by way of half-etching on the connections between the support arms 332 and the bent portions 328. Therefore, even when dicing is performed in proximity to the connections between the support arms 332 and the bent portions 328, the cutting edges regarding the support arms 332 are stopped inside the mold resins 306.

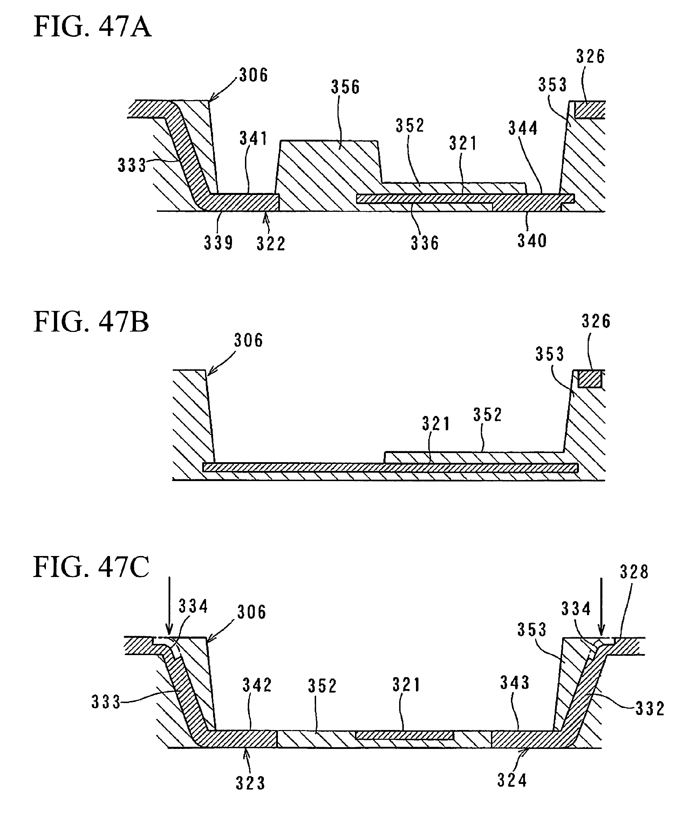

Without the recessed portions 334, the bends of the support arms 332 positioned inwardly of the bent portions 328 should be subjected to cutting, wherein as the cutting positions approaches close to the bent portions 328, the cutting edges regarding the support arms 332 will be easily exposed on the surfaces of the mold resins 306, so that they may be easily exposed as burrs due to small tolerances of dimensions. It may be possible to adopt a countermeasure for preventing such a drawback in which the support arms 332 are further elongated by further distancing the bent portions 328 from the main frames 326 so that the support arms 332 are subjected to cutting at the mid-positions thereof; but this increases dead space and loss of materials consumed in manufacturing. In contrast, the tenth embodiment is designed to form the recessed portions 334 in the lead frame 305 and to enable dicing on the support arms 332 at positions (indicated by arrows in Fig. 47C) close to the bent portions 328, thus reducing loss of materials consumed in manufacturing.

With respect to rows perpendicular to columns in aligning the lead frames 305, dicing is performed on the interconnection arms 325 by which the lead frames 305 are linearly aligned to adjoin together so that the interconnection arms 325 are separated from each other, thus producing individual pieces of the packages 304.

Due to dicing in rows and columns, the external configurations of the peripheral walls 352 of the packages 304 are refined so as to precisely produce the packages each having a rectangular shape in plan view.

The semiconductor device 301 is a surface-mount type microphone package, in which the external connection surfaces 337 to 340 (corresponding to the terminals 322 to 324 and the shield plate 321) are exposed on the backside and are soldered to the surface of an external substrate (not shown). As shown in Figs. 51 and 52, the semiconductor device 301 is designed such that the shield plate 321 embedded in the base portion 352 is positioned below the microphone chip 2 and the control chip 3; the microphone chip 2 is connected to the internal connection surface 344 of the shield plate 321; the main frame 326, which is interconnected with the shield plate 322 via the interconnection arms 325, is electrically connected to the cover 308 on the upper end of the peripheral wall 353 via the conductive bonding agent 366; and the cover 308 encloses the microphone chip 2 and the control chip 3. That is, the microphone chip 2 and the control chip 3 are surrounded by the cover 308 and the shield plate 321 whose external connection surface 340 is grounded via the external substrate; hence, it is possible to shield the microphone chip 2 and the control chip 3 from an external magnetic field.

The interconnection arms 325, which interconnect between the shield plate 321 and the main frame 326 exposed on the upper end of the peripheral wall 353, are subjected to bending in the semiconductor device 301. Originally, the distance between the shield plate 321 and the main frame 326 is increased to match the lengths of the interconnection arms 325 of the development state before bending. Due to bending of the interconnection arms 325, the shield plate 321 moves close to the main frame 326 in plan view. The semiconductor device 301 is designed such that the main frame 326 is attached to the prescribed side of the package base 307 only; hence, it is unnecessary to estimate the developed lengths of the interconnection arms 325 in designing the package base 307 with respect to the other sides which are not equipped with the main frame 326. This makes it possible to enlarge the shield plate 321 approaching close to the support frame 331 lying in an adjacent row, thus improving the shield effect. In addition, it is possible to produce relatively large sizes of packages 304 in comparison with the limited area of the lead frame assembly 312.

The recessed portions 334 are formed close to the connections between the support arms 332 and the bent portions 328, thus moving the dicing positions close to the bent portions 328. In addition, the lead frames 305 are interconnected together via the interconnection arms 325 so as to reduce pitches therebetween. Thus, it is possible to improve the use efficiency of materials consumed in manufacturing.

Since the lead frame assembly 312 has less waste of area and demonstrates a high use efficiency of materials, it is possible to reduce the manufacturing cost in manufacturing the semiconductor devices 301.

It is possible to modify the tenth embodiment such that the sound hole 364 is not formed in the cover 308 but a through-hole is formed in the base portion 352. In this modification, a cylindrical wall surrounding the through-hole is formed by a mold resin so as to prevent a die bonding material from overflowing into the through-hole.

### 11. Variations

It is possible to modify the present embodiments in various ways, which will be described below.
(1) The present embodiments are directed to microphone packages of semiconductor devices; but this is not a restriction. It is possible to apply the present invention to other sensors (other than silicon microphones) such as quartz oscillators, high-frequency SAW filters, duplexers, solid image pickup devices, and MEMS devices (such as acceleration sensors, angular velocity sensors, magnetic sensors, pressure sensors, infrared sensors, micro-mirror arrays, silicon microphones, silicon oscillators, and RF-MEMS switches) as well as flow sensors, and wind pressure sensors. The silicon microphones need through-holes such as sound holes establishing communications between internal spaces (containing microphones) and external spaces. Some sensors do not need through-holes, while flow sensors need two through-holes for sensing flows.
(2) The tenth embodiment teaches a package assembly including a plurality of microphone packages, which are divided into individual pieces via dicing. It is possible to incorporate microphone chips having different sensitivities into four packages which are aligned to adjoin together, thus forming a single unit of the package assembly. Thus, it is possible to collectively produce silicon microphones having specific directivities by use of the above package assembly. In case of airtight-sealed and vacuum-sealed devices, after airtight-sealed devices such as quartz oscillators are fixed to package bases, covers are bonded to package bases by a vacuum sealing apparatus (not shown), for example. Only the internal connection surfaces (corresponding to the surfaces of the terminals) and the internal connection surface of the stage are exposed inside the package while the other areas of the package base are sealed with the mold resin; hence, it is possible to seal the internal space formed by the package base and the cover in an airtight manner. Thus, the semiconductor package of the present invention can be preferably applied to airtight-sealed and vacuum-sealed devices, whose internal spaces are sealed in an airtight manner or in a vacuum state, such as quartz oscillators and SAW filters.
(3) The semiconductor devices of the present embodiments are each designed to form four types of terminals such as the power-supply terminal, output terminal, gain terminal, and ground terminal. However, microphone packages need at least three types of terminals such as the power-supply terminal, output terminal, and ground terminal. That is, it is possible to form two ground terminals in addition to the power-supply terminal and output terminal. The number of terminals is varied dependent on the types of semiconductor chips, wherein the number of semiconductor chips is not necessarily limited to two. It is possible to increase the number of terminals connected to the external frame by means of the connections, thus achieving five-terminal or six-terminal configuration, for example.
(4) The ground terminals of the shield plates of the lead frames are formed by way of half-etching in the present embodiments; but they can be formed by way of other processing such as embossing and coining. The outline configurations of the lead frames are refined by way of etching in the present embodiments; but they can be refined by way of pressing or punching. In addition, the internal connection surfaces are uniformly positioned on the shield plates of the lead frames in the present embodiments; but the positions of the internal connection surfaces can be arbitrarily changed as long as they are placed on the surfaces of the shield plates.
(5) The terminals and support arms are uniformly formed with the same thickness in the present embodiments; but this is not a restriction. It is possible to reduce the thickness of the support arms to be smaller than the thickness of the terminals by performing half-etching on the backsides of the support arms. In this case, it is possible to perform half-etching locally on the connections of the support arms connected to the terminals.
(6) In the injection metal mold shown in Fig. 4, the recesses 54 engaging with the terminals 15 are formed in the lower mold 52 for use in the injection molding of the mold resin 6 shown in Fig. 5; but the injection molding can be performed using another injection metal mold having no recess. In the press metal mold shown in Fig. 3, the press mold 43 having the integral structure descends down to hold the lead frame 5 while bending the interconnection arms 12 and the support arms 14; but this is not a restriction. As long as the press metal mold is designed to depress the shield plate 13 in position compared to the main frame 11, it is possible to drive the punches 45 and 46 used for forming the interconnection arms 12 independently of the press molds 43 and 44 for pressing the main frame 11.
(7) In the bending process, it is possible to simultaneously bend the interconnection arms and the support arms. Alternatively, it is possible to bend the support arms first, and then to bend the interconnection arms. In order to reduce error between the two stages of bending, it is possible to introduce a pressing process for adjusting the configurations of the interconnection arms and support arms after completion of bending of the two stages.
(8) The covers are not necessarily formed in flat shapes but can be slightly subjected to drawing, for example. The covers are not necessarily fixed using the conductive bonding agents applied to the package bases; that is, the covers can be fixed using adhesive sheets attached onto the package bases.
(9) The cover assembly can be attached to the package base assembly in such a way that conductive bonding agents are applied to the upper ends of the peripheral walls of the package bases, which are directed upwardly, then, the peripheries of the covers are fixed onto the upper ends of the peripheral walls of the package bases. Alternatively, it is possible to reverse the package base assembly and the cover assembly so that conductive bonding agents are applied to the peripheries of the covers included in the "reversed" cover assembly, then, the upper ends of the peripheral walls of the package bases included in the "reversed" package base assembly are fixed onto the peripheries of the covers. In the latter case, it is possible to prevent conductive bonding agents from dripping from the peripheral walls toward the base portions of the package bases.

Lastly, the present invention is not necessarily limited to the present embodiments and their variations, which can be further modified within the scope of the invention as defined by the appended claims.

### SUMMARY OF THE INVENTION

1. A flat frame material for use in a lead frame, comprising:
   a main frame;
   a plurality of interconnection arms;
   a shield plate which is placed inside the main frame and is interconnected to the main frame via the plurality of interconnection arms;
   a plurality of bent portions which are bent externally from the main frame so as to form a plurality of recesses therein;
   a plurality of support arms which are extended inwardly from the plurality of recesses in connection with the plurality of bent portions; and
   a plurality of terminals which are connected to distal ends of the support arms in proximity to the shield plate.
2. The flat frame material according to 1, wherein the plurality of interconnection arms is subjected to bending at first and second ends thereof in such a way that a first line imaginarily connecting between the first ends of the interconnection arms aligned in proximity to the main frame is parallel to a second line imaginarily connecting between the second ends of the interconnection arms aligned in proximity to the shield plate.
3. The flat frame material according to 2, wherein the plurality of interconnection arms is disposed in parallel with each other between the main frame and the shield plate which are positioned opposite to each other.
4. The flat frame material according to 3, wherein the plurality of interconnection arms is positioned linearly symmetrical with respect to the shield plate and wherein the first ends of the interconnection arms interconnected to the main frame are shifted in position compared to the second ends of the interconnection arms interconnected to the shield plate.
5. A flat frame assembly comprising:
   an external frame; and
   a plurality of flat frame materials serving as lead frames which are aligned in rows and columns inside the external frame and each of which includes a main frame, a plurality of interconnection arms, a shield plate placed inside the main frame and interconnected to the main frame via the plurality of interconnection arms, a plurality of bent portions which are bent externally from the main frame so as to form a plurality of recesses therein, a plurality of support arms extended inwardly from the plurality of recesses in connection with the plurality of bent portions, and a plurality of terminals connected to distal ends of the support arms in proximity to the shield plate,
   wherein the main frames are positioned on one ends of the lead frames and are linearly interconnected in each row so as to form a support frame, so that the bent portions are expanded externally from the main frames and perpendicularly to the rows.
6. A lead frame for use in a semiconductor device, comprising:
   a main frame;
   a plurality of interconnection arms;
   a shield plate which is placed inside the main frame and is interconnected to the main frame via the plurality of interconnection arms;
   a plurality of bent portions which are bent externally from the main frame so as to form a plurality of recesses therein;
   a plurality of support arms which are extended inwardly from the plurality of recesses in connection with the plurality of bent portions; and
   a plurality of terminals which are connected to distal ends of the support arms in proximity to the shield plate,
   wherein the plurality of interconnection arms and the plurality of support arms are subjected to bending so as to depress the shield plate coupled with the plurality of terminals in position compared to the main frame.
7. The lead frame according to 6, wherein the plurality of interconnection arms is slightly extended due to bending.
8. A lead frame for use in a semiconductor device comprising:
   a main frame;
   a plurality of interconnection arms;
   a shield plate which is placed inside the main frame and is interconnected to the main frame via the plurality of interconnection arms;
   a plurality of bent portions which are bent externally from the main frame so as to forms plurality of recesses therein;
   a plurality of support arms which are extended inwardly from the plurality of recesses in connection with the plurality of bent portions; and
   a plurality of terminals which are connected to distal ends of the support arms in proximity to the shield plate,
   wherein the plurality of interconnection arms is subjected to bending at first and second ends thereof in such a way that a first line imaginarily connecting between the first ends of the interconnection arms aligned in proximity to the main frame is parallel to a second line imaginarily connecting between the second ends of the interconnection arms aligned in proximity to the shield plate,
   wherein intermediate portions of the interconnection arms between the first and second ends subjected to bending are slantingly disposed between the main frame and the shield plate, and
   wherein the plurality of support arms is subjected to bending together with the plurality of interconnection arms so as to depress the shield plate coupled with the terminals in position compared to the main frame.
9. A lead frame assembly comprising:
   an external frame; and
   a plurality of lead frames which are aligned in rows and columns inside the external frame and each of which includes a main frame, a plurality of interconnection arms, a shield plate placed inside the main frame and interconnected to the main frame via the plurality of interconnection arms, a plurality of bent portions which are bent externally from the main frame so as to form a plurality of recesses therein, a plurality of support arms extended inwardly from the plurality of recesses in connection with the plurality of bent portions, and a plurality of terminals connected to distal ends of the support arms in proximity to the shield plate,
   wherein the main frames are positioned on one ends of the lead frames and are linearly interconnected in each row so as to form a support frame, so that the bent portions are expanded externally from the main frames and perpendicularly to the rows, and
   wherein the plurality of interconnection arms and the plurality of support arms are subjected to bending so as to depress the shield plate coupled with the terminals in position compared to the main frame.
10. A manufacturing method of a lead frame including a main frame, a plurality of interconnection arms, a shield plate placed inside the main frame and interconnected to the main frame via the plurality of interconnection arms, a plurality of bent portions which are bent externally from the main frame so as to form a plurality of recesses therein, a plurality of support arms extended inwardly from the plurality of recesses in connection with the plurality of bent portions, and a plurality of terminals connected to distal ends of the support arms in proximity to the shield plate, wherein the plurality of interconnection arms and the plurality of support arms are subjected to bending so as to depress the shield plate coupled with the terminals in position compared to the main frame.
11. The manufacturing method of a lead frame according to 10, wherein the plurality of interconnection arms is slightly extended due to bending.
12. A manufacturing method of a lead frame including a main frame, a plurality of interconnection arms, a shield plate placed inside the main frame and interconnected to the main frame via the plurality of interconnection arms, a plurality of bent portions which are bent externally from the main frame so as to form a plurality of recesses therein, a plurality of support arms extended inwardly from the plurality of recesses in connection with the plurality of bent portions, and a plurality of terminals connected to distal ends of the support arms in proximity to the shield plate, wherein the plurality of interconnection arms is subjected to bending at first and second ends thereof in such a way that a first line imaginarily connecting between the first ends of the interconnection arms aligned in proximity to the main frame is parallel to a second line imaginarily connecting between the second ends of the interconnection arms aligned in proximity to the shield plate,
   wherein intermediate portions of the interconnection arms between the first and second ends subjected to bending are slantingly disposed between the main frame and the shield plate, and
   wherein the plurality of support arms is subjected to bending together with the plurality of interconnection arms so as to depress the shield plate coupled with the terminals in position compared to the main frame.
13. A package base assembly comprising:
   a lead frame assembly including an external frame, and a plurality of lead frames which are aligned in rows and columns inside the external frame and each of which includes a main frame, a plurality of interconnection arms, a shield plate placed inside the main frame and interconnected to the main frame via the plurality of interconnection arms, a plurality of bent portions which are bent externally from the main frame so as to form a plurality of recesses therein, a plurality of support arms extended inwardly from the plurality of recesses in connection with the plurality of bent portions, and a plurality of terminals connected to distal ends of the support arms in proximity to the shield plate, wherein the main frames are positioned on one ends of the lead frames and are linearly interconnected in each row so as to form a support frame, so that the bent portions are expanded externally from the main frames and perpendicularly to the rows, and wherein the plurality of interconnection arms and the plurality of support arms are subjected to bending so as to depress the shield plate coupled with the terminals in position compared to the main frame; and
   a mold resin assembly including a plurality of mold resins for sealing the plurality of lead frames included in the lead frame assembly, wherein each of the mold resins includes a base portion for embedding the shield plate therein and a peripheral wall vertically disposed on a periphery of the base portion, wherein the main frame is partially exposed on an upper end of the peripheral wall, wherein surfaces of the terminals are partially exposed on a surface of the base portion, and wherein backsides of the terminals and a prescribed portion of a backside of the shield plate are partially exposed on a backside of the base portion.
14. A manufacturing method of a package base including a lead frame further including a main frame, a plurality of interconnection arms, a shield plate placed inside the main frame and interconnected to the main frame via the plurality of interconnection arms, a plurality of bent portions which are bent externally from the main frame so as to form a plurality of recesses therein, a plurality of support arms extended inwardly from the plurality of recesses in connection with the plurality of bent portions, and a plurality of terminals connected to distal ends of the support arms in proximity to the shield plate, wherein the plurality of interconnection arms is subjected to bending at first and second ends thereof in such a way that a first line imaginarily connecting between the first ends of the interconnection arms aligned in proximity to the main frame is parallel to a second line imaginarily connecting between the second ends of the interconnection arms aligned in proximity to the shield plate,
   said manufacturing method comprising:
   bending the plurality of interconnection arms and the plurality of support arms so as to depress the shield plate coupled with the terminals in position compared to the main frame;
   forming a mold resin sealing the lead frame therein while partially exposing a surface of the main frame as well as surfaces and backsides of the terminals; and
   cutting the bent portions of the main frame projecting externally of the mold resin.
15. The manufacturing method of a package base according to 14, wherein the plurality of interconnection arms is slightly extended due to bending.
16. A manufacturing method of a package base including a lead frame further including a main frame, a plurality of interconnection arms, a shield plate placed inside the main frame and interconnected to the main frame via the plurality of interconnection arms, a plurality of bent portions which are bent externally from the main frame so as to form a plurality of recesses therein, a plurality of support arms extended inwardly from the plurality of recesses in connection with the plurality of bent portions, and a plurality of terminals connected to distal ends of the support arms in proximity to the shield plate, wherein the plurality of interconnection arms is subjected to bending at first and second ends thereof in such a way that a first line imaginarily connecting between the first ends of the interconnection arms aligned in proximity to the main frame is parallel to a second line imaginarily connecting between the second ends of the interconnection arms aligned in proximity to the shield plate,
   said manufacturing method comprising:
   bending the plurality of interconnection arms at the first and second ends so that intermediate portions of the interconnection arms are slantingly disposed between the main frame and the shield plate, wherein the shield plate is depressed in position compared to the main frame;
   simultaneously bending the plurality of support arms so as to depress the terminals in position in relation to the shield plate;
   forming a mold resin sealing the lead frame while partially exposing a surface of the mainframe as well as surfaces and backsides of the terminals; and
   cutting the bent portions of the main frame projecting externally of the mold resin.
17. A manufacturing method adapted to a package base assembly including a lead frame assembly and a mold resin assembly,
   wherein the lead frame assembly includes an external frame, and a plurality of lead frames which are aligned in rows and columns inside the external frame and each of which includes a main frame, a plurality of interconnection arms, a shield plate placed inside the main frame and interconnected to the main frame via the plurality of interconnection arms, a plurality of bent portions which are bent externally from the main frame so as to form a plurality of recesses therein, a plurality of support arms extended inwardly from the plurality of recesses in connection with the plurality of bent portions, and a plurality of terminals connected to distal ends of the support arms in proximity to the shield plate, in which the main frames are positioned on one ends of the lead frames and are linearly interconnected in each row so as to form a support frame, so that the bent portions are expanded externally from the main frames and perpendicularly to the rows, and
   wherein the mold resin assembly includes a plurality of mold resins for sealing the plurality of lead frames included in the lead frame assembly, and wherein each of the mold resins includes a base portion for embedding the shield plate therein and a peripheral wall vertically disposed on a periphery of the base portion, in which the main frame is partially exposed on an upper end of the peripheral wall, in which surfaces of the terminals are partially exposed on a surface of the base portion, and in which backsides of the terminals and a prescribed portion of a backside of the shield plate are partially exposed on a backside of the base portion,
   said manufacturing method comprising:
   banding the plurality of interconnection arms and the plurality of support arms so as to depress the shield plate coupled with the terminals in position compared to the main frame: and
   cutting the bent portions linearly connected to the support arm in each column, thus cutting out peripheries of the peripheral walls of the mold resins.
18. A package base for use in a semiconductor device comprising:
   a lead frame; and
   a box-shaped mold resin for sealing the lead frame, wherein the mold resin includes a base portion and a peripheral wall vertically disposed on a periphery of the base portion,
   wherein the lead frame includes a main frame partially exposed on an upper end of the peripheral wall, a plurality of interconnection arms which are bent and embedded inside the peripheral wall of the mold resin in connection with the main frame, a shield plate which is embedded in the base portion and which is interconnected to the main frame via the plurality of interconnection arms, a plurality of support arms which are derived from a plurality of bent portions externally expanded from the main frame and which are bent and embedded inside the peripheral wall of the mold resin, and a plurality of terminals which are supported by the plurality of support arms and which are positioned in proximity to the shield plate that is depressed in position compared with the main frame, and
   wherein surfaces and backsides of the terminals are partially exposed on a surface and a backside of the base portion of the mold resin.
19. A package base for use in a semiconductor device comprising:
   a lead frame; and
   a box-shaped mold resin for sealing the lead frame, wherein the mold resin includes a base portion and a peripheral wall vertically disposed on a periphery of the base portion,
   wherein the lead frame includes a main frame partially exposed on an upper end of the peripheral wall, a plurality of interconnection arms which are bent and embedded inside the peripheral wall of the mold resin in connection with the main frame, a shield plate which is embedded in the base portion and which is interconnected to the main frame via the plurality of interconnection arms, a plurality of support arms which are derived from a plurality of bent portions externally expanded from the main frame and which are bent and embedded inside the peripheral wall of the mold resin, and a plurality of terminals which are supported by the plurality of support arms and which are positioned in a plurality of cutouts formed in the shield plate that is depressed in position compared with the main frame, and
   wherein the plurality of interconnection arms is subjected to bending at first and second ends thereof in such a way that a first line imaginarily connecting between the first ends of the interconnection arms aligned in proximity to the main frame is parallel to a second line imaginarily connecting between the second ends of the interconnection arms aligned in proximity to the shield plate, so that intermediate portions of the interconnection arms between the first and second ends are slantingly disposed between the main frame and the shield plate.
20. The package base according to 19, wherein the plurality of interconnection arms is aligned between the main frame and the shield plate which are positioned opposite to each other.
21. The package base according to 19, wherein the plurality of interconnection arms is aligned linearly symmetrical with respect to the shield plate, wherein the first ends of the interconnection arms connected to the main frame are shifted in positions compared to the second ends of the interconnection arms connected to the shield plate, and wherein the intermediate portions of the interconnection arms are slantingly disposed between the main frame and the shield plate due to bending at the first and second ends of the interconnection arms.
22. A manufacturing method of a semiconductor device by use of a package base assembly including a lead frame assembly and a mold resin assembly,
   wherein the lead frame assembly includes an external frame, and a plurality of lead frames which are aligned in rows and columns inside the external frame and each of which includes a main frame, a plurality of interconnection arms, a shield plate placed inside the main frame and interconnected to the main frame via the plurality of interconnection arms, a plurality of bent portions which are bent externally from the main frame so as to form a plurality of recesses therein, a plurality of support arms extended inwardly from the plurality of recesses in connection with the plurality of bent portions, and a plurality of terminals connected to distal ends of the support arms in proximity to the shield plate, in which the main frames are positioned on one ends of the lead frames and are linearly interconnected in each row so as to form a support frame, so that the bent portions are expanded externally from the main frames and perpendicularly to the rows, and in which the plurality of interconnection arms and the plurality of support arms are subjected to bending so as to depress the shield plate coupled with the terminals in position compared to the main frame, and
   wherein a mold resin assembly includes a plurality of mold resins for sealing the plurality of lead frames included in the lead frame assembly, in which each of the mold resins includes a base portion for embedding the shield plate therein and a peripheral wall vertically disposed on a periphery of the base portion, in which the main frame is partially exposed on an upper end of the peripheral wall, in which surfaces of the terminals are partially exposed on a surface of the base portion, and in which backsides of the terminals and a prescribed portion of a backside of the shield plate are partially exposed on a backside of the base portion.
   said manufacturing method comprising:
   mounting at least one semiconductor chip on each of the base portions of the mold resins;
   fixing a plurality of covers onto a plurality of upper ends of the peripheral walls of the mold resins via conductive bonding agents; and
   cutting the plurality of bent portions connected to the support arm in each column, thus cutting a plurality of peripheries of the peripheral walls of the mold resins.
23. A package for use in a semiconductor device comprising:
   a lead frame;
   a box-shaped mold resin for sealing the lead frame, wherein the mold resin includes a base portion and a peripheral wall vertically disposed on a periphery of the base portion; and
   a cover composed of a conductive metal material attached to an upper end of the peripheral wall so as to close an internal space surrounded by the base portion and the peripheral wall,
   wherein the lead frame includes a main frame partially exposed on the upper end of the peripheral wall, a plurality of interconnection arms which are bent and embedded inside the peripheral wall of the mold resin in connection with the main frame, a shield plate which is embedded in the base portion and which is interconnected to the main frame via the plurality of interconnection arms, a plurality of support arms which are derived from a plurality of bent portions externally expanded from the main frame and which are bent and embedded inside the peripheral wall of the mold resin, and a plurality of terminals which are supported by the plurality of support arms and which are positioned in a plurality of cutouts formed in the shield plate that is depressed in position compared with the main frame, and
   wherein the plurality of interconnection arms is subjected to bending at first and second ends thereof in such a way that a first line imaginarily connecting between the first ends of the interconnection arms aligned in proximity to the main frame is parallel to a second line imaginarily connecting between the second ends of the interconnection arms aligned in proximity to the shield plate, so that intermediate portions of the interconnection arms between the first and second ends are slantingly disposed between the main frame and the shield plate.
24. A semiconductor device comprising:
   a lead frame;
   a box-shaped mold resin for sealing the lead frame, wherein the mold resin includes a base portion and a peripheral wall vertically disposed on a periphery of the base portion;
   at least one semiconductor chip which is mounted on the base portion of the mold resin above the shield plate; and
   a cover composed of a conductive metal material attached to an upper end of the peripheral wall so as to close an internal space surrounded by the base portion and the peripheral wall,
   wherein the lead frame includes a main frame partially exposed on the upper end of the peripheral wall, a plurality of interconnection arms which are bent and embedded inside the peripheral wall of the mold resin in connection with the main frame, a shield plate which is embedded in the base portion and which is interconnected to the main frame via the plurality of interconnection arms, a plurality of support arms which are derived from a plurality of portions externally expanded from the main frame and which are bent and embedded inside the peripheral wall of the mold resin, and a plurality of terminals which are supported by the plurality of support arms and which are positioned in a plurality of cutouts formed in the shield plate that is depressed imposition compared with the main frame, and
   wherein the plurality of interconnection arms is subjected to bending at first and second ends thereof in such a way that a first line imaginarily connecting between the first ends of the interconnection arms aligned in proximity to the main frame is parallel to a second line imaginarily connecting between the second ends of the interconnection arms aligned in proximity to the shield plate, so that intermediate portions of the interconnection arms between the first and second ends are slantingly disposed between the main frame and the shield plate.
25. A microphone package comprising:
   a lead frame;
   a box-shaped mold resin for sealing the lead frame, wherein the mold resin includes a base portion and a peripheral wall vertically disposed on a periphery of the base portion;
   a microphone chip which is mounted on the base portion of the mold resin above the shield plate; and
   a cover composed of a conductive metal material attached to an upper end of the peripheral wall so as to close an internal space surrounded by the base portion and the peripheral wall,
   wherein the lead frame includes a main frame partially exposed on the upper end of the peripheral wall, a plurality of interconnection arms which are bent and embedded inside the peripheral wall of the mold resin in connection with the main frame, a shield plate which is embedded in the base portion and which is interconnected to the main frame via the plurality of interconnection arms, a plurality of support arms which are derived from a plurality of bent portions eternally expanded from the main frame and which are bent and embedded inside the peripheral wall of the mold resin, and a plurality of terminals which are supported by the plurality of support arms and which are positioned in a plurality of cutouts formed in the shield plate that is depressed in position compared with the main frame,
   wherein the plurality of interconnection arms is subjected to bending at first and second ends thereof in such a way that a first line imaginarily connecting between the first ends of the interconnection arms aligned in proximity to the main frame is parallel to a second line imaginarily connecting between the second ends of the interconnection arms aligned in proximity to the shield plate, so that intermediate portions of the interconnection arms between the first and second ends are slantingly disposed between the main frame and the shield plate, and
   wherein a sound hole is formed in the base portion of the mold resin running through the shield plate or in the cover, thus allowing the internal space to communicate with an external space.
26. The microphone package according to 25, wherein a window hole is formed to expose a prescribed portion of the shield plate in the base portion of the mold resin, and wherein a plurality of small holes is formed to run through the exposed portion of the shield plate, thus collectively forming the sound hole.

## Claims

1. A flat frame material for use in a lead frame, comprising:
a main frame;
a plurality of interconnection arms;
a shield plate which is placed inside the main frame and is interconnected to the main frame via the plurality of interconnection arms;
a plurality of bent portions which are bent externally from the main frame so as to form a plurality of recesses therein;
a plurality of support arms which are extended inwardly from the plurality of recesses in connection with the plurality of bent portions; and
a plurality of terminals which are connected to distal ends of the support arms in proximity to the shield plate.

2. The flat frame material according to claim 1, wherein the plurality of interconnection arms is subjected to bending at first and second ends thereof in such a way that a first line imaginarily connecting between the first ends of the interconnection arms aligned in proximity to the main frame is parallel to a second line imaginarily connecting between the second ends of the interconnection arms aligned in proximity to the shield plate,
wherein preferably the plurality of interconnection arms is disposed in parallel with each other between the main frame and the shield plate which are positioned opposite to each other,
wherein preferably the plurality of interconnection arms is positioned linearly symmetrical with respect to the shield plate and wherein the first ends of the interconnection arms interconnected to the main frame are shifted in position compared to the second ends of the interconnection arms interconnected to the shield plate.

3. A flat frame assembly comprising:
an external frame; and
a plurality of flat frame materials serving as lead frames which are aligned in rows and columns inside the external frame and each of which includes a main frame, a plurality of interconnection arms, a shield plate placed inside the main frame and interconnected to the main frame via the plurality of interconnection arms, a plurality of bent portions which are bent externally from the main frame so as to form a plurality of recesses therein, a plurality of support arms extended inwardly from the plurality of recesses in connection with the plurality of bent portions, and a plurality of terminals connected to distal ends of the support arms in proximity to the shield plate,
wherein the main frames are positioned on one ends of the lead frames and are linearly interconnected in each row so as to form a support frame, so that the bent portions are expanded externally from the main frames and perpendicularly to the rows.

4. A lead frame for use in a semiconductor device, comprising:
a main frame;
a plurality of interconnection arms;
a shield plate which is placed inside the main frame and is interconnected to the main frame via the plurality of interconnection arms;
a plurality of bent portions which are bent externally from the main frame so as to form a plurality of recesses therein;
a plurality of support arms which are extended inwardly from the plurality of recesses in connection with the plurality of bent portions; and
a plurality of terminals which are connected to distal ends of the support arms in proximity to the shield plate,
wherein the plurality of interconnection arms and the plurality of support arms are subjected to bending so as to depress the shield plate coupled with the plurality of terminals in position compared to the main frame,
wherein preferably the plurality of interconnection arms is slightly extended due to bending.

5. A lead frame for use in a semiconductor device comprising:
a main frame;
a plurality of interconnection arms;
a shield plate which is placed inside the main frame and is interconnected to the main frame via the plurality of interconnection arms;
a plurality of bent portions which are bent externally from the main frame so as to form a plurality of recesses therein;
a plurality of support arms which are extended inwardly from the plurality of recesses in connection with the plurality of bent portions; and
a plurality of terminals which are connected to distal ends of the support arms in proximity to the shield plate,
wherein the plurality of interconnection arms is subjected to bending at first and second ends thereof in such a way that a first line imaginarily connecting between the first ends of the interconnection arms aligned in proximity to the main frame is parallel to a second line imaginarily connecting between the second ends of the interconnection arms aligned in proximity to the shield plate,
wherein intermediate portions of the interconnection arms between the first and second ends subjected to bending are slantingly disposed between the main frame and the shield plate, and
wherein the plurality of support arms is subjected to bending together with the plurality of interconnection arms so as to depress the shield plate coupled with the terminals in position compared to the main frame.

6. A lead frame assembly comprising:
an external frame; and
a plurality of lead frames which are aligned in rows and columns inside the external frame and each of which includes a main frame, a plurality of interconnection arms, a shield plate placed inside the main frame and interconnected to the main frame via the plurality of interconnection arms, a plurality of bent portions which are bent externally from the main frame so as to form a plurality of recesses therein, a plurality of support arms extended inwardly from the plurality of recesses in connection with the plurality of bent portions, and a plurality of terminals connected to distal ends of the support arms in proximity to the shield plate,
wherein the main frames are positioned on one ends of the lead frames and are linearly interconnected in each row so as to form a support frame, so that the bent portions are expanded externally from the main frames and perpendicularly to the rows, and
wherein the plurality of interconnection arms and the plurality of support arms are subjected to bending so as to depress the shield plate coupled with the terminals in position compared to the main frame.

7. A manufacturing method of a lead frame including a main frame, a plurality of interconnection arms, a shield plate placed inside the main frame and interconnected to the main frame via the plurality of interconnection arms, a plurality of bent portions which are bent externally from the main frame so as to form a plurality of recesses therein, a plurality of support arms extended inwardly from the plurality of recesses in connection with the plurality of bent portions, and a plurality of terminals connected to distal ends of the support arms in proximity to the shield plate, wherein the plurality of interconnection arms and the plurality of support arms are subjected to bending so as to depress the shield plate coupled with the terminals in position compared to the main frame,
wherein preferably the plurality of interconnection arms is slightly extended due to bending.

8. A manufacturing method of a lead frame including a main frame, a plurality of interconnection arms, a shield plate placed inside the main frame and interconnected to the main frame via the plurality of interconnection arms, a plurality of bent portions which are bent externally from the main frame so as to form a plurality of recesses therein, a plurality of support arms extended inwardly from the plurality of recesses in connection with the plurality of bent portions, and a plurality of terminals connected to distal ends of the support arms in proximity to the shield plate,
wherein the plurality of interconnection arms is subjected to bending at first and second ends thereof in such a way that a first line imaginarily connecting between the first ends of the interconnection arms aligned in proximity to the main frame is parallel to a second line imaginarily connecting between the second ends of the interconnection arms aligned in proximity to the shield plate,
wherein intermediate portions of the interconnection arms between the first and second ends subjected to bending are slantingly disposed between the main frame and the shield plate, and
wherein the plurality of support arms is subjected to bending together with the plurality of interconnection arms so as to depress the shield plate coupled with the terminals in position compared to the main frame.

9. A package base assembly comprising:
a lead frame assembly including an external frame, and a plurality of lead frames which are aligned in rows and columns inside the external frame and each of which includes a main frame, a plurality of interconnection arms, a shield plate placed inside the main frame and interconnected to the main frame via the plurality of interconnection arms, a plurality of bent portions which are bent externally from the main frame so as to form a plurality of recesses therein, a plurality of support arms extended inwardly from the plurality of recesses in connection with the plurality of bent portions, and a plurality of terminals connected to distal ends of the support arms in proximity to the shield plate,
wherein the main frames are positioned on one ends of the lead frames and are linearly interconnected in each row so as to form a support frame, so that the bent portions are expanded externally from the main frames and perpendicularly to the rows, and wherein the plurality of interconnection arms and the plurality of support arms are subjected to bending so as to depress the shield plate coupled with the terminals in position compared to the main frame; and
a mold resin assembly including a plurality of mold resins for sealing the plurality of lead frames included in the lead frame assembly, wherein each of the mold resins includes a base portion for embedding the shield plate therein and a peripheral wall vertically disposed on a periphery of the base portion, wherein the main frame is partially exposed on an upper end of the peripheral wall, wherein surfaces of the terminals are partially exposed on a surface of the base portion, and wherein backsides of the terminals and a prescribed portion of a backside of the shield plate are partially exposed on a backside of the base portion.

10. A manufacturing method of a package base including a lead frame further including a main frame, a plurality of interconnection arms, a shield plate placed inside the main frame and interconnected to the main frame via the plurality of interconnection arms, a plurality of bent portions which are bent externally from the main frame so as to form a plurality of recesses therein, a plurality of support arms extended inwardly from the plurality of recesses in connection with the plurality of bent portions, and a plurality of terminals connected to distal ends of the support arms in proximity to the shield plate,
wherein the plurality of interconnection arms is subjected to bending at first and second ends thereof in such a way that a first line imaginarily connecting between the first ends of the interconnection arms aligned in proximity to the main frame is parallel to a second line imaginarily connecting between the second ends of the interconnection arms aligned in proximity to the shield plate,
said manufacturing method comprising:
bending the plurality of interconnection arms and the plurality of support arms so as to depress the shield plate coupled with the terminals in position compared to the main frame;
forming a mold resin sealing the lead frame therein while partially exposing a surface of the main frame as well as surfaces and backsides of the terminals; and
cutting the bent portions of the main frame projecting externally of the mold resin,
wherein preferably the plurality of interconnection arms is slightly extended due to bending.

11. A manufacturing method of a package base including a lead frame further including a main frame, a plurality of interconnection arms, a shield plate placed inside the main frame and interconnected to the main frame via the plurality of interconnection arms, a plurality of bent portions which are bent externally from the main frame so as to form a plurality of recesses therein, a plurality of support arms extended inwardly from the plurality of recesses in connection with the plurality of bent portions, and a plurality of terminals connected to distal ends of the support arms in proximity to the shield plate,
wherein the plurality of interconnection arms is subjected to bending at first and second ends thereof in such a way that a first line imaginarily connecting between the first ends of the interconnection arms aligned in proximity to the main frame is parallel to a second line imaginarily connecting between the second ends of the interconnection arms aligned in proximity to the shield plate,
said manufacturing method comprising:
bending the plurality of interconnection arms at the first and second ends so that intermediate portions of the interconnection arms are slantingly disposed between the main frame and the shield plate, wherein the shield plate is depressed in position compared to the main frame;
simultaneously bending the plurality of support arms so as to depress the terminals in position in relation to the shield plate;
forming a mold resin sealing the lead frame while partially exposing a surface of the main frame as well as surfaces and backsides of the terminals; and
cutting the bent portions of the main frame projecting externally of the mold resin.

12. A manufacturing method adapted to a package base assembly including a lead frame assembly and a mold resin assembly,
wherein the lead frame assembly includes an external frame, and a plurality of lead frames which are aligned in rows and columns inside the external frame and each of which includes a main frame, a plurality of interconnection arms, a shield plate placed inside the main frame and interconnected to the main frame via the plurality of interconnection arms, a plurality of bent portions which are bent externally from the main frame so as to form a plurality of recesses therein, a plurality of support arms extended inwardly from the plurality of recesses in connection with the plurality of bent portions, and a plurality of terminals connected to distal ends of the support arms in proximity to the shield plate, in which the main frames are positioned on one ends of the lead frames and are linearly interconnected in each row so as to form a support frame, so that the bent portions are expanded externally from the main frames and perpendicularly to the rows, and
wherein the mold resin assembly includes a plurality of mold resins for sealing the plurality of lead frames included in the lead frame assembly, and wherein each of the mold resins includes a base portion for embedding the shield plate therein and a peripheral wall vertically disposed on a periphery of the base portion, in which the main frame is partially exposed on an upper end of the peripheral wall, in which surfaces of the terminals are partially exposed on a surface of the base portion, and in which backsides of the terminals and a prescribed portion of a backside of the shield plate are partially exposed on a backside of the base portion,
said manufacturing method comprising:
bending the plurality of interconnection arms and the plurality of support arms so as to depress the shield plate coupled with the terminals in position compared to the main frame; and
cutting the bent portions linearly connected to the support arm in each column, thus cutting out peripheries of the peripheral walls of the mold resins.

13. A package base for use in a semiconductor device comprising:
a lead frame; and
a box-shaped mold resin for sealing the lead frame, wherein the mold resin includes a base portion and a peripheral wall vertically disposed on a periphery of the base portion,
wherein the lead frame includes a main frame partially exposed on an upper end of the peripheral wall, a plurality of interconnection arms which are bent and embedded inside the peripheral wall of the mold resin in connection with the main frame, a shield plate which is embedded in the base portion and which is interconnected to the main frame via the plurality of interconnection arms, a plurality of support arms which are derived from a plurality of bent portions externally expanded from the main frame and which are bent and embedded inside the peripheral wall of the mold resin, and a plurality of terminals which are supported by the plurality of support arms and which are positioned in proximity to the shield plate that is depressed in position compared with the main frame, and
wherein surfaces and backsides of the terminals are partially exposed on a surface and a backside of the base portion of the mold resin.

14. A package base for use in a semiconductor device comprising:
a lead frame; and
a box-shaped mold resin for sealing the lead frame, wherein the mold resin includes a base portion and a peripheral wall vertically disposed on a periphery of the base portion,
wherein the lead frame includes a main frame partially exposed on an upper end of the peripheral wall, a plurality of interconnection arms which are bent and embedded inside the peripheral wall of the mold resin in connection with the main frame, a shield plate which is embedded in the base portion and which is interconnected to the main frame via the plurality of interconnection arms, a plurality of support arms which are derived from a plurality of bent portions externally expanded from the main frame and which are bent and embedded inside the peripheral wall of the mold resin, and a plurality of terminals which are supported by the plurality of support arms and which are positioned in a plurality of cutouts formed in the shield plate that is depressed in position compared with the main frame, and
wherein the plurality of interconnection arms is subjected to bending at first and second ends thereof in such a way that a first line imaginarily connecting between the first ends of the interconnection arms aligned in proximity to the main frame is parallel to a second line imaginarily connecting between the second ends of the interconnection arms aligned in proximity to the shield plate, so that intermediate portions of the interconnection arms between the first and second ends are slantingly disposed between the main frame and the shield plate,
wherein preferably the plurality of interconnection arms is aligned between the main frame and the shield plate which are positioned opposite to each other, and/or
wherein preferably the plurality of interconnection arms is aligned linearly symmetrical with respect to the shield plate, wherein the first ends of the interconnection arms connected to the main frame are shifted in positions compared to the second ends of the interconnection arms connected to the shield plate, and wherein the intermediate portions of the interconnection arms are slantingly disposed between the main frame and the shield plate due to bending at the first and second ends of the interconnection arms.

15. A manufacturing method of a semiconductor device by use of a package base assembly including a lead frame assembly and a mold resin assembly,
wherein the lead frame assembly includes an external frame, and a plurality of lead frames which are aligned in rows and columns inside the external frame and each of which includes a main frame, a plurality of interconnection arms, a shield plate placed inside the main frame and interconnected to the main frame via the plurality of interconnection arms, a plurality of bent portions which are bent externally from the main frame so as to form a plurality of recesses therein, a plurality of support arms extended inwardly from the plurality of recesses in connection with the plurality of bent portions, and a plurality of terminals connected to distal ends of the support arms in proximity to the shield plate, in which the main frames are positioned on one ends of the lead frames and are linearly interconnected in each row so as to form a support frame, so that the bent portions are expanded externally from the main frames and perpendicularly to the rows, and in which the plurality of interconnection arms and the plurality of support arms are subjected to bending so as to depress the shield plate coupled with the terminals in position compared to the main frame, and
wherein a mold resin assembly includes a plurality of mold resins for sealing the plurality of lead frames included in the lead frame assembly, in which each of the mold resins includes a base portion for embedding the shield plate therein and a peripheral wall vertically disposed on a periphery of the base portion, in which the main frame is partially exposed on an upper end of the peripheral wall, in which surfaces of the terminals are partially exposed on a surface of the base portion, and in which backsides of the terminals and a prescribed portion of a backside of the shield plate are partially exposed on a backside of the base portion.
said manufacturing method comprising:
mounting at least one semiconductor chip on each of the base portions of the mold resins;
fixing a plurality of covers onto a plurality of upper ends of the peripheral walls of the mold resins via conductive bonding agents; and
cutting the plurality of bent portions connected to the support arm in each column, thus cutting a plurality of peripheries of the peripheral walls of the mold resins.

16. A package for use in a semiconductor device comprising:
a lead frame;
a box-shaped mold resin for sealing the lead frame, wherein the mold resin includes a base portion and a peripheral wall vertically disposed on a periphery of the base portion; and
a cover composed of a conductive metal material attached to an upper end of the peripheral wall so as to close an internal space surrounded by the base portion and the peripheral wall,
wherein the lead frame includes a main frame partially exposed on the upper end of the peripheral wall, a plurality of interconnection arms which are bent and embedded inside the peripheral wall of the mold resin in connection with the main frame, a shield plate which is embedded in the base portion and which is interconnected to the main frame via the plurality of interconnection arms, a plurality of support arms which are derived from a plurality of bent portions externally expanded from the main frame and which are bent and embedded inside the peripheral wall of the mold resin, and a plurality of terminals which are supported by the plurality of support arms and which are positioned in a plurality of cutouts formed in the shield plate that is depressed in position compared with the main frame, and
wherein the plurality of interconnection arms is subjected to bending at first and second ends thereof in such a way that a first line imaginarily connecting between the first ends of the interconnection arms aligned in proximity to the main frame is parallel to a second line imaginarily connecting between the second ends of the interconnection arms aligned in proximity to the shield plate, so that intermediate portions of the interconnection arms between the first and second ends are slantingly disposed between the main frame and the shield plate.

17. A semiconductor device comprising:
a lead frame;
a box-shaped mold resin for sealing the lead frame, wherein the mold resin includes a base portion and a peripheral wall vertically disposed on a periphery of the base portion;
at least one semiconductor chip which is mounted on the base portion of the mold resin above the shield plate; and
a cover composed of a conductive metal material attached to an upper end of the peripheral wall so as to close an internal space surrounded by the base portion and the peripheral wall,
wherein the lead frame includes a main frame partially exposed on the upper end of the peripheral wall, a plurality of interconnection arms which are bent and embedded inside the peripheral wall of the mold resin in connection with the main frame, a shield plate which is embedded in the base portion and which is interconnected to the main frame via the plurality of interconnection arms, a plurality of support arms which are derived from a plurality of bent portions externally expanded from the main frame and which are bent and embedded inside the peripheral wall of the mold resin, and a plurality of terminals which are supported by the plurality of support arms and which are positioned in a plurality of cutouts formed in the shield plate that is depressed in position compared with the main frame, and
wherein the plurality of interconnection arms is subjected to bending at first and second ends thereof in such a way that a first line imaginarily connecting between the first ends of the interconnection arms aligned in proximity to the main frame is parallel to a second line imaginarily connecting between the second ends of the interconnection arms aligned in proximity to the shield plate, so that intermediate portions of the interconnection arms between the first and second ends are slantingly disposed between the main frame and the shield plate.

18. A microphone package comprising:
a lead frame;
a box-shaped mold resin for sealing the lead frame, wherein the mold resin includes a base portion and a peripheral wall vertically disposed on a periphery of the base portion;
a microphone chip which is mounted on the base portion of the mold resin above the shield plate; and
a cover composed of a conductive metal material attached to an upper end of the peripheral wall so as to close an internal space surrounded by the base portion and the peripheral wall,
wherein the lead frame includes a main frame partially exposed on the upper end of the peripheral wall, a plurality of interconnection arms which are bent and embedded inside the peripheral wall of the mold resin in connection with the main frame, a shield plate which is embedded in the base portion and which is interconnected to the main frame via the plurality of interconnection arms, a plurality of support arms which are derived from a plurality of bent portions externally expanded from the main frame and which are bent and embedded inside the peripheral wall of the mold resin, and a plurality of terminals which are supported by the plurality of support arms and which are positioned in a plurality of cutouts formed in the shield plate that is depressed in position compared with the main frame,
wherein the plurality of interconnection arms is subjected to bending at first and second ends thereof in such a way that a first line imaginarily connecting between the first ends of the interconnection arms aligned in proximity to the main frame is parallel to a second line imaginarily connecting between the second ends of the interconnection arms aligned in proximity to the shield plate, so that intermediate portions of the interconnection arms between the first and second ends are slantingly disposed between the main frame and the shield plate, and
wherein a sound hole is formed in the base portion of the mold resin running through the shield plate or in the cover, thus allowing the internal space to communicate with an external space,
wherein preferably a window hole is formed to expose a prescribed portion of the shield plate in the base portion of the mold resin, and wherein a plurality of small holes is formed to run through the exposed portion of the shield plate, thus collectively forming the sound hole.
